# EUROPEAN PATENT SPECIFICATION

(11) **EP 1 019 737 B1**
(45) Date of publication and mention of the grant of the patent: **10.03.2010**
(21) Application number: 99929600.7
(22) Date of filing: 08.07.1999
(51) Int. Cl.: G01R 21/133, G01R 21/00, G01R 22/06

(54) **METHOD AND APPARATUS FOR ELECTRICAL POWER MEASUREMENT**
GERÄT UND VERFAHREN ZUR ELEKTRISCHEN LEISTUNGSMESSUNG
MESURE DE PUISSANCE ELECTRIQUE

(30) Priority: 08.07.1998 GB 9814793
(43) Date of publication of application: 19.07.2000
(73) Proprietor: Electric Power Research Limited, Belfast BT12 6TA (GB)
(72) Inventor: GHASSEMI,Foroozan, Enfield Island Village, Enfield EN3 6GJ (GB)
(74) Representative: Ahmad, Sheikh Shakeel
(86) International application number: PCT/GB1999/002189
(87) International publication number: WO 2000/003262

(56) References cited:
- EP-A- 0 660 120
- US-A- 4 672 555
- US-A- 5 212 441
- SALVATORE L ET AL: "TIME-FREQUENCY REPRESENTATIONS OF INSTANTANEOUS COMPLEX POWER, VOLTAGE AND CURRENT SPACE VECTORS" EUROPEAN TRANSACTIONS ON ELECTRICAL POWER ENGINEERING, vol. 4, no. 5, 1 September 1994 (1994-09-01), pages 395-401, XP000484725 ISSN: 0939-3072
- LESZEK S CZARNECKI ET AL: "POWER IN NINSINUSOIDAL NETWORKS: THEIR INTERPRETATION, ANALYSIS, AND MEASUREMENT" IEEE TRANSACTIONS ON INSTRUMENTATION AND MEASUREMENT, vol. 39, no. 2, 1 April 1990 (1990-04-01), pages 340-345, XP000113636 ISSN: 0018-9456
- EMANUEL A E: "ON THE DEFINITION OF POWER FACTOR AND APPARENT POWER IN UNBALANCED POLYPHASE CIRCUITS WITH SINUSOIDAL VOLTAGE AND CURRENTS" IEEE TRANSACTIONS ON POWER DELIVERY, vol. 8, no. 3, 1 July 1993 (1993-07-01), pages 841-852, XP000403077 ISSN: 0885-8977
- FILIPSKI P S: "POLYPHASE APPARENT POWER AND POWER FACTOR UNDER DISTORTED WAVEFORM CONDITIONS" IEEE TRANSACTIONS ON POWER DELIVERY, vol. 6, no. 3, 1 July 1991 (1991-07-01), pages 1161-1165, XP000240206 ISSN: 0885-8977

## Description

The present invention concerns improvements relating to electrical power measurement and more particularly, though not exclusively, to a method of measuring an electrical power parameter, such as Apparent Power or Power Factor, which is accurate for single and multiple phases under all conditions namely those of balanced and unbalanced loads, and distorted and non-distorted waveforms.

The quantities that have conventionally been used to measure the quality and quantity of electric power are generally considered to be true and accurate when power is supplied to the load in a sinusoidal waveform and the load bears equally on each phase of the supply. The parameters that are widely used in power measurement are Active Power (P), Apparent Power (S), Reactive Power (Q) and Power Factor (PF).

Active power, when integrated in time, is used for billing purposes and reflects the energy consumed. Power Factor in AC circuits is a convenient figure of merit representing the utilisation of the supplying system by consumers and is used to determine the quality of the load. Reactive Power contributes to transmission losses and is used to define the oscillation of energy caused by reactive elements in the load. It is an important quantity in defining the current carrying capacity of electrical transmission systems, in the design of consumer plants and equipment and is often used in the calculation of Power Factor. Apparent Power is used to measure the maximum demand for industrial loads and it reflects the capital investment in the supplying systems. Apparent Power is also used in power engineering to define the maximum ratings of electrical apparatus, and in revenue metering, it is used as a meaningful quantity in the general power theory of electrical networks.

Of the above-mentioned quantities only the first, Active Power, is widely accepted as holding for unbalanced or non-sinusoidal situations. Reactive Power, Apparent Power and Power Factor become less valid when the supply is distorted or the load is unbalanced.

Non-linear and unbalanced loads are widespread and have caused concerns to electricity suppliers, users and regulators for many years. Non-linear loads have detrimental effects on components of the power system, they give rise to harmonic power flows to other users of the supply, and they contribute to a deterioration of the supply quality. Also, load imbalance in polyphase systems reduces the performance of the distribution system, causes voltage asymmetries which may be harmful for customers' loads, and also contributes to a deterioration of the supply quality. In the absence of a proper system for power measurement for non-linear loads, various approximations and work-arounds are made. These are unsatisfactory from many points of view: consumers are not charged accurately, and equipment designers have to cope with a margin of error when their prototypes are tested, for example.

The lack of a universally accepted definition of Apparent Power, for example, leads to inconsistencies and inaccuracies in VA demand meters used for billing purposes. Meters from different manufacturers (or even different models by the same manufacturer) use different definitions of Apparent Power. Different operating principles may also be used. Each meter type therefore responds differently to different types of load, and no conventional meter gives consistent results for all loads. Under distorted waveform conditions their readings can differ by several percent even for the same balanced but non-linear, load. In extreme circumstances, the differences may be as high as 30%. Standard engineering text books tend to skate over this problem, but International institutions such as the IEC, IEEE and IEE are well aware of it.

Due to uncertainties in defining Reactive Power in non-sinusoidal situations, the use of Apparent Power is preferred in some countries for determining Power Factor. However, using existing standard power theory in AC circuits, Apparent Power itself cannot be defined consistently in an unbalanced three-phase system.

There is a considerable body of literature which describes the shortcomings of the current approach to calculating Apparent Power, Reactive Power, and Power Factor. Examples notable for their clarity are:
(1) A. Emanuel, "On the Definition of Power Factor and Apparent Power in Unbalanced Polyphase Circuits with Sinusoidal Voltage and Currents,", IEEE Trans. On Power Delivery, Vol. 8, No. 3, pp. 841-852, July 1993;
(2) P. S. Filipski, Polyphase "Apparent Power - the Misleading Quantity In Non-Sinusoidal Power Theory: Are all Non-Sinusoidal Power Theories Doomed to Fail?," ETEP, Vol.3, No. 1, pp. 21-26, Jan/Feb 1993; and
(3) R. West, "The Measurement of Apparent and Reactive Power with Unbalanced Loads and Non-Sinusoidal Waveforms", Distribution 2000 Conference, Sydney, 1997

These authors describe three key aspects of the problem. Firstly, that there appears to be a good working definition in single-phase systems, where convention gives rise to calculated quantities to which one can attribute a physical meaning. Secondly, that there is a problem in polyphase systems of attributing a real physical meaning to the calculated parameters in existing theories. Intuitive reasoning appears to fail here. Thirdly, that the analysis of polyphase systems gives rise to no less than five different definitions for Apparent Power in three-phase systems with or without distorted waveforms. These results are often different by quite significant margins; particularly in unbalanced systems with distortion.

A good review of previous works has been presented in the paper by West (1997). The problems have been reported in many technical papers in for example by West (1997),

Filipski (1993), Emanuel (1993), and in IEEE Working Group Report, "Practical Definitions for Powers in Systems with Non-Sinusoidal Waveforms and Unbalanced Loads: A Discussion", IEEE PWRD, Vol. 11, pp. 79-101., but yet no acceptable solutions have been found. The emphasis for calculating Apparent Power is now on System (equivalent) Apparent Power, see the papers by West (1997), Emanuel (1993), and IEEE Working Group Report. Also, the quantity know as RMS Apparent Power has also been considered by some technical institutions.

One of the main disadvantages with all the proposed methods for calculating Apparent Power is the fact that their results all depend on the voltage of reference point at which measurement is made. In single-phase circuits, the RMS values of voltage across the load and current through the load are clearly defined. However, in three-phase systems the Apparent Power should not depend on the reference voltage see paper by L. S. Czarnecki, "Power Related Phenomena in Three-Phase Unbalanced Systems", IEEE PWRD, Vol. 10, pp. 1168-1176. This disadvantage of the conventional power measurement methods is readily apparent by the following example of a three-phase system.

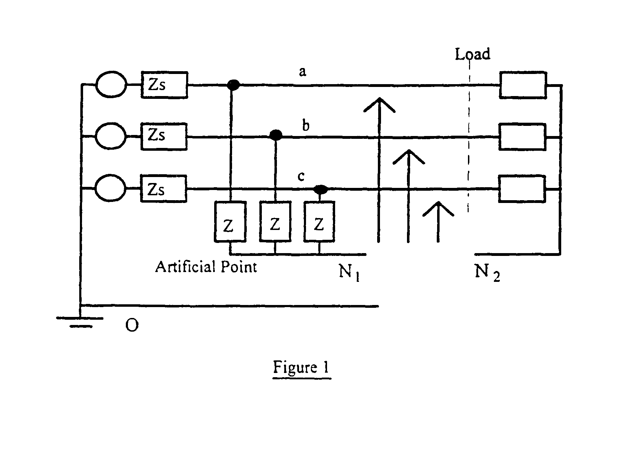

Considering Figure 1, in a balanced situation, points 0, N₁ and N₂ have zero voltage. The RMS values of the phase voltages measured with respect to three references are the same which in turn it implies that the Apparent Powers are equal. However, if the load is unbalanced then N_{1,} N₂ and 0 have different voltages. Only 0 retains zero voltage. Thus, Apparent Power calculated using the voltages measured with respect to 0, N_{1,} and N₂ will be different.

Now consider a three-phase load that is supplied by an ideal source (Zₛ=0). Assume that one of the lines, say "c", is broken (I_{c}=0). The measured voltage for phase "c" would be different on the sides of the broken point. If the voltage transducer is on the source side then it is the source voltage and if the potential transformer is on the load side, the measured voltage is influenced by the current of other two lines and the load impedance. Thus, the system (equivalent) Apparent Power (see papers by West (1997) and IEEE Working Group Report) will be different for the load.

One of the reasons for calculating Apparent Power is to obtain Power Factor. Consider now a single-phase circuit consisting of source with impedance Zₛ and a pure resistive load.

Conventionally, Power Factor for this load is calculated to be unity. Assume that the above single-phase load is connected to a three-phase system with the same source impedance/phase as the single-phase system. For simplification of the analysis assume a perfect earthing, hence zero neutral impedance. Depending on the definition used different results are obtained for Power Factor as the calculated Apparent Powers are different. Phasor and RMS Apparent Powers are both equal to unity. The System Apparent Power would be less than one. Surely, as the full system capacity is not utilised by the load and also due to extra losses in the form of negative and zero sequence powers in the source impedance, a unity Power Factor is technically unacceptable. In other words, a unity Power Factor does not reflect the quality of the load and utilisation of the system (see papers by L. S. Czarnecki and Emanuel). The System Apparent Power does reflect this effect of a single-phase load connected to a three-phase supply. However, since the load itself, and thus its quality, has not changed then one may argue that Power Factor must remain the same. It is clearly seen by the above that there is an inconsistency in the approach, observation and result using conventional power theory in AC circuits.

It is an object of the present invention to overcome the above problems.

The inventor has determined that the cause of the problems observed for polyphase circuits lies in the basic characterisation applied to single-phase circuits, which is flawed. Though the results given for single-phase systems are acceptable in practice, the extension to polyphase systems strains the analysis and produces the difficulties such as misleading and inconsistent results which have been observed.

The inventor has developed a novel power measurement method based on a new approach which advantageously removes the uncertainty and ambiguity from present methods of power measurement. The new approach applies consistently across-the-board to balanced and unbalanced loads, linear and non-linear loads, single-phase and polyphase supplies, to sinusoidal and non-sinusoidal supplies, and which is consistent for all system topologies and conditions, does not violate any principle of electrical engineering and can be readily implemented in practical equipment. The basis for the present invention is a complete and self-consistent mathematical approach covering all measurement scenarios.

According to a first aspect of the present invention, there is provided a method of measuring the value of an electrical power parameter of an electrical power signal as defined in claim 1.

One of the advantages of the present invention is that it enables consistent measurement such that loads can be properly characterised, so that efficient engineering action can be taken, or accurate pricing adjustments can be made

A utility embodying the present invention can offer accurate metering of these awkward loads can offer keener prices to attract the business of those customers whose loads are overestimated by existing meters. It has a proper basis on which to raise its prices to customers whose loads have been underestimated, to reflect the true economics of supplying them. There are many other commercial benefits.

The new approach described herein redefines the nature of Reactive Power. On that basis, a new definition for Apparent Power is provided which is consistent for all circuit situations and topologies. The new definitions satisfy the rules of electrical engineering both in time and frequency domain.

In an embodiment of the present invention, a voltage signal is phase shifted by -90° to produce a quadrature axis voltage signal. By multiplying the original and quadrature voltages by a current signal, two instantaneous power signals are obtained. The former is an instantaneous active power component signal *pₚ* (t) and the latter is an instantaneous quadrature (reactive) power component signal *p_{q}* (t). These signals satisfy the law of conservation of energy throughout the circuit, which implies that the sum of each of these instantaneous powers of different points in the circuit is zero. Reactive Power is then defined as the average DC-component value (mean) of the quadrature (instantaneous) power, *p_{q}*(t), that was obtained from the product of the quadrature axis voltage and current signal. Note that in conventional power theory, although Reactive Power is defined as the peak of the non-energy related component of instantaneous power, it is typically measured and considered as an average DC-component (mean) of the instantaneous power in technical applications such as billing.

According to the present invention, when the power parameter to be measured is Apparent Power, it is defined as the RMS value of the complex instantaneous power given by Equation (1). $p \left(t\right) = {p}_{p} \left(t\right) + j ⁢ {p}_{q} \left(t\right)$
where *p*ₚ(t) is an instantaneous active power component
*p*_{q}(t) is an instantaneous reactive power component

This definition of Apparent Power provides a consistent result in all system conditions, from single-phase sinusoidal to unbalanced three-phase systems with distorted waveforms. This consistency is unobtainable in other approaches.

In balanced three-phase systems with pure sinusoidal waveforms, the results obtained using the new approach are the same as those using conventional power theory.

In three-phase systems, since the new power theory is based on the sum of the instantaneous powers of three phases, then the measured Apparent Power, for example, is independent of the reference point voltage that is used in voltage measurement. This feature overcomes the conventional measurement methods problems described previously with respect to Figure 1 and is unique when comparing with other definitions of Apparent Power cited in literature and standards.

Using conventional understanding, Reactive Power is defined as the peak value of one of the oscillatory components of the instantaneous power. The inventor has determined that that this cannot be obtained in frequency domain contrary to Plancherel's Theorem. This discrepancy between frequency and time domain results leads to indeterminable quantities in the time and frequency domains, and is attributable to the fact that present power theory does not provide any information about Reactive Power in the frequency domain. Reactive Power as defined by the new approach is determined in both the time and frequency domains as an imaginary DC value, and the method is consistent for all system topologies.

The average (mean) values of the new instantaneous power on the real and the imaginary axes correspond to Active and Reactive Power respectively. Thus, in a method embodying the present invention, Reactive Power is defined and measured as a DC value and not as an ambiguous peak of one of the oscillatory components of instantaneous power.

Using the method embodying the present invention to determine the Active and Reactive Powers, it is demonstrated later that standard circuit theories are satisfied. The treatment of single-phase and three-phase systems are the same except that in three-phase systems the analysis is carried out on a per phase basis, and the total instantaneous power is obtained by adding together the three-phase results.

The 2-Norm, or RMS, of a signal is a measure of the size of that signal. Thus, Universal Apparent Power as determined by the method embodying the present invention is defined as the RMS of the complex instantaneous power. In three-phase balanced systems this definition leads to the standard definition of Universal Apparent Power that is three times the product of

RMS of voltage and RMS of current.

However, using the method embodying the present invention in single-phase and unbalanced three-phase systems, the Universal Apparent Power is different from conventional Apparent Power, although it retains its basic dimension of volt-ampere. In fact, from the new approach it can be seen that in single-phase systems the Universal Apparent Power is √2 times the RMS of voltage and current. This departure from the conventional Power Factor (which itself has little basis other than convention) is due to the AC components of the instantaneous power. In balanced three-phase systems the AC terms of the instantaneous power are cancelled.

Universal Power Factor determined by the method embodying the present invention is then considered as the ratio of Active Power to Universal Apparent Power as compared to conventional Power Factor. This leads to a reduced value for Universal Power Factor in a pure resistive single-phase circuit. In fact, for such a system the Universal Power Factor cannot be greater than 0.707 (1/√2). This reflects the consistency in the approach. This result, though arithmetically inconvenient, is shown to have a real basis in the analysis.

Symmetrical components have been used to analyse the new parameter definitions which are a feature of the present invention and a decomposition of different parameters in terms of the sequence components has been obtained. It is more technically acceptable for metering purposes that only the positive phase sequence voltage is considered in the analysis. This reflects the effects of unbalanced loads on the systems.

Preferably, the method further comprises filtering at least one of the instantaneous voltage and instantaneous current signals of the electrical power signal prior to their use in the calculating steps. In this way, several different but related parameters can be calculated by the same method steps with the appropriately filtered signals. More particularly, the filtering step preferably results in the fundamental frequency of the instantaneous voltage or the instantaneous current being obtained. Fundamental frequency filtered voltage signals enable the measured power parameter to be representative of network delivered power namely the power taken (used) by the load from the power supply.

It is to be appreciated that the present invention utilises at least the harmonics of one of the instantaneous voltage or the instantaneous current in combination with at least the fundamental frequency of the other instantaneous current or instantaneous voltage, to determine the power parameter. This covers three different situations namely: when one of the instantaneous voltage or current signals is unfiltered providing its full spectrum and the other is filtered; when both signals are unfiltered each providing the full frequency spectrum; and when one of the instantaneous voltage or current signals is filtered to provide its fundamental frequency spectrum and the other is filtered to provide its harmonic frequency spectrum. There is information in the harmonics of the instantaneous voltage or the instantaneous current which has previously been discarded that provides a more accurate measure of the power parameter.

By utilising the appropriate combination of filtered/unfiltered signals the following power parameters can be advantageously be calculated: Universal Apparent Power, Harmonic Apparent Power, Universal Distortion Factor, Voltage Distortion Power, Current Distortion Power, and Universal Power Factor.

The method may further comprise comparing a Network Delivered Power (NDP) Parameter, the Harmonic Apparent Power Parameter, the Voltage Distortion Power Parameter, or the Current Distortion Power Parameter with another power parameter determined by the method to produce a dimensionless figure of merit representative of the waveform distortion produced, in the electrical power signal, by a load to which the electrical power signal is supplied. This is a particularly useful power parameter to measure as it provides information about where power supply distortion is being generated. For example, power parameters such as Voltage Distortion Factor and Current Distortion Factor can be determined.

When the electrical power signal comprises a balanced or unbalanced multiple-phase signal, the method preferably further comprises resolving the multiple-phase signal into a phase sequence for use in establishing the effect of the load on the electric power network. The phase sequence may comprise a positive-phase sequence in order to obtain a measure representative of the power generated at a source of the electrical power signal.
Alternatively, the phase sequence may comprise negative and zero-phase sequences in order to obtain a measure representative of the power converted in the load. The method may also comprise using the positive, the negative and the zero-phase sequences to obtain a measure representative of the power used by the load.

According to a second aspect of the present invention there is provided a method of measuring the value of an electrical power parameter of an electrical power signal as defined in claim 23.

The method preferably further comprises: carrying out a relative phase-shift between the instantaneous voltage signal and the instantaneous current signal; and converting the relatively phase-shifted instantaneous voltage and current signals into the frequency domain for use in the frequency spectrum analysis.

Alternatively, the method further comprises: carrying out a relative phase-shift between the instantaneous voltage signal and the instantaneous current signal in the frequency domain for use in the frequency spectrum analysis.

The phase shift is important in order to be able to measure the imaginary (quadrature) component of the instantaneous power. In this way, the measurement of power quantities can be digitised and hence made significantly cheaper and more robust. The use of the frequency domain to calculate the power parameters also advantageously reduces the component counts in meters implementing the method.

Preferably, the frequency spectrum analysis involves carrying out a first convolution of the frequency spectra associated with the instantaneous voltage and current signals, a second convolution of the frequency spectra associated with the phase-shifted instantaneous voltage and current signals, and combining the results of the first and second convolutions.

The present invention extends to an electrical power meter for measuring the value of an electrical power parameter of an electrical power signal as defined in claim 29.

Presently preferred embodiments of the present invention will now be described by way of example with reference to the accompanying drawings. In the drawings:
Figure 1 is a schematic circuit diagram showing a conventional three-phase system with different reference points for voltage measurement;
Figure 2 is a schematic block diagram of a power measurement meter implementing a method of a first embodiment of the present invention;
Figure 3 is a flow diagram showing the steps involved in the implementation of the method of the first embodiment of the present invention;
Figure 4 is a graphical representation of an instantaneous power waveform showing the different averaging techniques used in the first embodiment of the present invention;
Figure 5 is a schematic block diagram of a power measurement meter implementing a method of a second embodiment of the present invention;
Figure 6 is a flow diagram showing the steps involved in the implementation of the method of the second embodiment of the present invention;
Figures 7a and 7b are diagrammatic representations of the frequency spectra of voltage and current for the single-phase AC power circuit;
Figure 8 is a diagrammatic representation of the frequency spectrum of an active component (Pₚ(f)) of the instantaneous power of the single-phase AC power circuit;
Figure 9 is a phasor diagram of the frequency spectrum of the complex instantaneous power of the single-phase AC power circuit;
Figure 10 is a schematic circuit diagram of a three-phase source and load circuit showing the flow of instantaneous power components with balanced and unbalanced loads;
Figure 11 is a phasor diagram of the frequency spectrum of the instantaneous power of a non-sinusoidal three-phase AC power circuit;

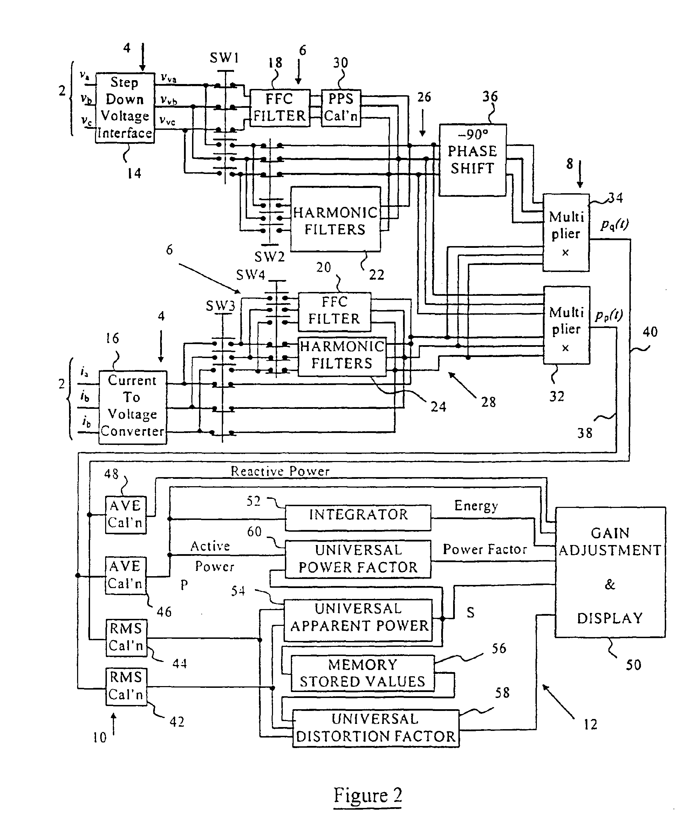

Referring now to Figure 2, there is shown a power measurement meter 1 which is used in carrying out a method of a preferred embodiment of the present invention. The power measurement meter 1 of this embodiment operates in the time-varying domain.

The power measurement meter 1 measures instantaneous voltage and current of a single-phase or three-phase electrical power supply system 2. From these measurements, the meter calculates the following power parameters: Universal Apparent Power, Fundamental Apparent Power, Harmonic Apparent Power, Universal Power Factor, Active Power, Reactive Power, Energy Consumption, Voltage Distortion Factor, Current Distortion Factor and Universal Distortion Factor.

The electronic circuit of the meter I essentially comprises five different stages namely, a signal conversion stage 4, a switchable filtering stage 6, a combining stage 8, an averaging stage 10 and a power parameter calculation and display stage 12.

Taking each of these stages in turn, the conversion stage 4 the electronic circuit comprises a step-down voltage interface 14 and a current-to-voltage converter 16. One side of the step-down voltage interface 14 is connected directly to the power supply system 2 being measured and the other side provides scaled down voltage signals νvₐ,ν_{vb},ν_{vc} representative of the magnitudes of voltage of the power supply system 2. Similarly, one side of the current-to-voltage converter 16 is connected directly to the power supply system 2 and the other side provides voltage signals νᵢₐ,ν_{ib},ν_{ic} representative of the magnitudes of current of the power supply system 2. These outputs from the step-down voltage interface 14 and the current-to-voltage converter 16 are passed to the switchable filtering stage 6.

The switchable filtering stage 6 comprises two sets of fundamental-frequency component filters 18,20 and two sets of harmonic filters 22,24. A fundamental-frequency component filter 18,20 and a set of harmonic frequency filters 22,24 are provided for the outputs of each of the step-down voltage interface 14 and the current-to-voltage converter 16. In addition, four user-controllable switches SW1,SW2,SW3,SW4 are provided for enabling selection of the appropriate set of filters or for allowing the outputs of the conversion stage 4 to bypass the filters altogether. The filter stage 6 has two outputs 26,28, the first output 26 is the signal representing the power supply voltage, the second output 28 is the signal representing the power supply current.

The filtering stage 6 also comprises, for the signal representing the power supply voltage, a positive phase sequence (PPS) calculation unit 30 which is arranged to receive the output of the fundamental-frequency component filter 18. The PPS calculation circuit 30 is arranged to convert an unbalanced three-phase signal into a positive phase sequence of balanced components. This type of unit 30 is well known in the art and the details of its operation are not therefore provided. The output of the PPS calculation unit 30 is coupled to the first output 26 of the filtering stage 6 and can provide one of the possible outputs.

The user-selected outputs 26,28 of the filtering stage 6 provide the inputs for the combining stage 8 of the circuit. More particularly, The combining stage 8 comprises an active component multiplier unit 32 and a reactive component multiplier unit 34 which each act to multiply together two different supplied signals input from the filtering stage 6. The active component multiplier unit 32 receives an input directly from each the above mentioned first and second outputs 26,28 of the filtering stage 6. However, the reactive component multiplier unit 34 only receives the second output 28 directly from the filtering stage 6. The first output 26 is modified by passing it through a -90° phase shifting unit 36 before being input to the reactive component multiplier unit 34.

The two outputs 38,40 of the multiplying stage 8, which respectively represent the active and reactive power components of the instantaneous power of the power supply system 2, are next processed by the averaging stage 10. The averaging stage 10 comprises an active RMS calculation unit 42 and a reactive RMS calculation unit 44 which are supplied with the outputs 38,40 of the active component multiplier unit 32 (*p*ₚ(t)) and the reactive component multiplier 34 (*p*_{q}(t)) respectively. In addition, the averaging stage 10 has an active mean signal calculation unit 46 which is supplied with the output 38 of the active component multiplier unit 32, and a reactive mean signal calculation unit 48 which is supplied with the output 40 of the reactive component multiplier unit 34. The outputs of these RMS calculation units 42,44 and mean signal calculation units 46,48 are provided to the power parameter calculation and display stage 12.

The reactive mean signal calculation unit 48 simply calculates the mean of the reactive component (*p*_{q}(t)) of the instantaneous power of the electrical power supply system 2. The output of the reactive mean signal calculation unit 48, which represents the Reactive Power (Q) of the electrical power supply system 2, is supplied directly to a gain adjustment and display unit 50 where it can be displayed as a measured value to the meter user. Gain adjustment is required to normalise measured values for display and to compensate for the differences in the results for the measurement of a three-phase or a single-phase electrical power supply, for example.

Similarly, the active mean signal calculation unit 46 calculates the mean of the active component (*p*ₚ(t)) of the instantaneous power of the electrical power supply system 2. The output of the active mean signal calculation unit 46 represents the Active Power (P) of the electrical power supply system 2 and this is also supplied directly to the gain adjustment and display unit 50 for display.

The measured Active Power (P) is also supplied to an energy consumption measurement unit 52. Here the measured Active Power is integrated over a given time period and the result is the energy consumption over that time period. The energy consumption measurement unit 52 outputs its result to the gain adjustment and display unit 50 for display.

The active RMS calculation unit 42 and the reactive RMS calculation unit 44 calculate the RMS values of the active and reactive components of the instantaneous power (*p*ₚ(t) and *p*_{q}(t)) respectively. The outputs of each of these RMS calculation units 42,44 is supplied to a Universal Apparent Power calculation unit 54. This unit 54 is arranged to calculate the Universal Apparent Power, the Fundamental Apparent Power or the Harmonic Apparent Power of the power supply in dependence upon the filter selection in the switchable filtering stage 6. More specifically, when none of the outputs of the step-down voltage interface 14 and the voltage-to-current converter 16 are filtered, the RMS values are geometrically summed in this unit 54 to calculate the Universal Apparent Power (S), namely, the Universal Apparent Power is the root of the sum of the squares of the RMS values. When both of the outputs of the step-down voltage interface 14 and the current-to-voltage converter 16 are filtered by the harmonic frequency component filters 22,24 the unit calculates the Harmonic Apparent Power.

These calculated values for Universal Apparent Power and the Harmonic Apparent Power are output to the gain adjustment and display unit 50 for display. A further output is supplied to a memory unit 56 which stores the Universal Apparent Power or the Harmonic Apparent Power for subsequent use with a Universal Distortion Factor calculation unit 58.

The output of each of these RMS calculation units 42,44 is also supplied to the Universal Distortion Factor calculation unit 58. A further input is taken from the memory unit 56. The Universal Distortion Factor calculation unit 58 is arranged to calculate, in dependence upon the configuration of the switchable filtering stage 6, the Universal Distortion Power, the Current Distortion Factor or the Voltage Distortion Factor. These factors are dimensionless figures of merit which are ratios of Apparent Power and distortion power. More particularly, when the output of the step-down voltage interface 14 is filtered by the fundamental frequency component filter 18, and the output of the current-to-voltage converter 16 is filtered by the harmonic frequency component filters 24, the Current Distortion Factor is calculated. However, when the output of the step-down voltage interface 14 is filtered by the harmonic frequency component filters 24, and the output of the current-to-voltage converter 16 is filtered by the fundamental frequency component filter 20, the Voltage Distortion Factor is calculated.

The calculation of any of these Distortion Factors is a four-stage process which involves: firstly, calculating the Universal Apparent Power using a particular filter selection; secondly, storing the calculated value in the memory unit 56; thirdly, calculating the selected Distortion Power using a particular filter setting; and finally, calculating the ratio of the Distortion Power to the Universal Apparent Power. The output of the Universal Distortion Factor calculation unit 58 is supplied to the gain adjustment and display unit 50 for display to the user.

It is to be appreciated that whilst the outputs of the active and reactive RMS calculation units 42,44 have in themselves no significant meaning within the electrical power supply itself, they have great importance when they are used in the determination of the value of a desired power parameter. In the present case, these outputs are processed directly by the Universal Apparent Power calculation unit 54 and the Universal Distortion Factor unit 58.

The Universal Apparent Power value is also supplied to a Universal Power Factor calculation unit 60 together with the Active Power output (P) of the active mean signal calculation unit. The Universal Power Factor is calculated as the ratio of the measured Active Power to the measured Universal Apparent Power, namely P/S. This calculated value for Universal Power Factor is output to the gain adjustment and display unit 50 for display.

The selection of the appropriate switches (not all shown) on the meter allows the user to select the quantity to be measured and displayed.

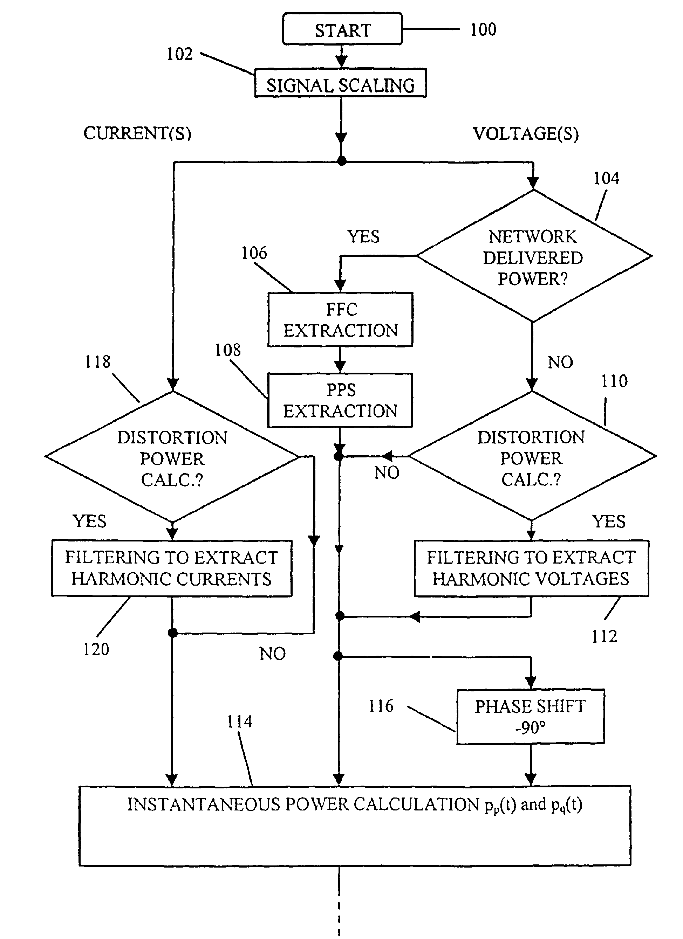

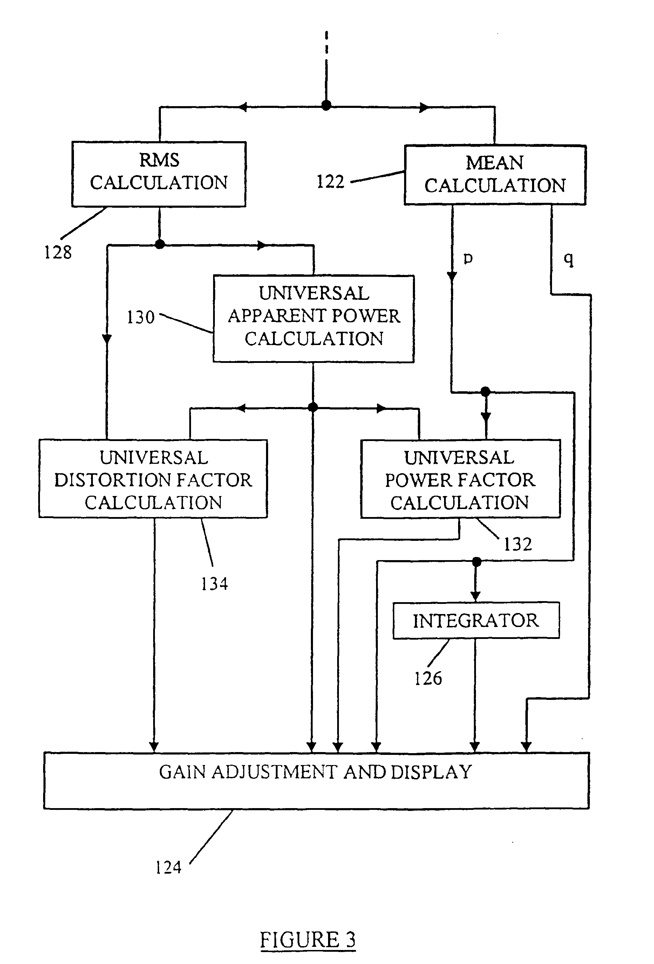

Referring now to Figure 3, a method of measuring the value of a power parameter using the meter 1 of Figure 2 is now described. For the sake of convenience, the following description will assume that a three-phase AC power signal is being sensed, though the method is also applicable to a single-phase AC signal.

The method commences at 100 with the voltage *v*ₐ,*v*_{b},*v*_{c} and current iₐ,i_{b},i_{c} of the power signal being sensed. The step-down voltage interface 14 scales down the sensed voltage range at 102 to voltage signals *v*ᵥₐ,*v*_{vb},*v*_{vc} within a smaller predetermined acceptable voltage range for the circuit. Similarly, the current-to-voltage converter 16 transforms at 102 the sensed current signals *i*ₐ,*i*_{b},*i*_{c} into voltage signals *v*ᵢₐ,*v*_{ib},*v*_{ic} such that they are of same voltage magnitude range as that produced by the step-down voltage interface 14. Typically, the voltages are stepped down from 110 Volts to a range of ±10 Volts. The magnitude of the sensed current is also converted to a range of ±10 Volts.

The position of the filter switch SW1 determines at 104 whether or not the quantity being measured relates to network delivered power. In one position, where the quantity does relate to network delivered power, the voltages signals *v*ᵥₐ,*v*_{vb},*v*_{vc} are filtered by the fundamental frequency component filter 18 at 106. Following this, the filtered voltage signals *v*ᵥₐ,*v*_{vb},*v*_{vc} are passed to the PPS calculation unit 30 where the positive phase sequence is extracted at 108.

In the other position, where the quantity does not relate to network delivered power, the voltage signals *v*ᵥₐ,*v*_{vb},*v*_{vc} are passed onto the switch SW2 which determines at 110 whether or not a distortion power calculation is to be carried out. If distortion power is to be calculated, the switch SW2 directs the voltage signals *v*ᵥₐ,*v*_{vb},*v*_{vc} to the harmonics filters 22 where the voltage signals *v*ᵥₐ,*v*_{vb},*v*_{vc} are filtered at 112 to extract the harmonics of the signals. Otherwise, the voltage signals *v*ᵥₐ,*v*_{vb},*v*_{vc} are not filtered.

The resultant voltage signals *v*ᵥₐ,*v*_{vb},*v*_{vc} from the PPS extraction at 108, the filtering at 112, or the non-filtering at 110, form the first output 26 of the switchable filtering stage 6. This first output 26 is passed directly to the instantaneous power calculation at 114 where the active component of instantaneous power *p*ₚ(t) and the reactive component of instantaneous power *p*_{q}(t) are calculated. In addition, the first output 26 is shifted at 116 by a -90° phase shift and then passed on for the instantaneous power calculation at 114.

On the current sensing side of the procedure, the voltage signals *v*ᵢₐ,*v*_{ib},*v*_{ic} representative of the current of the power supply system 2 are determined at the signal scaling step at 102 of the procedure. These voltage signals *v*ᵢₐ,*v*_{ib},*v*_{ic} are then processed by the switchable filter stage 6
where the position of the filter switches SW3, SW4 determine at 118 whether or not a distortion power calculation is to be carried out. If distortion power is to be calculated, the switches SW3 and SW4 direct the voltage signals *v*ᵢₐ,*v*_{ib},*v*_{ic} to the harmonics filters 24 where the voltage signals *v*ᵢₐ,*v*_{ib},*v*_{ic} are filtered at 120 to extract the harmonics of the signals. Otherwise, the voltage signals *v*ᵢₐ,*v*_{ib},*v*_{ic} are not filtered.

The resultant voltage signals *v*ᵢₐ,*v*_{ib},*v*_{ic} from the filtering at 120, or the non-filtering at 118, form the second output 28 of the switchable filtering stage 6. This second output 28 is passed directly to the combining stage 8 where the instantaneous power calculation at 114 calculates the active component of instantaneous power *p*ₚ(t) and the reactive component of instantaneous power *p*_{q}(t). The relationship between the active and reactive components to the instantaneous power for a single-phase power supply has previously been stated in Equation 1. In three-phase the equivalent is given below: $p \left(t\right) = {p}_{a} \left(t\right) + {p}_{b} \left(t\right) + {p}_{c} \left(t\right)$
where
*p*(t) = total complex instantaneous power
*p*ₐ(t) = complex instantaneous power of phase a = (νₚₐ + jυ_{qa}) *i*ₐ = *p*ₚₐ + j*p*_{qa}
*p*_{b}(t) = complex instantaneous power of phase b= (ν_{pb} + jυ_{qb}) *i*_{b} = *p*_{pb} + j*p*_{qb}
*p*_{c}(t) = complex instantaneous power of phase c= (ν_{pc} + jυ_{qc}) *i*_{c} = *p*_{pc} + j*p*_{qc}

An equation representing the processing carried out on the voltage signals to determine at 114 the active and reactive components is given below: ${p}_{p} \left(t\right) = \left(three-phase version\right) = {v}_{pa} {i}_{a} + {v}_{pb} {i}_{b} + {v}_{pc} {i}_{c}$ ${p}_{q} \left(t\right) = \left(Three phase version\right) = {v}_{qa} {i}_{a} + {v}_{qb} {i}_{b} + {v}_{qc} {i}_{c}$
where:
*v*ₚₐ(t) = instantaneous voltage of phase a
*v*_{pb}(t) = instantaneous voltage of phase b
*v*_{pc}(t) = instantaneous voltage of phase c
*v*_{qa}(t) = instantaneous phase-shifted voltage of phase a
*v*_{qb}(t) = instantaneous phase-shifted voltage of phase b
*v*_{qc}(t) = instantaneous phase-shifted voltage of phase c
*i*ₐ (t) = instantaneous current of phase a
*i*_{b} (t) = instantaneous current of phase b
*i*_{c} (t) = instantaneous current of phase c

The two outputs 38,40 of the combining stage 8, representing the active and reactive components of the instantaneous power of the power supply, are subject to a mean signal calculation at 122 which determines the values for Active Power (P) and Reactive Power (Q) of the electrical power supply system 2. These power parameters (P and Q) are then gain adjusted and displayed to the meter user at 124. In addition, the Active Power is integrated at 126 to determine the energy consumption of the electrical power supply system 2. The thus determined energy consumption parameter is gain adjusted and displayed to the meter user at 124.

The active and reactive components of the instantaneous power of the power supply, are also supplied to the averaging stage 10 where an RMS calculation at 128 on each of the active and reactive power components is carried out. The following equations represent the processing at this stage: $RMS \left[{p}_{p}\left(t\right)\right] = \left(three phase\right) = ‖ {p}_{p} \left(t\right) ‖ = \begin{matrix}√\end{matrix} \left\{1/T⁢{{\int }_{0}}^{T}⁢{\left[{p}_{p}\left(t\right)\right]}^{2}ⅆt\right\}$ $RMS \left[{p}_{q}\left(t\right)\right] = \left(three phase\right) = ‖ {p}_{q} \left(t\right) ‖ = \begin{matrix}√\end{matrix} \left\{1/T⁢{{\int }_{0}}^{T}⁢{\left[{p}_{q}\left(t\right)\right]}^{2}ⅆt\right\}$
where: *p*ₚ and *p*ₚ are as in equations (3) and (4)

The RMS calculations of each of the active and reactive power components are used to determine at 130 the Universal Apparent Power of the electrical power supply. This involves determining the root of the summation of the squares of the instantaneous power components as is set out below: $S = \begin{matrix}√\end{matrix} \left[{‖ {p}_{p} \left(t\right) ‖}^{2}+{‖ {p}_{q} \left(t\right) ‖}^{2}\right]$

This power parameter (S) is then gain adjusted and displayed to the meter user at 124. In addition the Universal Apparent Power determined described above is used in the calculation of Universal Power Factor at 132 as a ratio of Active Power (P) to Universal Apparent Power (S). Furthermore, using the four-stage process described earlier but not shown in Figure 3, the Universal Apparent Power is also stored in the memory unit 56 and used to determine at 134 the new quantity called Universal Distortion Factor. Both the Universal Power Factor and the Universal Distortion Factor are gain adjusted and displayed to the meter user at 124.

As has been described previously, the particular value of a power parameter determined by the Universal Apparent Power calculation at 130, by the Universal Power Factor calculation at 132, or by the Universal Distortion Factor calculation at 134, is dependent on the selected arrangement of the switchable filtering stage 6. Therefore, even though not shown on Figure 3, other related power parameters can be calculated at steps 130, 132 and 134, by simply selecting the appropriate combination of filtering at the switchable filtering stage 6.

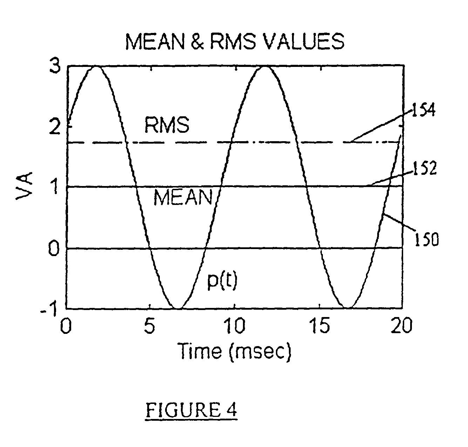

It is worth appreciating the difference between the two different types of averaging carried out at the averaging stage 10. The difference is clearly illustrated with reference to Figure 4 of the accompanying drawings. Here an instantaneous power signal p(t) 150 in the form of a sine wave is shown. The mean value 152 of the signal 150, is the DC offset 152 about which the signal is oscillating symmetrically and this is shown to have a value of 1.0 on the VA scale. The RMS value 154 of the signal 150, can be seen to be greater than the mean value 152. This is because of the positive contribution made by the oscillatory component of the signal to the RMS calculation.

The above meter 1 can be readily implemented in both the digital and analogue domains. Also, whilst the above meter has been described as comprising of a plurality of processing units, it is possible for them to be replaced by a single processing unit which carries out all of the desired functions. The most practical example of this is for the single processing unit to be a microprocessor running a program implementing the desired functions by way of an algorithm. For example, the meter 1 could be implemented in an ASIC (Application Specific Integrated Circuit) in order to reduce component costs with the output of the signal conversion stage 4 being digitised before processing by the other stages.

The above method of the present invention has been tested through use of a computer simulation to determine how its measurements compare to those of conventional power measurement methods. This has been carried out under two general conditions: firstly for balanced and unbalanced linear loads; and secondly, for balanced and unbalanced non-linear loads. The simulation analysis has been carried using ElectroMagnetic Transient Programme (EMPT) which is a universally accepted software program for power system simulation.

Referring to Table 1, simulation results are given for balanced/unbalanced linear loads. The results show Universal Apparent Power and Universal Power Factor ('UAP' and 'UF') using the method embodying the present invention, and conventional Arithmetic 'RMS' and System definitions of Apparent Power and Power Factor.

In the case of a three-phase balanced load with sinusoidal waveforms (Tests A and B), the three methods used give identical results, as expected. No values are quoted for the NDP

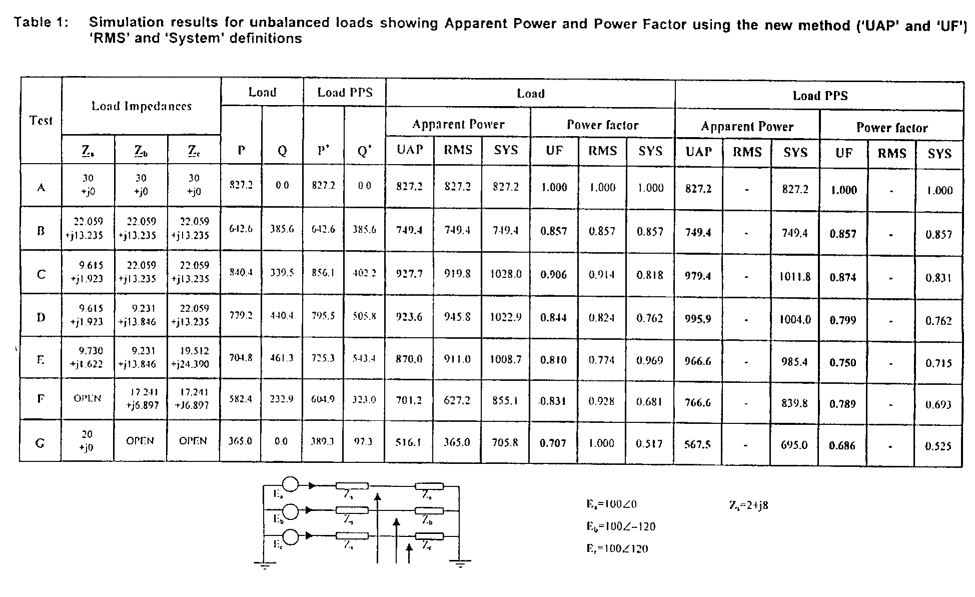

(Network Delivered Power) RMS Apparent Power and Power Factor because they are not defined in the RMS convention.

It is to be noted that in the extremely unbalanced situation illustrated in test G, the load PPS Reactive Power is 97.3 VAr where the load is a pure resistance. This is equal to the Reactive Power demanded by the source negative and zero phase sequence (NPS, ZPS) impedances.
The load converts, in this situation, all of the PPS Reactive Power into NPS and ZPS Reactive Power which is injected back to the system to be used by the source impedance.

The results obtained by the three methods are different in the case of unbalanced loads, again in line with expectation.

Referring to Table 2, simulation results are given for non-linear loads in balanced and non-balanced conditions. The results show Universal Apparent Power and Universal Power Factor ('UAP' and 'UF') using the method embodying the present invention, and conventional RMS and System definitions of Apparent Power and Power Factor.

In this case, the EMTP simulation package was used to model a three-phase, phase controlled thyristor system. This simulation allows different, non-linear load conditions to be tested.

Tests H, M, T and Y are similar to tests A and B shown in Table 1. In these cases, a balanced load is used, and the thyristor firing angle is zero, resulting in an undistorted waveform. The other tests were carried out with firing angles of 72° and 144° to give strong harmonic content to the voltage and current waveforms. In these circumstances, the three methods give different results. Generally speaking, the RMS and System Apparent Powers give similar results for a balanced load that is supplied with distorted or sinusoidal waveforms. This can also be analytically proved to be true. The difference between these two definitions is particularly clear when the load is unbalanced.

With all three methods, Power Factor and UF reduces as the firing angle increases.

Sub-sets of the tests involved evaluating the effect of different earthing arrangements. An artificial reference point was realised by connecting a star of high-value resistors in parallel with load. The star point of this combination was used as the reference point for voltage measurement.

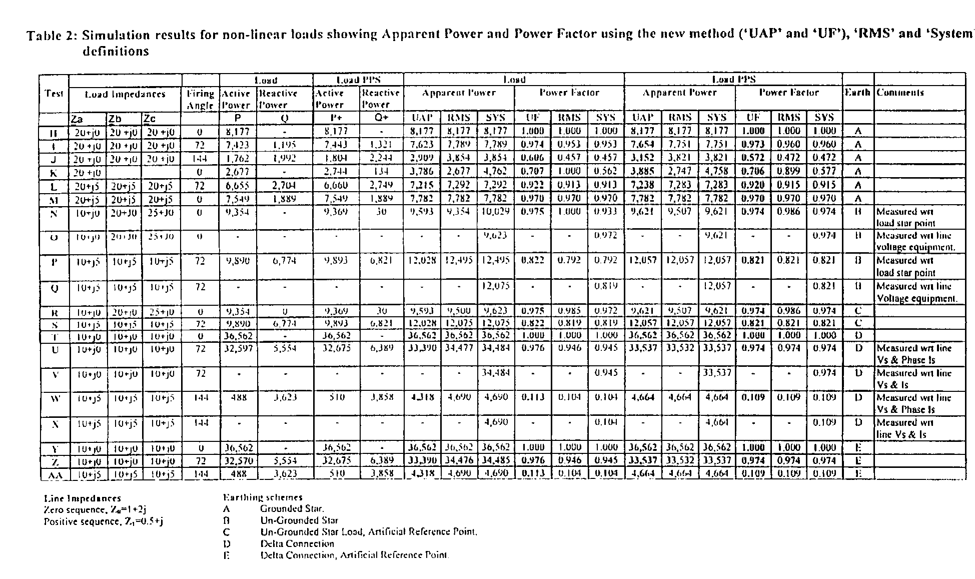

In cases where only the System Apparent Power has been specified and other power quantities have been designated as blank, Active and Reactive Power cannot be deduced from the voltages and currents used in Apparent Power calculation.

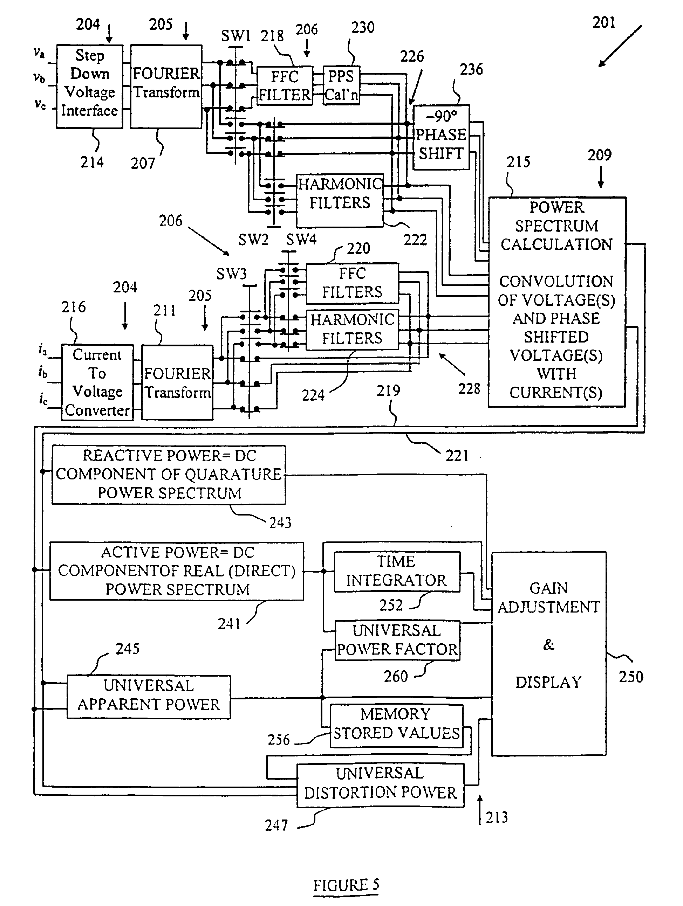

Referring now to Figure 5, there is shown a power measurement meter 201 which is used in carrying out a method of another preferred embodiment of the present invention. The power measurement meter 201 of this embodiment operates in the frequency-varying domain and will be referred hereinafter as the FD meter 201.

The FD meter 201 is arranged to implement a method which is equivalent to that of the first embodiment, but in the frequency domain. The resultant measurements of power quantities (parameters) from the FD meter 201 are equivalent to that of the time-domain power meter 1 of the first embodiment. There are similarities between the two embodiments (c.f. Figures 2 and 5) and to avoid unnecessary repetition, the following description of the FD meter 201 is directed to those differences. Where components of the FD meter 201 are identical those of the time-domain power meter 1, the same reference numerals with a constant prefix (of '2') have been used to label those components.

The electronic circuit of the FD meter 201 comprises five different stages namely, a signal conversion stage 204, a signal transform stage 205, a switchable filtering stage 206, a combining stage 209, and a power parameter calculation and display stage 213. The signal conversion stage 204 and the switchable filtering stage 206 are identical in function to those of the first embodiment and so will not be described further.

The outputs of the conversion stage 204, namely the voltage signals *v*ᵥₐ,*v*_{vb},*v*_{vc} and *v*ᵢₐ,*v*_{ib},*v*_{ic} are converted into the frequency domain at the signal transform stage 205 by two Fourier Transform units 207,211. These transform units 207,211 are well understood in the art for performing a standard transformation into the frequency domain and as such, no further description of their function is required. The outputs of the two Fourier Transform units 207,211, which are each in the form of a frequency spectrum, are supplied as inputs to the switchable filtering stage 206.

The user-selected outputs 226,228 of the filtering stage 206 provide the inputs for the combining stage 209 of the circuit. More particularly, the combining stage 209 comprises a power spectra calculation unit 215 which acts to convolve three different inputs together to form a first and a second component instantaneous power spectra. The power spectra calculation unit 215 receives an input directly from each the above mentioned first and second outputs 226,228 of the filtering stage 206. These two signals are convolved into a first component instantaneous power spectrum 219.

The combining stage 209 receives a further input which is the first output 226 of the filtering stage 206 modified by passing it through a -90° phase-shifting unit 236. This phase-shifted signal is convolved with the second output 228 of the filtering stage 206 into a second component instantaneous power spectrum 221. The process of convolution is well understood in the art and so requires no further explanation.

The first and second component instantaneous power spectra 219,221 are output from the combining stage 209 and supplied to the power parameter calculation and display stage 213. Here, the various power parameters can be determined relatively simply from the various components of the instantaneous power spectra 219,221 as is described below.

The power parameter calculation and display stage 213 comprises an Active Power calculation unit 241 to which the first component instantaneous power spectrum 219 is supplied. The Active Power is simply calculated as the DC component of the first component instantaneous power spectrum 219. Similarly, a Reactive Power calculation unit 243 is provided to which the second component instantaneous power spectrum 221 is supplied. The Reactive Power is simply calculated as the DC component of the second component instantaneous power spectrum 221.

The Universal Apparent Power is measured at the Universal Apparent Power calculation unit 245 by combining the first and second component power spectra 219,221. More specifically, the Universal Apparent Power is determined by calculating the square root of the sum of the squares of the frequency components of the first and second component power spectra 219,221.

The remaining parts of the power parameter calculation and display stage 213 are almost identical to those of the previous embodiment and accordingly no further description of the function of these units is given. However, one minor difference is that the Universal Distortion Factor calculation unit 247 receives the first and second component power spectra 219,221 as inputs.

It is to be appreciated that the desired power quantities can be derived from the first and second calculated power spectra 219,221 without the need for an averaging stage 10 as is needed in time-domain calculations of the previous embodiment. This advantageously reduces component cost and circuit complexity. Furthermore, the electronic circuit of a FD meter 201 is far more readily implemented as a digital device than the electronic circuit of a time-domain meter.

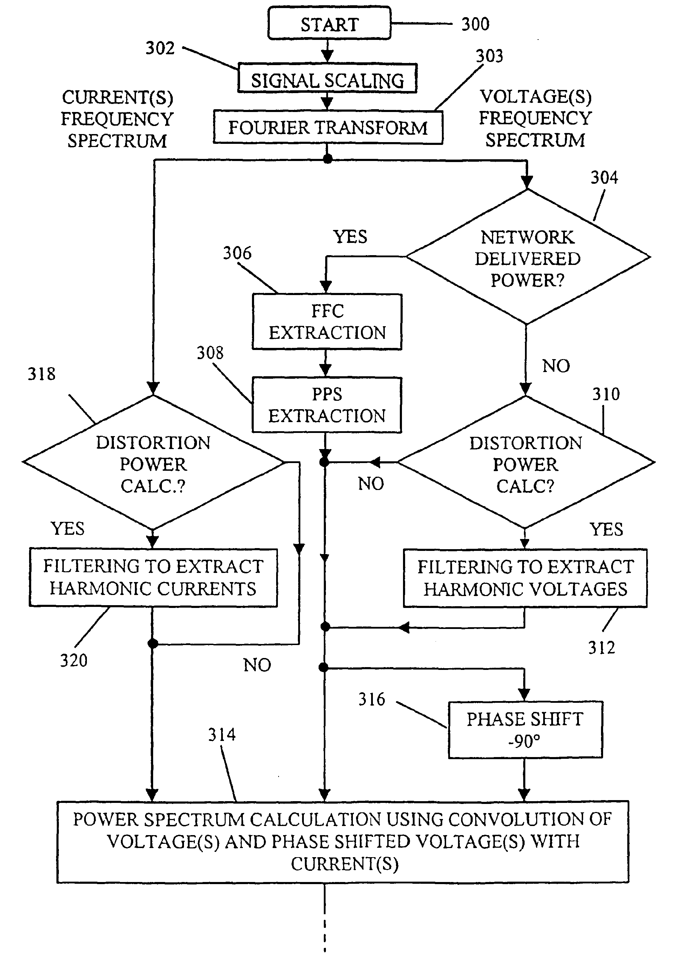

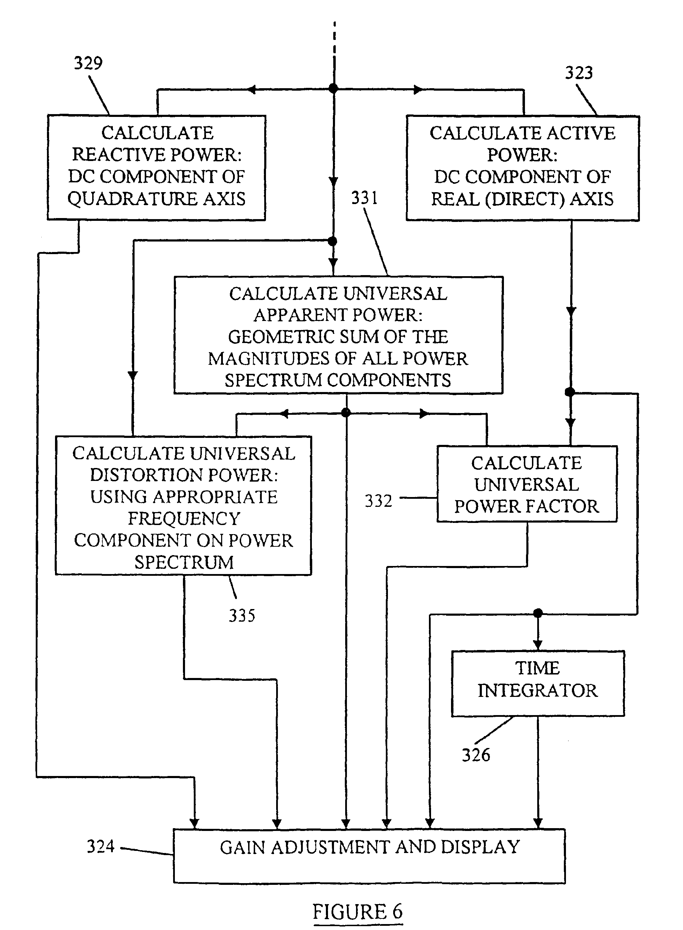

Referring now to Figure 6, a method of measuring the value of a power parameter using the FD meter 201 of Figure 5 is now described. As in the previous embodiment, the following description will assume that a three-phase AC power signal is being sensed, though the method is also applicable to a single-phase AC signal.

The method of measuring an electric power parameter using the above described FD meter is equivalent to that of the first embodiment, but in the frequency domain. There are a significant number of common procedural steps between the two embodiments (c.f. Figures 3 and 6) and to avoid unnecessary repetition, the following description of the frequency domain power parameter measurement will only briefly mention the similarities. Where components of the FD meter 201 are identical those of the time-domain power meter 1, the same reference numerals with replacement prefix (of '3') have been used to label those components.

The method commences at 300 with the voltage *v*ₐ,*v*_{b},*v*_{c} and current *i*ₐ,*i*_{b},*i*_{c} of the power signal being sensed. These signals are scaled down at 302 to voltage signals *v*ᵥₐ,*v*_{vb},*v*_{vc} and vᵢₐ,v_{ib},v_{ic} respectively. Then a frequency-domain representation (a frequency spectrum) of each of these voltage signals *v*ᵥₐ,*v*_{vb},*v*_{vc} and *v*ᵢₐ,*v*_{ib},*v*_{ic} is obtained by performing at 303 a Fourier transform on each of the voltage signals *v*ᵥₐ,*v*_{vb},*v*_{vc} and *v*ᵢₐ,*v*_{ib},*v*_{ic}.

The frequency spectrum of the voltage signals *v*ᵥₐ,*v*_{vb},*v*_{vc} is then filtered at 306 to extract its fundamental frequency component and subsequently a positive phase sequence is extracted at 308 if the network delivered power is being measured at 304. Otherwise, if a distortion power calculation is required at 310, the frequency spectrum of the voltage signals *v*ᵥₐ,*v*_{vb},*v*_{vc} is then filtered at 312 to extract its harmonic voltages. The outputs of the PPS extraction at 308, the harmonic filtering at 312 and the non-filtered spectra determined at 310 together provide the first output 226 of the filtering stage 206.

This first output 226 is then divided into two spectra, one which is phase shifted by -90° to give a quadrature representation of the voltage signal *v*ᵥₐ,*v*_{vb},*v*_{vc} and the other which is not phase shifted at all.

The frequency spectrum of the current related voltage signals *v*ᵢₐ,*v*_{ib},*v*_{ic} are, if a distortion power calculation is required at 318, filtered at 320 to extract its harmonic voltages. This provides the second output 228 of the filtering stage 206.

The spectrum of the second output 228 and the two divided spectra of the first output 226 are processed in a power spectrum calculation at 315. Here the frequency spectra of the non-phase shifted first output 226 and the second output 228 are convoluted together to form the active component power spectrum 219. Also the frequency spectrum of the second output 228 and the frequency spectrum of the phase-shifted first output 226 are convoluted together at 315 to form the reactive component power spectrum 221.

Both of the active and reactive component power spectra 219,221 are forwarded to the power parameter calculation and display stage 213. Here, the Active Power is calculated at 323 as the DC component of the active component power spectrum 219. In addition, the Reactive Power is calculated at 329 as the DC component of the reactive component power spectrum 221. The Universal Apparent Power is simply calculated at 331 as the geometric sum of the magnitudes of all the power spectra components, namely by calculating the root of the sum of the squares of each of the elements of the active and reactive component power spectra 219,221.

The Universal Distortion Factor is calculated at 335 by considering both the active and reactive component power spectra 219,221 and the Universal Apparent Power stored in the memory unit 256 (not shown in Figure 6).The calculation of Universal Power Factor at 332 and the Energy Consumption at 326 is equivalent to that described in the previous embodiment. Similarly, the gain adjustment and display at 324 is no different to that previously described.

In the frequency domain the spectrums of the active and reactive components of instantaneous power (Pₚ(f), P_{q}(f)) are determined by the following equations: ${P}_{p} \left(f\right) = {V}_{pa} \left(f\right) * {I}_{a} \left(f\right) + {V}_{pb} \left(f\right) * {I}_{b} \left(f\right) + {V}_{pc} \left(f\right) * {I}_{c} \left(f\right)$ ${P}_{q} \left(f\right) = {V}_{qa} \left(f\right) * {I}_{a} \left(f\right) + {V}_{qb} \left(f\right) * {I}_{b} \left(f\right) + {V}_{qc} \left(f\right) * {I}_{c} \left(f\right)$
Where * = convolution of the signals.
Vₚₐ (f) = original voltage spectrum of phase a
V_{pb} (f) = original voltage spectrum of phase b
V_{pc} (f) = original voltage spectrum of phase c
Iₐ (f) = original current spectrum of phase a
I_{b} (f) = original current spectrum of phase b
I_{c} (f) = original current spectrum of phase c

In both of the above described embodiments, the output of the fundamental frequency component filter 18,218 always is supplied to the PPS calculation unit 30,230. It should be noted that when the three-phase power supply is balanced or only a single-phase power supply is being monitored, there is no need for a positive phase sequence. In these cases, the output of the PPS calculation unit 30,230 will make virtually no difference to the result. In the case of a single-phase supply, the value obtained as the first output 26,226 of the filtering stage 6,206 will need to be multiplied by three times to give the correct value. However, as this is a constant value, the gain adjustment step 124,324 at the very end of the process can compensate for this difference. This could for example be programmed into an algorithm such that the compensation was automatic.

It is to be appreciated that, whilst a phase shift is carried out on only the voltage signal to produce the -90° phase shift, it is possible to carry out a phase shift of the current signal to produce the same effect. This can be extended to a situation where both the voltage and current signals could each be phase shifted by amounts which result in the effective (relative) phase shift being equivalent to the -90° carried out in the above-described embodiments.

The present invention is based on a novel appreciation of the definitions of electric power parameters. These definitions are the subject of complex mathematical analysis which is necessary to explain the characteristics of single-phase and multiphase power distribution. In order to better understand the new theories underlying the present invention, three papers authored by the inventor are now presented.

**ABSTRACT** In this paper a new definition of apparent power in single and three phase systems is presented. The technique is based on the instantaneous power, which satisfies the law of conservation of energy. In this technique the reactive power is determined as a dc imaginary component of the instantaneous power. The apparent power is defined as the rms or 2-Norm of the instantaneous power. The technique satisfies the Plancherel's theorem both in time and frequency domain. It will be shown that the power factor can only be made to unity in a 3-phase balanced system if the new definition of apparent power is used.

### KEYWORD Power theory, Apparent Power, Power Factor

### 1-INTRODUCTION

The definition of power in ac circuits has been a subject of research and investigation for many years. Although the definition of active power has widely been accepted, there is a continuous controversy on the definition of the apparent power (AP), reactive power, and power factor (pf) in three phase systems and circuits with distorted waveforms [1, 2, 3]. The problems are well established and have been reported in many technical papers [1, 2, 3, 4], but yet no acceptable solutions have been found. In recent years, there have been reports on new methods for calculating and measuring the AP in three phase systems. However, all of these methods have their shortcomings and are not totally accepted by the academia and industry.

The method reported and used in [3] and [4] utilises the equivalent voltage and current for three phase systems to calculate the AP. This has the main disadvantage that the outcome depends on the reference voltage. Also the physical bases of the core of the theory which is the assumption that reactive power is purely the magnitude of one of the oscillatory component of the instantaneous power and the AP is only related to the losses of the system, has not been totally accepted [5].

For example, by considering the figure in the discussion section of reference [3] (second discussor), one can see that the value of the apparent power as defined in the paper depends on the point of voltage measurement for the broken line. The AP would be different if the voltage is taken from the load side of the broken point to the case when the voltage is taken from the source side. Therefore, it is clearly evident that the value of the AP as defined in reference [3] and [4] may not be unique for a given load.

In this report, first a single-phase system is considered and the power theory in time and frequency domain is investigated and a new technique is proposed. The proposed method for calculating the AP and hence pf is then extended to three-phase systems. Throughout this work the focus has been on the instantaneous power (IP), since the law of "conservation of energy" is satisfied by this power in an ac system [6]. Also, as has been discussed in reference [7], unlike the current calculation in the frequency domain, the present power theory in electrical engineering has the shortcoming that the time domain analysis does not fully agree with the frequency domain calculation [7]. This feature of the proposed method will also be addressed.

### 2-SINGLE PHASE SYSTEMS

Equation (1) and (2) respectively give the voltage across and current in impedance Z=|Z| ∠ϕ in a single-phase circuit. $v \left(t\right) = \hat{V} ⁢ cos \left({ω}_{1}⁢t+α\right)$ $i \left(t\right) = \hat{I} ⁢ cos \left({ω}_{1}⁢t+β\right)$

It is clear that: $ϕ = ↼ Z = α - β$

The instantaneous power, *p(t)* is defined as follows: ${p}_{p} \left(t\right) = v \left(t\right) ⁢ i \left(t\right) = \frac{\hat{V} ⁢ \hat{I}}{2} ⁢ cos \left(α-β\right) + \frac{\hat{V} ⁢ \hat{I}}{2} ⁢ cos \left(2⁢{ω}_{1}⁢t+α+β\right)$

Equation (4) can be rearranged as (5) and its average is given by Equation (6). ${p}_{p} \left(t\right) = v \left(t\right) ⁢ i \left(t\right) = P + Pcos ⁢ \left(2⁢{ω}_{1}⁢t+2⁢β\right) - Qsin ⁢ \left(2⁢{ω}_{1}⁢t+2⁢β\right)$ $P = \frac{1}{T} ⁢ {\int }_{0}^{T} ⁢ v \left(t\right) ⁢ i \left(t\right) ⁢ dt = \frac{\hat{V} ⁢ \hat{I}}{2} ⁢ cosϕ$
where T is the period of the signals. The standard active and reactive powers are defined as given by (7.a) and (7.b). $P ⁢ {=}^{Δ} ⁢ \frac{\hat{V} ⁢ \hat{I}}{2} ⁢ cosϕ = VIcosϕ$ $Q ⁢ {=}^{Δ} ⁢ \frac{\hat{V} ⁢ \hat{I}}{2} ⁢ sinϕ = VIsinϕ$

V and I are the rms values of voltage and current respectively.

Note that the reactive power is defined as the magnitude of one of the oscillatory components. The AP is defined as the product of the rms values of voltage and current as shown below; $S = VI = \sqrt{{\left(VIcosϕ\right)}^{2} + {\left(VIsinϕ\right)}^{2}} = \sqrt{{P}^{2} + {Q}^{2}}$

Equation (8) is the standard relationship between the AP and the active and reactive powers that has been used for many years.

Using the Schwarz inequality the following relationship exists between any two signals [8]: ${\left(\left|{\int }_{a}^{b}⁢x\left(t\right)⁢y\left(t\right)⁢dt\right|\right)}^{2} \leq {\int }_{a}^{b} ⁢ {\left|x\left(t\right)\right|}^{2} ⁢ dt . {\int }_{a}^{b} ⁢ {\left|y\left(t\right)\right|}^{2} ⁢ dt$

For generalisation of the relationship the magnitude of signals have been considered to include complex signals [8]. By inspection it can be seen that the left-hand side (L.H.S) is equal to the average power and right hand side (R.H.S) is equal to the product of the squared of the rms values of voltage and current. Thus: ${\left(VIcosϕ\right)}^{2} \leq {V}^{2} ⁢ {I}^{2}$

The inequality becomes equality when the angle between voltage and current, ϕ, is zero. It will be shown in the following section that the reactive power considered as in (5) cannot be determined in frequency domain.

### 3-POWER DEFINITION IN FREQUENCY DOMAIN

In two ways the frequency domain spectrum of power relationship, Equation (4), can be obtained. The first is to identify the frequency components of voltage and current and to perform convolution in frequency domain. This is equivalent to the multiplication of voltage and current in the time domain. The second is to calculate the IP, *pₚ(t),* and to perform the Fourier transform. Both methods must give the same result.

The Fourier transform of any signal is defined as in (11). $X \left(f\right) = {\int }_{- ∞}^{∞} ⁢ x \left(t\right) ⁢ {e}^{- jωt} ⁢ dt$

By performing the Fourier transform on (1) and (2), the frequency spectrum of voltage and current are determined. $V \left(f\right) = \frac{1}{2} ⁢ \left[\hat{V}⁢{e}^{+ jα}⁢δ⁢\left(f-{f}_{1}\right)+\hat{V}⁢{e}^{- jα}⁢δ⁢\left(f+{f}_{1}\right)\right]$ $I \left(f\right) = \frac{1}{2} ⁢ \left[\hat{I}⁢{e}^{+ jβ}⁢δ⁢\left(f-{f}_{1}\right)+\hat{I}⁢{e}^{- jβ}⁢δ⁢\left(f+{f}_{1}\right)\right]$
where δ is the Dirac function.

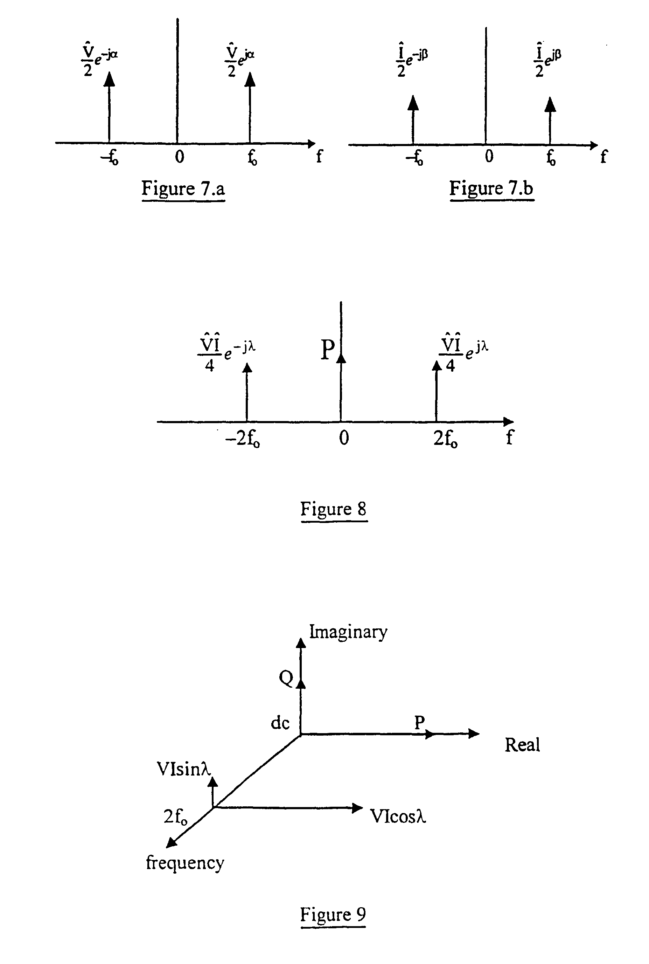

The IP, *pₚ(t),* is defined by (4) as the product of the voltage and current. The same result can also be obtained in frequency domain by performing convolution of voltage and current spectrum, since the following relationship exist. $v \left(t\right) . i \left(t\right) ↔ V \left(f\right) * I \left(f\right)$
where (·) and (*) denote multiplication and convolution respectively. The spectrum of voltage and current are shown in Fig 7.a and 7.b respectively.

Note that the component at the negative (-ve) frequency is the conjugate of that at the positive (+ve) frequency. The negative frequency does not have any physical meaning but it is the result of the mathematical analysis. It is important to note that both frequency components constitute the time domain signal in frequency domain. The spectrum of the IP can be obtained by convoluting the spectrum of voltage and current [9]. Thus: ${P}_{p} \left(f\right) = {\int }_{- ∞}^{+ ∞} ⁢ V \left(f\right) . I ⁢ \left(f-f\right) ⁢ d ⁢ f = {\int }_{- ∞}^{+ ∞} ⁢ I \left(f\right) . V ⁢ \left(f-f\right) ⁢ d ⁢ f$
where f is a dummy variable. Appendix A shows how (14) can be applied to calculate the frequency components of the IP. It can be seen that Pₚ(f) has values at -2f₁, dc, and 2f₁. The dc is given by (15). ${p}_{p} \left(0\right) = \frac{\hat{V} ⁢ \hat{I}}{4} ⁢ \left[{e}^{- jϕ}+{e}^{+ jϕ}\right] = \frac{\hat{V} ⁢ \hat{I}}{2} ⁢ cosϕ = VIcosϕ = P$

As can be seen, (15) gives the average power that could be deduced from (6). The average (active) power can also be deduced from (16.a) or (16.b). $P = V * \left({f}_{1}\right) ⁢ I \left({f}_{1}\right) + V \left({f}_{1}\right) ⁢ I * \left({f}_{1}\right)$ $P = {\sum }_{f = - ∞}^{∞} V \left(f\right) ⁢ {I}^{*} \left(f\right) = {\sum }_{- {f}_{1}}^{{f}_{1}} V \left(f\right) ⁢ {I}^{*} \left(f\right)$
where * denotes the phasor conjugate.

The spectrum of the instantaneous power is shown in Fig 8.
where from Appendix A, λ=α+β. As can be seen the frequency spectrum does not provide any information about the reactive power, Q.
If Fourier transform is applied on Equation (4), the same result as shown in Fig 8 is obtained.

### 4-DISCUSSION ON SPECTRUM ANALYSIS

The aforementioned analysis indicates that the reactive power as defined by (7.b) cannot be determined in the frequency domain. Note that the Schwarz inequality suggests that if ϕ≠0, two sides of (10) can never be equal. The analysis considered, which is the standard procedure in electrical engineering does not have the capability to calculate the reactive power.

The power in any signal *xₚ(t)* may be found in terms of either a time or frequency description based on Parseval's relation, if *xₚ(t)* is a square integrable function over one period [10]. A generalisation of this is Plancherel's relation for the product of two arbitrary periodic signals, *xₚ(t) and yₚ(t).* Plancherel's relation is defined as in (17) [8,10]. $\frac{1}{T} ⁢ {\int }_{0}^{T} ⁢ {x}_{p} \left(t\right) ⁢ {y}_{p}^{*} \left(t\right) ⁢ dt = {\sum }_{- ∞}^{∞} X \left(f\right) ⁢ {Y}^{*} \left(f\right)$

L.H.S of Equation (17) is the average power that is given by (6). R.H.S of (17) is equal to what has been calculated by the convolution theorem in frequency domain that is described by (16.b). Thus Plancherel's relation can be considered as a basis for defining the power in an ac circuit. It is clear that if the normal procedure of power calculation is used, neither in time nor frequency domain, Q as defined by (7.b) can be determined.

In normal electrical engineering practice, complex power is considered defined by (18). $\vec{S} = \vec{V} ⁢ {\vec{I}}^{*} = P + JQ = \left|S\right| ∠ ϕ$
where |S| is considered to be the AP in single and balanced 3-phase systems. (18) is a frequency domain expression. However, it has been shown that the complex power cannot be deduced from the spectrum of voltage and current. If R.H.S of (17) is modified, as shown in (19), then Q can be deduced. $2 {\sum }_{0}^{∞} X \left(f\right) ⁢ {Y}^{*} \left(f\right) = \frac{\hat{V} ⁢ \hat{I}}{2} ⁢ {e}^{jϕ} = VIcosϕ - JVIsinϕ = P + jQ$

However, for this condition the Plancherel's (Parseval's) theorem is not satisfied and hence is not acceptable. In other words the relationship (18) is not analytically valid. Thus, Q defined as the magnitude of one of the oscillatory components of the IP cannot be obtained in the frequency domain.

### 5-TRADITIONAL METHOD FOR MEASURING Q

Traditionally, Q is measured by phase shifting the voltage signal by -90° and multiplying it by the current signal. Integration of the product over one period, which is effectively the average value, is the reactive power as given by (7.b) [11]. The procedure is given below. ${p}_{p} \left(t\right) = \hat{V} ⁢ cos \left({ω}_{1}⁢t+α-\frac{π}{2}\right) . \hat{I} ⁢ cos \left({ω}_{1}⁢t+β\right)$ ${p}_{q} \left(t\right) = \frac{\hat{V} ⁢ \hat{I}}{2} ⁢ sinϕ + \frac{\hat{V} ⁢ \hat{I}}{2} ⁢ sin \left(2⁢{ω}_{1}⁢t+α+β\right)$

As can be seen, the average value *of p_{q}(t)* is the reactive power, Q.

### 6-NEW APPARENT POWER

### 6.1-Modified Voltage Signal

As was shown in Section 5, the reactive power Q is obtained by assuming that it is an imaginary dc signal. In order to generalise the method, appropriate signal must be considered in the analysis that also satisfies the signal theories.

Thus, if the voltage signal considered in the power calculation is modified as shown below then the reactive power Q can be calculated. ${v}_{mp} \left(t\right) = \hat{V} ⁢ cos \left({ω}_{1}⁢t+α\right)$ ${v}_{mp} \left(t\right) = \hat{V} ⁢ cos \left({ω}_{1}⁢t+α-\frac{π}{2}\right) = \hat{V} ⁢ sin \left({ω}_{1}⁢t+α\right)$

The voltage signal that must be considered in the analysis is given below. $\begin{matrix}{v}_{m} \left(t\right) & = {v}_{mp} \left(t\right) + j ⁢ {v}_{mq} \left(t\right) \\ & = \hat{V} ⁢ \left[cos\left({ω}_{1}⁢t+α\right)+jsin⁢\left({ω}_{1}⁢t+α\right)\right] = \hat{V} ⁢ {e}^{j ⁢ \left({ω}_{1}⁢t+α\right)}\end{matrix}$

Note that *v_{mq}(t)* does not exist in the circuit but is physically obtainable as done in Q measurement. In order to keep in line with Plancherel's theorem the IP is defined as follows: $p \left(t\right) = {v}_{m} \left(t\right) ⁢ i * \left(t\right)$ $p \left(t\right) = \hat{V} ⁢ {e}^{j ⁢ \left({ω}_{1}⁢t+α\right)} ⁢ {\left[\hat{I}⁢cos\left({ω}_{1}⁢t+β\right)\right]}^{*}$

Note that since the current is considered real, the conjugate is the same as the signal itself. Using Cauchy relationship, the IP can be written as follows: $p \left(t\right) = \frac{\hat{V} ⁢ \hat{I}}{2} ⁢ {e}^{jϕ} + \frac{\hat{V} ⁢ \hat{I}}{2} ⁢ {e}^{j ⁢ \left({ω}_{1}⁢t+λ\right)}$
where, ϕ=α-β and λ=α+β.

As can be seen, *p(t)* defined by (25) has dc components on the real and imaginary axis which are equal to P and Q respectively. Also, there exists a complex ac component. The spectrum of the IP is shown in Fig 9.

Applying the Schwarz inequality to the modified signals, the following is obtained. ${\left(\frac{\hat{V} ⁢ \hat{I}}{2}\right)}^{2} \leq {\hat{V}}^{2} ⁢ \frac{{\hat{I}}^{2}}{2}$

Note that if the voltage given in (22) is considered the rms of the signal is equal to its peak [10]. It can be seen that the relationship does not depend on the phase angle between the voltage and current. Hence considering the modified signals, the Schwarz relationship can be written as follows: ${\left(\sqrt{2}\left|{\int }_{0}^{T}⁢{v}_{m}\left(t\right)⁢i\left(t\right)⁢dt\right|\right)}^{2} = {\int }_{0}^{T} ⁢ {\left|{v}_{m}\left(t\right)\right|}^{2} ⁢ dt . {\int }_{0}^{T} ⁢ {\left|i\left(t\right)\right|}^{2} ⁢ dt$

Equation (27) can be written as shown below. ${\left(\sqrt{2}⁢\sqrt{{P}^{2} + {Q}^{2}}\right)}^{2} = {\left(\sqrt{2}⁢VI\right)}^{2} = {\left({V}_{m}⁢I\right)}^{2}$
where Vₘ denotes the rms value of the complex voltage signal. It can be seen that if the voltage signal is modified, the Schwarz relationship is always equality, provided √2 coefficient is considered. The spectrum of the complex voltage is given by (29). $V \left(f\right) = \hat{V} ⁢ {e}^{jα} ⁢ δ ⁢ \left(f-{f}_{1}\right) = {V}_{m} ⁢ {e}^{jα} ⁢ δ ⁢ \left(f-{f}_{1}\right)$

The spectrum of current is given by (12.b). Applying (17) yields the active and reactive powers both in time and frequency domain. Equation (30.a) and (30.b) give the L.H.S and R.H.S of (17) respectively. $\frac{1}{T} ⁢ {\int }_{0}^{T} ⁢ {v}_{m} \left(t\right) ⁢ i \left(t\right) ⁢ dt = \frac{\hat{V} ⁢ \hat{I}}{2} ⁢ {e}^{jϕ} = \frac{\hat{V} ⁢ \hat{I}}{2} ⁢ cosϕ + j ⁢ \frac{\hat{V} ⁢ \hat{I}}{2} ⁢ sinϕ$ ${\sum }_{f = {f}_{1}}^{{f}_{1}} {V}_{m} \left(f\right) ⁢ I * \left(f\right) = \hat{V} ⁢ {e}^{jα} ⁢ \frac{\hat{I}}{2} ⁢ {e}^{- jβ} + 0 ⋅ \frac{\hat{I}}{2} ⁢ {e}^{jβ} = \frac{\hat{V} ⁢ \hat{I}}{2} ⁢ {e}^{jϕ}$

It can be seen that Plancherel's relation is satisfied and at the same time the reactive power can be determined both in frequency and time domain. As it is evident the reactive power is obtained as an imaginary dc power in this analysis.

### 6.2-AP as the NORM of the Instantaneous Power (IP)

The Norm of any signal *x(t)* is defined by (31) [8,12]. The 2-Norm (where *d*=2) is the rms value of the signal. It is a measure of the size of the signal [10, 12]. For any signal, the square of the 2-Norm is referred to as the energy (for energy signals) or power (for power signals) of the signal. It is clear that the periodic signals are power signals [9, 10] and (|x|₂)² gives the total power in the signal [8, 10,12]. Note that although the IP is not a physical signal [6], it can be regarded as one. In fact the IP is a quantity for determining physical quantities. But it must also be emphasised that the law of the conservation of energy is satisfied by this quantity throughout a circuit. ${‖ x ‖}_{d} = {\left({\int }_{- ∞}^{∞}⁢{\left|x\left(t\right)\right|}^{d}⁢dt\right)}^{\frac{1}{d}} for 1 \leq d \leq ∞$

The 2-Norm or rms of *p(t)* is given by (32.a) or (32.b), obtained by substituting (25) into (31) for d=2. Note that since *p(t)* is periodical (power signal) the limit of integration has been modified [12]. Equation (32.b) shows that the 2-Norm is equal to the product of the rms of the current and complex voltage or √2 times the rms of current and real voltage. ${‖ p ‖}_{2} = {\left({\frac{1}{T}}_{lim T \to ∞}⁢{\int }_{0}^{T}⁢\left[{\left|\frac{\hat{V} ⁢ \hat{I}}{2}⁢{e}^{jϕ}\right|}^{2}+{\left|\frac{\hat{V} ⁢ \hat{I}}{2}⁢{e}^{j ⁢ \left(2⁢{ω}_{1}⁢t+λ\right)}\right|}^{2}\right]⁢dt\right)}^{\frac{1}{2}}$ ${‖ p ‖}_{2} = {\left[{\left(\frac{\hat{V} ⁢ \hat{I}}{2}\right)}^{2}+{\left(\frac{\hat{V} ⁢ \hat{I}}{2}\right)}^{2}\right]}^{\frac{1}{2}} = \sqrt{2} ⁢ \frac{\hat{V} ⁢ \hat{I}}{2} = \sqrt{2} ⁢ VI = \frac{\sqrt{2}}{2} ⁢ {V}_{m} ⁢ \frac{\hat{I}}{\sqrt{2}} = {V}_{m} ⁢ I$

The AP is defined as the 2-Norm of the modified IP. The modified IP is the product of current and complex voltage.

Thus, the relationship between the 2-Norm and different quantities for single-phase systems is given below. $S = {‖ p ‖}_{2}$ $S = {V}_{m} ⁢ I = \sqrt{2} ⁢ VI = \sqrt{2} ⁢ \sqrt{{P}^{2} + {Q}^{2}}$

Note that the AP defined by (33.a) has the dimension of volt-ampere. The new definition of AP presented here leads to the product of the rms of current and voltage. It has been shown that in order to satisfy the rule of electrical engineering both in time and frequency domain, the definition of reactive power as the magnitude of one of the oscillatory components of *p(t)* is not sufficient.

### 7-POWER FACTOR IN SINGLE PHASE SYSTEMS

The ratio of active power to the AP has been suggested as the definition for power factor (pf) [1, 2, 3]. With reference to the new definition for S, pf is given by (34). $pf = \frac{P}{S}$
where P= VIcosϕ $S = {V}_{m} ⁢ I$ ${V}_{m} = \hat{V} magnitude of the real voltage signal$ $I = rms of the current signal$

In single-phase systems the pf can be written as (35). $pf = \frac{P}{S} = \frac{p}{\sqrt{2} ⁢ VI} = \frac{cosϕ}{\sqrt{2}} \approx 0.707 ⁢ cosϕ$

It can be seen that pf cannot be greater that 0.707 in single-phase systems. The maximum pf occurs when the voltage and current are in phase (cosϕ=1), i.e. pure resistive load. This reduction in pf from standard unity pf for resistive load is due to the ac component of *p(t).* This component exists even if all of the reactive power (the component of *p(t)* on the imaginary axis) is compensated by reactive passive elements. The sign of Q determines the nature of the reactive power (Leading or Lagging).

### 8-IMPLEMENTATION OF THE ALGORITM

Appendix B illustrates that the rms or 2-Norm of *p(t)* can be measured using (36). It can be seen that Equation (36) is the same as (33.b). Note that the AP defined by (36) is not measured by the product of the rms of voltage and current but from the IP, *p(t).* $\begin{matrix}S = rms \left[p\left(t\right)\right] = {\left\{{\left[rms\left[{v}_{p}\left(t\right)⁢i\left(t\right)\right]\right]}^{2}+{\left[rms\left[{v}_{q}\left(t\right)⁢i\left(t\right)\right]\right]}^{2}\right\}}^{\frac{1}{2}} \\ = \sqrt{2 ⁢ {P}^{2} + 2 ⁢ {Q}^{2}} = \sqrt{2} ⁢ \sqrt{{P}^{2} + {Q}^{2}}\end{matrix}$

### 9-THREE PHASE SYSTEMS

The method proposed here for measuring S in 3-phase systems is the extension of the algorithm, which was presented for single-phase systems. It is believed that any method that is considered for calculating the AP should be based on a quantity that agrees with the law of energy conservation and does not violate any basic rule of electrical engineering. In any 3-phase system the sum of the instantaneous powers is zero. Thus; ${\sum }_{k = a , b , c} {p}_{gk} \left(t\right) + {\sum }_{k = a , b , c} {p}_{Lk} \left(t\right) + {\sum }_{k = a , b , c} Δ ⁢ {p}_{k} \left(t\right) = 0$
where:
*p_{g}(t)*= Instantaneous power at the source
*p_{L}(t)*= Instantaneous power at the load
Δ*p(t)*= Instantaneous power loss
a,b,c=phase number

It has already been suggested that pf, which is a measure of the quality of loads, is calculated using the active and AP [1, 2, 3]. The main question has been what the AP is in 3-phase systems. It is well known that in a 3-phase system with linear, unbalanced pure resistive loads there exists a difference between the active power and AP, without any oscillation of power between the load and source [2, 5]. Hence for such loads pf is not unity. The following section presents the new definition of S in 3-phase systems.

### 10-AP CALCULATED FROM 3-PHASE IP

In general (38.a) and (38.b) can define the voltages and currents of a 3-phase system at any point in the circuit. ${v}_{k} \left(t\right) = {\hat{V}}_{k} ⁢ cos \left({ω}_{1}⁢t+{α}_{k}\right) ⁢ {|}_{k = a , b , c}$ ${i}_{k} \left(t\right) = {\hat{I}}_{k} ⁢ cos \left({ω}_{1}⁢t+{β}_{k}\right) ⁢ {|}_{k = a , b , c}$
where a, b, c denote the phase numbers. As has been previously presented, the voltage signals are modified. Thus (39) gives the complex voltages. ${v}_{mk} = {\hat{V}}_{k} ⁢ {e}^{j ⁢ \left({ω}_{1}⁢t+{α}_{k}\right)} ⁢ {|}_{k = a , b , c}$

The total IP is given by (40). $p \left(t\right) = {\sum }_{k = a , b , c} {p}_{k} \left(t\right) = {\sum }_{k = a , b , c} {v}_{mk} \left(t\right) ⁢ {i}_{k} \left(t\right) = {\sum }_{k = a , b , c} \frac{{\hat{V}}_{k} ⁢ {\hat{I}}_{k}}{2} ⁢ {e}^{j ⁢ {ϕ}_{k}} + \left({\sum }_{k = a , b , c}\frac{{\hat{V}}_{k} ⁢ {\hat{I}}_{k}}{2}⁢{e}^{j ⁢ {λ}_{k}}\right) ⁢ {e}^{j ⁢ 2 ⁢ {ω}_{1} ⁢ t}$
Where: ${ϕ}_{a} = {α}_{a} - {β}_{a} , {ϕ}_{b} = {α}_{b} - {β}_{b} , {ϕ}_{c} = {α}_{c} - {β}_{c}$ ${λ}_{a} = {α}_{a} + {β}_{a} , {λ}_{b} = {α}_{b} + {β}_{b} , {λ}_{c} = {α}_{c} + {β}_{c}$

It is clear that the average value of (40) is the total active and reactive powers as indicated below. $\frac{1}{T} ⁢ {\int }_{0}^{T} ⁢ p \left(t\right) ⁢ dt = {\sum }_{k = a , b , c} {P}_{k} + j {\sum }_{k = a , b , c} ⁢ {Q}_{k}$

Note that (41) represents only the dc part of the IP. The counterpart relation of (41) is obtained in frequency domain using the convolution (or Plancherel's relation). ${\sum }_{k = a , b , c} {P}_{k} + j {\sum }_{k = a , b , c} ⁢ {Q}_{k} = {\sum }_{k = a , b , c} {\sum }_{f = - {f}_{1}}^{{f}_{1}} {V}_{mk} \left(f\right) ⁢ {I}_{k}^{*} \left(f\right)$

The AP is obtained by calculating the 2-Norm of *p(t)*. Substituting (40) into (33.a) yields: $S = {\left\{{\left|{\sum }_{k = a , b , c} \left({P}_{k}+j{Q}_{k}\right)\right|}^{2}+{\left|{\sum }_{k = a , b , c}\left(\frac{{\hat{V}}_{k} ⁢ {\hat{I}}_{k}}{2}⁢cos{λ}_{k}+j⁢\frac{{\hat{V}}_{k} ⁢ {\hat{I}}_{k}}{2}⁢sin{λ}_{k}\right)\right|}^{2}\right\}}^{\frac{1}{2}}$

Equation (43) can be written as follows: $S = \sqrt{{S}_{s}^{2} + {S}_{u}^{2}}$
where; ${S}_{s} = \sqrt{{\sum }_{k = a , b , c} {V}_{k}^{2} ⁢ {I}_{k}^{2} + {\sum }_{\begin{matrix}k ⁢ 1 = a , b , c \\ k ⁢ 2 = a , b , c \\ k ⁢ 1 \neq k ⁢ 2\end{matrix}} {V}_{k ⁢ 1} ⁢ {V}_{k ⁢ 2} ⁢ {I}_{k ⁢ 1} ⁢ {I}_{k ⁢ 2} ⁢ cos \left({ϕ}_{k ⁢ 1}-{ϕ}_{k ⁢ 2}\right)}$ ${S}_{u} = \sqrt{{\sum }_{k = a , b , c} {V}_{k}^{2} ⁢ {I}_{k}^{2} + {\sum }_{\begin{matrix}k ⁢ 1 = a , b , c \\ k ⁢ 2 = a , b , c \\ k ⁢ 1 \neq k ⁢ 2\end{matrix}} {V}_{k ⁢ 1} ⁢ {V}_{k ⁢ 2} ⁢ {I}_{k ⁢ 1} ⁢ {I}_{k ⁢ 2} ⁢ cos \left({λ}_{k ⁢ 1}-{λ}_{k ⁢ 2}\right)}$
where Vₖ and Iₖ are the rms of phase voltages and currents respectively. Sₛ and Sᵤ are called the symmetrical and unsymmetrical AP respectively, since Sᵤ will be non-zero only if the currents and/or voltages are not balanced. In a special case when the system is completely balanced, then Vₐ=V_{b}V_{c}=V, Iₐ=I_{b}=I_{c}=I, ϕₐ=ϕ_{b}=ϕ_{c}=ϕ and λₐ=λ_{b}=α+β, λ_{b}=120+λ,λ_{c}=120+λ, thus; ${S}_{s} = \sqrt{{\left({\sum }_{k = a , b , c}⁢{P}_{k}\right)}^{2} + {\left({\sum }_{k = a , b , c}⁢{Q}_{k}\right)}^{2}} = 3 ⁢ \sqrt{{P}^{2} + {Q}^{2}} = 3 ⁢ VI$ ${S}_{u} = VI ⁢ \sqrt{3 + 6 ⁢ cos \left(120\right)} = 0$

This result is also evident from (40) where its ac part becomes zero as shown below.
ac part of $p \left(t\right) = \frac{\hat{V} ⁢ \hat{I}}{2} ⁢ \left[{e}^{jλ}+{e}^{j ⁢ \left(120+λ\right)}+{e}^{j ⁢ \left(-120+λ\right)}\right] = 0$

Thus, in a balanced 3-phase system the ac part of the IP is zero and it consists of only dc components that is given by (46). This is a contrary to the single-phase systems. In this case the AP is the modulus of the complex power defined as below; $\vec{S} = 3 ⁢ {\vec{V}}_{m} \left(f\right) ⁢ \vec{I} \left(f\right) *$

The pf (P/S) can be made equal to unity for a balanced system if appropriate compensation is employed in the circuit, as this reduces the value of *p(t*) on the dc imaginary axis to zero and only dc real component is present. On the other hand, it can be said that if there is an ac component on *p(t)* then it means that there is unbalanced load present in the system. The unity pf is achievable in a 3-phase system by first compensating the reactive power which is the dc component on imaginary axis and then balancing the load, using the techniques described in [11].

Also, at the source where the voltages are balanced, the symmetrical and unsymmetrical APs for a case when the currents are not balanced are given below; $\begin{matrix}{S}_{s} = \sqrt{{\left({P}_{a}+{P}_{b}+{P}_{c}\right)}^{2} + {\left({Q}_{a}+{Q}_{b}+{Q}_{c}\right)}^{2}} \\ = E ⁢ \sqrt{{I}_{a}^{2} + {I}_{b}^{2} + {I}_{c}^{2} + 2 ⁢ {I}_{a} ⁢ {I}_{b} ⁢ cos \left({ϕ}_{a}-{ϕ}_{b}\right) + 2 ⁢ {I}_{b} ⁢ {I}_{c} ⁢ cos \left({ϕ}_{b}-{ϕ}_{c}\right) + 2 ⁢ {I}_{c} ⁢ {I}_{a} ⁢ cos \left({ϕ}_{c}-{ϕ}_{a}\right)}\end{matrix}$ ${S}_{u} = E ⁢ \sqrt{{I}_{a}^{2} + {I}_{b}^{2} + {I}_{c}^{2} + 2 ⁢ {I}_{a} ⁢ {I}_{b} ⁢ cos \left({λ}_{a}-{λ}_{b}\right) + 2 ⁢ {I}_{b} ⁢ {I}_{c} ⁢ cos \left({λ}_{b}-{λ}_{c}\right) + 2 ⁢ {I}_{c} ⁢ {I}_{a} ⁢ cos \left({λ}_{c}-{λ}_{a}\right)}$
where E is the rms of the phase voltages at the source. If the phase "a" of the generator is considered as the reference then: ${ϕ}_{a} = - {β}_{a} , {ϕ}_{b} = - 120 ⁢ ° - {β}_{b} , {ϕ}_{c} = 120 ⁢ ° - {β}_{c}$ ${λ}_{a} = {β}_{a} , {λ}_{b} = - 120 ⁢ ° + {β}_{b} , {λ}_{c} = 120 ⁢ ° + {β}_{c}$

### 11-MEASUREMENT OF 3-PHASE AP

The algorithm for 3-phase systems can be implemented using the same technique as that described in Appendix B. The rms of 3-phase *p(t)* is given below; $rms \left[p\left(t\right)\right] = {\left\{{\left[rms\left({\sum }_{k = a , b , c}{v}_{pk}\left(t\right)⁢{i}_{k}\left(t\right)\right)\right]}^{2}+{\left[rms\left({\sum }_{k = a , b , c}{v}_{qk}\left(t\right)⁢{i}_{k}\left(t\right)\right)\right]}^{2}\right\}}^{\frac{1}{2}}$

Equation (51) can be implemented on a measuring device.

### 12-CONCLUSION

It was shown that the present power theory cannot be used to determine the reactive power in time and frequency domain. The Plancherel's relation is not satisfied by the present power theory. A technique was proposed to determine the reactive power that satisfies signal theories in both time and frequency domain. The technique is based on the modification of the voltage signal by including a quadrature axis voltage. This component is obtained by delaying the voltage signal by 90°. The new AP is defined as the rms or 2-Norm of the IP that satisfies the law of conservation of energy in a circuit. It was shown that if the new AP is considered the power factor (P/S), cannot be unity in single-phase systems even if the voltage and current are in-phase. Unity power factor is only obtainable in 3-phase balanced systems. It was shown that for this condition the ac component of the IP is zero.

### 13-REFERENCES

[1]-P.S. Filipski," Polyphase Apparent Power and Power Factor Under Distorted Waveform Conditions," IEEE Trans., on Power Delivery, Vol. PWDR-6, No. 3, pp. 1161-1165, July 1991. 1.
[2]-L.S. Czarnecki," Power Related Phenomena in Three-Phase Unbalanced Systems," IEEE Trans. on Power Delivery, Vol. 10, No. 3, pp. 1168-1176, July 1995.
[3]-A. Emanuel," On The Definition of Power Factor and Apparent Power in Unbalanced Polyphase Circuits with Sinusoidal Voltage and Currents," IEEE Trans. on Power Delivery, Vol. 8, No. 3, pp. 841-852, July 1993.
[4]-IEEE Working Group Report," Practical Definitions for Powers in Systems with Non-Sinusoidal Waveforms and Unbalanced Loads: A Discussion," IEEE Trans. on Power Delivery, Vol. 11, No. 1, pp. 79-101, Jan 1996.
[5]-L.S. Czarnecki, Discussion section in reference [4], pp. 94-96.
[6]-W. Shepherd, Zand, Energy Flow and Power Factor in Non-Sinusoidal Circuits, Textbook, p. 16.
[7]-P.S. Filipski," Apparent Power - a Misleading Quantity in the Non-Sinusoidal Power Theory: Are all Non-Sinusoidal Power Theories Doomed to Fail?," ETEP, Vol. 3, No. 1, pp. 21-26, Jan/Feb 1993.
[8]-D.C. Champeney, A Handbook of Fourier Theorems, Textbook, Cambridge University Press, Chapter 3, 1987.
[9]-A.V. Oppenheim, A.S. Willsky, Signals & Systems, Textbook, Prentice Hall, Second Edition.
[10]-A. Ambardar, Analog and Digital Signal Processing, Textbook, PWS Publishing Company, 1995.
[11]-T.J.E. Miller, Reactive Power Control in Electric Systems, Textbook, John Wiley & Sons, 1982.
[12]-H. Kwakernaak, R. Sivan, Modern Signals and Systems, Textbook, Prentice Hall International Edition, 1991.

### 14-APPENDICES

### 14.1-Appendix A

Since there are only f₁ components present in the voltage and current spectrum, all components lower than -2f₁ and higher than 2f₁ on the power spectrum are zero. Applying Equation (14) on voltage and current spectrum yields: $\begin{matrix}{P}_{p} ⁢ \left(-2⁢{f}_{1}\right) = V ⁢ \left(-2⁢{f}_{1}\right) ⁢ I ⁢ \left(-2⁢{f}_{1}+2⁢{f}_{1}\right) + V ⁢ \left(-{f}_{1}\right) ⁢ I ⁢ \left(-2⁢{f}_{1}+{f}_{1}\right) + V \left(0\right) ⁢ I ⁢ \left(-2⁢{f}_{1}\right) + V \left({f}_{1}\right) ⁢ I ⁢ \left(-2⁢{f}_{1}-{f}_{1}\right) \\ {P}_{p} ⁢ \left(-2⁢{f}_{1}\right) = V ⁢ \left(-{f}_{1}\right) ⁢ I ⁢ \left(-{f}_{1}\right) = \frac{\hat{V} ⁢ \hat{I}}{4} ⁢ {e}^{- j ⁢ \left(α+β\right)} = \frac{\hat{V} ⁢ \hat{I}}{4} ⁢ {e}^{- jλ}\end{matrix}$
where: $λ = α + β$ $\begin{matrix}{P}_{p} ⁢ \left(-{f}_{1}\right) = V ⁢ \left(-2⁢{f}_{1}\right) ⁢ I ⁢ \left(-{f}_{1}+2⁢{f}_{1}\right) + V \left(-f\right) ⁢ I ⁢ \left(-{f}_{1}+{f}_{1}\right) + V \left(0\right) ⁢ I ⁢ \left(-{f}_{1}\right) + V \left({f}_{1}\right) ⁢ I ⁢ \left(-{f}_{1}-{f}_{1}\right) + V \left(2⁢{f}_{1}\right) ⁢ I ⁢ \left(-{f}_{1}-2⁢{f}_{1}\right) = 0 \\ {P}_{p} \left(0\right) = V ⁢ \left(-2⁢{f}_{1}\right) ⁢ I ⁢ \left(0+2⁢{f}_{1}\right) + V ⁢ \left(-{f}_{1}\right) ⁢ I ⁢ \left(0+{f}_{1}\right) + V \left(0\right) ⁢ I ⁢ \left(0-0\right) + V ⁢ \left(0-{f}_{1}\right) ⁢ I ⁢ \left(0-{f}_{1}\right) + V \left(2⁢{f}_{1}\right) ⁢ I ⁢ \left(0-2⁢{f}_{1}\right)\end{matrix}$ ${P}_{p} \left(0\right) = V ⁢ \left(-{f}_{1}\right) ⁢ I ⁢ \left(+{f}_{1}\right) + V \left({f}_{1}\right) ⁢ I ⁢ \left(-{f}_{1}\right) = \frac{\hat{V} ⁢ \hat{I}}{2} ⁢ cos ϕ$

By symmetry Pₚ(f₁)=0 $\begin{matrix}{P}_{p} \left(2⁢{f}_{1}\right) = V ⁢ \left(-{f}_{1}\right) ⁢ I ⁢ \left(2⁢{f}_{1}+{f}_{1}\right) + V \left(0\right) ⁢ I ⁢ \left(2⁢{f}_{1}-0\right) + V \left({f}_{1}\right) ⁢ I ⁢ \left(2⁢{f}_{1}-{f}_{1}\right) = V \left({f}_{1}\right) ⁢ I \left({f}_{1}\right) \\ {P}_{p} \left(2⁢{f}_{1}\right) = V \left({f}_{1}\right) ⁢ I \left({f}_{1}\right) = \frac{\hat{V} ⁢ \hat{I}}{4} ⁢ {e}^{jλ}\end{matrix}$

### 14.2-Appendix B

The rms of *p(t)* is given by B1. $rms \left[p\left(t\right)\right] = rms \left\{\hat{V}⁢{e}^{j ⁢ \left({ω}_{1}⁢t+α\right)}⁢\hat{I}⁢cos\left({ω}_{1}⁢t+β\right)\right\}$

By expanding the voltage signal, (B1) can be rearranged as follow : $rms \left[p\left(t\right)\right] = {\left\{{\left[rms\left[{v}_{p}\left(t\right)⁢i\left(t\right)\right]\right]}^{2}+{\left[rms\left[{v}_{q}\left(t\right)⁢i\left(t\right)\right]\right]}^{2}\right\}}^{\frac{1}{2}}$
where: $\begin{matrix}rms \left[{v}_{p}\left(t\right)⁢i\left(t\right)\right] & = rms ⁢ \left[VIcos⁢\left({ω}_{1}⁢t+α\right)⁢cos\left({ω}_{1}⁢t+β\right)\right] \\ & = \sqrt{{P}^{2} + \frac{1}{2} ⁢ {P}^{2} + \frac{1}{2} ⁢ {Q}^{2}}\end{matrix}$ $\begin{matrix}rms ⌊ {v}_{p} \left(t\right) ⁢ i \left(t\right) ⌋ & = rms ⁢ \left[VIsin⁢\left({ω}_{1}⁢t+α\right)⁢cos\left({ω}_{1}⁢t+β\right)\right] \\ & = \sqrt{{Q}^{2} + \frac{1}{2} ⁢ {Q}^{2} + \frac{1}{2} ⁢ {P}^{2}}\end{matrix}$

Thus; $rms \left[p\left(t\right)\right] = \sqrt{2 ⁢ {P}^{2} + 2 ⁢ {Q}^{2}} = \sqrt{2} ⁢ \sqrt{{P}^{2} + {Q}^{2}}$

**ABSTRACT** The new apparent power defined as the 2-Norm of the instantaneous power is investigated using the symmetrical components. It will be shown that the instantaneous power consists of different terms that are the result of the product of different sequence components. The effects of each component on the apparent power and the power factor are investigated. It will be shown that the unbalanced loads convert some of their positive phase sequence active and reactive powers into other component powers and feed them back to the circuit. The same result is also obtained for the power components that are the result of, the product of unlike components.

**KEYWORD Apparent Power, Power Factor, Instantaneous Power, Symmetrical Components**

### 1-INTRODUCTION

Three phase systems can be analysed by the virtue of the symmetrical components. If the transmission system can be considered symmetrical, i.e. equal line impedances, the voltages and currents can be resolved into symmetrical components.

In part one of this report a new definition for the apparent power (AP) based on the modified instantaneous power (IP) was proposed. The AP was defined as the rms of the modified IP. The analysis was based on the phase coordinate of 3-phase systems. In order to investigate the generalisation of the approach, outlined in part one of this report, the analysis is carried out here for 3-phase systems using the symmetrical components. This enables one to observe the influence of different components, namely positive, negative and zero phase sequence of voltages and currents on power components and power factor (pf).

Reference [1] used symmetrical components to obtain an expression for the AP in terms of rms values of voltages and currents. Power factor (pf) was then defined as the ratio of positive phase sequence (pps) power and the defined AP [1]. In the following sections, pf in terms of the symmetrical components will be investigated and a new pf will be introduced.

### 2-SYMMETRICAL COMPONENTS REPRESENTATION OF THE NEW AP

Consider a 3-phase ideal source feeding a 3-phase load via a transmission system with impedance Zₛ. The source and load terminals will be considered separately.

### 2.1-The AP and pf at the Source

The voltages at the source can be defined as follows; ${e}_{k}^{+} = \hat{E} ⁢ cos \left({ω}_{1}⁢t+{α}_{k}^{+}\right) ⁢ {|}_{k = a , b , c}$
where a, b, c denote the phase numbers. The magnitudes are phase quantities. Also; ${{α}^{+}}_{a} = 0 , {{α}^{+}}_{b} = - 120 , {{α}^{+}}_{c} = 120.$

Since 3-phase sources can only generate pps voltages the negative phase sequence (nps) and zero phase sequence (zps) voltages are all zero.

For each phase a voltage signal delayed by -90° is formed and then as discussed in [2] the voltages are modified as shown below. ${e}_{qk}^{+} = \hat{E} ⁢ cos \left({ω}_{1}⁢t+{α}_{k}^{+}-90⁢°\right) ⁢ {|}_{k = a , b , c}$ ${e}_{mk}^{+} = \hat{E} ⁢ {e}^{j ⁢ \left({ω}_{1}⁢t+{α}_{k}^{+}\right)} ⁢ {|}_{k = a , b , c}$

Equ. (4) defines the complex voltage signals that are used in the analysis. The phase angles are as given by (2) [2].

The phase voltages and currents can be resolved into symmetrical components at any point in the circuit [1]. Hence

if the currents at the source are defined as (5) then using Cauchy relations, their symmetrical components representation will be as shown in (6). ${i}_{k} \left(t\right) = {\hat{I}}_{k} cos \left({ω}_{1}⁢t+{β}_{k}\right) ⁢ {|}_{k = a , b , c}$ ${i}_{k}^{r} \left(t\right) = \frac{{\hat{I}}^{r}}{2} ⁢ \left[{e}^{j ⁢ \left({ω}_{1}⁢t+{β}_{k}^{r}\right)}+{e}^{- j ⁢ \left({ω}_{1}⁢t+{β}_{k}^{r}\right)}\right] ⁢ {|}^{r = + , - , o} ⁢ {|}_{k = a , b , c}$
where: $\begin{matrix}{β}_{a}^{+} = {β}^{+} , {β}_{b}^{+} = {β}^{+} - 120 ⁢ ° , {β}_{c}^{+} = {β}^{+} + 120 ⁢ ° \\ {β}_{a}^{-} = {β}^{-} , {β}_{b}^{-} = {β}^{-} + 120 ⁢ ° , {β}_{c}^{-} = {β}^{-} - 120 ⁢ ° \\ {β}_{a}^{o} = {β}^{o} , {β}_{b}^{o} = {β}^{o} , {β}_{b}^{o} = {β}^{o}\end{matrix}$
I⁺, I⁻, I° denote the magnitude of pps, nps and zps currents respectively. Also β⁺, β⁻ and β° are phase angle of pps, nps and zps currents with respect to (w.r.t) the phase "a" voltage of the source.

The per phase and total instantaneous powers (IP) at the source are defined by (8.a) and (8.b) respectively. ${p}_{k} \left(t\right) = {e}_{mk} \left(t\right) ⁢ {i}_{k}^{*} \left(t\right) ⁢ {|}_{k = a , b , c} = {e}_{mk}^{+} \left(t\right) ⁢ {\left({i}_{k}^{+}\left(t\right)+{i}_{k}^{-}\left(t\right)+{i}_{k}^{o}\left(t\right)\right)}^{*} ⁢ {|}_{k = a , b , c}$ $\begin{matrix}p \left(t\right) & = {\sum }_{k = a , b , c} {p}_{k} \left(t\right) \\ & = {\sum }_{k = a , b , c} ⁢ {e}_{mk}^{+} \left(t\right) ⁢ {i}_{k}^{{+}^{*}} + {\sum }_{k = a , b , c} ⁢ {e}_{mk}^{+} \left(t\right) ⁢ {i}_{k}^{{-}^{*}} + {\sum }_{k = a , b , c} ⁢ {e}_{mk}^{+} \left(t\right) ⁢ {i}_{k}^{{o}^{*}}\end{matrix}$

The sum of the product of the pps voltages and zps currents are zero since the pps voltages are balanced and zps currents are all in-phase as shown below. ${p}^{{o}^{+}} \left(t\right) = {\sum }_{k = a , b , c} {e}_{mk}^{+} \left(t\right) ⁢ {i}_{k}^{{o}^{*}} \left(t\right) = \frac{\hat{E} ⁢ {\hat{I}}^{o}}{2} ⁢ \left[{e}^{- j ⁢ \left({ω}_{1}\left(t\right)+{β}^{o}\right)}+{e}^{j ⁢ \left({ω}_{1}\left(t\right)+{β}^{o}\right)}\right] ⁢ \left[{e}^{j \left({ω}_{1}⁢t\right)}+{e}^{j ⁢ \left({ω}_{1}\left(t\right)-120\right)}+{e}^{j ⁢ \left({ω}_{1}\left(t\right)+120\right)}\right] = 0$

This is physically acceptable since, theoretically, due to the physical placement of 3-phase windings in generators the zps current cannot produce any armature reaction in three phase machines.

Other components of the IP are found by considering the appropriate current components in (6). Thus; ${p}^{+} \left(t\right) = {\sum }_{k = a , b , c} {e}_{mk}^{+} \left(t\right) ⁢ {i}_{k}^{+} \left(t\right) = 3 ⁢ {EI}^{+} ⁢ {e}^{j ⁢ {ϕ}^{+}}$ ${p}^{\pm } \left(t\right) = {\sum }_{k = a , b , c} {e}_{mk}^{+} \left(t\right) ⁢ {i}_{k}^{-} \left(t\right) = 3 ⁢ {EI}^{-} ⁢ {e}^{j ⁢ \left(2⁢{ω}_{1}⁢t+{λ}^{\pm }\right)}$
where, ϕ⁺=β⁺, λ^{±}=β⁻ and E, I⁺ and I⁻ are the rms of the terminal voltage, pps and nps currents respectively. Note that (10.a) is a dc whereas (10.b) is an ac signal. Note also that since the currents are real signals their conjugates are the same as the signal itself.

The total IP is given below; $p \left(t\right) = 3 ⁢ {EI}^{+} ⁢ {e}^{j ⁢ {ϕ}^{+}} + 3 ⁢ {EI}^{-} ⁢ {e}^{j ⁢ {λ}^{\pm }} ⁢ {e}^{j \left(2⁢{ω}_{1}⁢t\right)}$

It can be seen that the average value of (11) is the same as (41) in [2], and is the total active and reactive powers that are supplied by the source to the circuit. Also note that the 3-phase generator can only produce active and reactive powers in a pps circuit. It is clear that if the system is balanced the nps current is zero and hence the IP consists of a dc term as explained in [2].

The apparent power (AP) was defined in [2] as the 2-Norm of the IP. Thus; $S = {‖ p ‖}_{2} = {\left({\frac{1}{T}}_{lim T \to ∞}⁢{\int }_{0}^{T}⁢{\left|p\left(t\right)\right|}^{2}⁢dt\right)}^{0.5}$

Substituting (11) into (12) yields: $S = {\left\{{\left(3⁢{EI}^{+}\right)}^{2}+{\left(3⁢{EI}^{-}\right)}^{2}\right\}}^{\frac{1}{2}} = 3 ⁢ E ⁢ \sqrt{{I}^{{+}^{2}} + {I}^{{-}^{2}}}$

The balanced and unbalanced AP in terms of symmetrical components are defined below as: ${S}_{s} = 3 ⁢ {EI}^{+}$ ${S}_{u} = 3 ⁢ {EI}^{-}$

Equation (14.a) and (14.b) are equal to (50.a) and (50.b) in [2] respectively where Sₛ and Sᵤ were defined in terms of the phase co-ordinates.

The power factor (pf) of the source is defined as the ratio of the active power to the AP. Thus; $pf = \frac{P}{S} = \frac{{P}^{+}}{S} = \frac{{I}^{+} ⁢ cos {ϕ}^{+}}{\sqrt{{I}^{{+}^{2}} + {I}^{{-}^{2}}}}$

Note that since the machine can only produce pps active power, the pf is obtained in terms of P⁺ only. Also note that since the pps circuit is balanced then voltages sum to zero at any instant and thus the product of the rms of the pps voltage to the pps and zps currents is independent of the reference.

### 2.2-The AP and of at the Load

### 2.2.1-IP Components at the Load

(6) gives the currents in the circuit. Depending on the grounding of the system, the zps current may or may not be present in each of the lines. In general, the pps, nps and zps voltage drops on the line impedances are given below: $Δ ⁢ {v}^{r} \left(t\right) = \left({R}_{s}^{r}+{L}_{s}^{r}⁢\frac{d}{dt}\right) ⁢ {i}^{r} \left(t\right) ⁢ {|}^{r = + , - , o}$
where Rₛ and Lₛ are the line sequence resistance and inductance respectively. The symmetrical component voltages at the load are thus given by (17). $\begin{matrix}{v}^{+} \left(t\right) = {e}^{+} \left(t\right) - Δ ⁢ {v}^{+} \left(t\right) \\ {v}^{-} \left(t\right) = - Δ ⁢ {v}^{-} \left(t\right) \\ {v}^{o} \left(t\right) = - Δ ⁢ {v}^{o} \left(t\right)\end{matrix} }$

Appendix A shows that in general the sequence voltages at the load terminal can be written as follows; $\begin{matrix}{v}^{+} \left(t\right) = {\hat{V}}^{+} ⁢ cos \left({ω}_{1}⁢t+{α}^{+}\right) \\ {v}^{-} \left(t\right) = {\hat{V}}^{-} ⁢ cos \left({ω}_{1}⁢t+{α}^{-}\right) \\ {v}^{o} \left(t\right) = {\hat{V}}^{o} ⁢ cos \left({ω}_{1}⁢t+{α}^{o}\right)\end{matrix} }$

The magnitudes and phase angles are given in Appendix A. Considering the above equations, the modified phase voltages at the load in terms of the symmetrical components are determined by phase shifting the sequence voltages by -90°. Thus; ${v}_{mk} \left(t\right) = {v}_{mk}^{+} \left(t\right) + {v}_{mk}^{-} \left(t\right) + {v}_{mk}^{o} \left(t\right) ⁢ {|}_{k = a , b , c} = {\hat{V}}^{+} ⁢ {e}^{j ⁢ \left({ω}_{1}⁢t+{α}_{k}^{+}\right)} - {\hat{V}}^{-} ⁢ {e}^{j ⁢ \left({ω}_{1}⁢t+{α}_{k}^{-}\right)} - {\hat{V}}^{o} ⁢ {e}^{j ⁢ \left({ω}_{1}⁢t+{α}_{k}^{o}\right)} ⁢ {|}_{k = a , b , c}$
Where; $\begin{matrix}{α}_{a}^{+} = {α}^{+} , {α}_{b}^{+} = {α}^{+} - 120 ⁢ ° , {α}_{c}^{+} = {α}^{+} + 120 ⁢ ° \\ {α}_{a}^{-} = {α}_{Δ}^{-} , {α}_{b}^{-} = {α}_{Δ}^{-} + 120 ⁢ ° , {α}_{c}^{-} = {α}_{Δ}^{-} - 120 ⁢ ° \\ {α}_{a}^{o} = {α}_{Δ}^{o} , {α}_{b}^{o} = {α}_{Δ}^{o} , {α}_{c}^{o} = {α}_{Δ}^{o}\end{matrix} }$

The total IP is given by (21). $p \left(t\right) = {\sum }_{k = a , b , c} {v}_{mk} \left(t\right) ⁢ {i}_{k}^{*} \left(t\right)$

Equation (21) can be written in terms of the symmetrical components as follows; $p \left(t\right) = \left[1 1 1\right] ⁢ \left[\begin{matrix}{v}_{ma}^{+} & {v}_{mb}^{+} & {v}_{mc}^{+} \\ {v}_{ma}^{-} & {v}_{mb}^{-} & {v}_{mc}^{-} \\ {v}_{ma}^{o} & {v}_{mb}^{o} & {v}_{mc}^{o}\end{matrix}\right] ⁢ {\left[\begin{matrix}{i}_{a}^{+} & {i}_{a}^{+} & {i}_{a}^{o} \\ {i}_{b}^{+} & {i}_{b}^{-} & {i}_{b}^{o} \\ {i}_{c}^{+} & {i}_{c}^{-} & {i}_{c}^{o}\end{matrix}\right]}^{*} \left[\begin{matrix}1 \\ 1 \\ 1\end{matrix}\right]$ $p \left(t\right) = \left[1 1 1\right] ⁢ \left[\begin{matrix}{p}^{+} & {p}^{\pm } & {p}^{{+}_{o}} \\ {i}_{b}^{\overline{+}} & {p}^{-} & {p}^{\overline{o}} \\ {p}^{{o}_{+}} & {p}^{{o}_{̲}} & {p}^{o}\end{matrix}\right] ⁢ \left[\begin{matrix}1 \\ 1 \\ 1\end{matrix}\right]$

Note that for simplicity, (*t*) has been eliminated from the equations, but it should be emphasised that all matrix elements are functions of time. The matrix elements are given below; ${p}^{+} = {\sum }_{k = a , b , c} {v}_{mk}^{+} ⁢ {i}_{k}^{+ *} = 3 ⁢ {V}^{+} ⁢ {I}^{+} ⁢ {e}^{j ⁢ {ϕ}^{+}}$ ${p}^{-} = {\sum }_{k = a , b , c} {v}_{mk}^{-} ⁢ {i}_{k}^{- *} = - 3 ⁢ {V}^{-} ⁢ {I}^{-} ⁢ {e}^{j ⁢ {ϕ}^{-}}$ ${p}^{o} = {\sum }_{k = a , b , c} {v}_{mk}^{o} ⁢ {i}_{k}^{o *} = - 3 ⁢ {V}^{o} ⁢ {I}^{o} ⁢ {e}^{j ⁢ {ϕ}^{o}} - 3 ⁢ {V}^{o} ⁢ {I}^{o} ⁢ {e}^{j ⁢ \left(2⁢{ω}_{1}⁢t+{λ}^{o}\right)}$ ${p}^{\pm } = {\sum }_{k = a , b , c} {v}_{mk}^{+} ⁢ {i}_{k}^{- *} = 3 ⁢ {V}^{+} ⁢ {I}^{-} ⁢ {e}^{j ⁢ \left(2⁢{ω}_{1}⁢t+{λ}^{\pm }\right)}$ ${p}^{{o}^{+}} = {\sum }_{k = a , b , c} {v}_{mk}^{+} ⁢ {i}_{k}^{o *} = 0$ ${p}^{\overline{+}} = {\sum }_{k = a , b , c} {v}_{mk}^{-} ⁢ {i}_{k}^{+ *} = - 3 ⁢ {V}^{-} ⁢ {I}^{+} ⁢ {e}^{j ⁢ \left(2⁢{ω}_{1}⁢t+{λ}^{\overline{+}}\right)}$ ${p}^{\overline{o}} = {\sum }_{k = a , b , c} {v}_{mk}^{-} ⁢ {i}_{k}^{o *} = 0$ ${p}^{{o}_{+}} = {\sum }_{k = a , b , c} {v}_{mk}^{o} ⁢ {i}_{k}^{+ *} = 0$ ${p}^{{o}_{-}} = {\sum }_{k = a , b , c} {v}_{mk}^{o} ⁢ {i}_{k}^{- *} = 0$
where V⁺, V⁻ and V° are the rms of pps, nps and zps voltages and I° is the rms of zps current, and for the above;${ϕ}^{+} = {α}^{+} - {β}^{+} , {ϕ}^{-} = {{α}_{Δ}}^{-} - {β}^{-} , {ϕ}^{°} = {{α}_{Δ}}^{°} - {β}^{°}$ ${λ}^{°} = {{α}_{Δ}}^{°} + {β}^{°} , {λ}^{\pm } = {α}^{+} + {β}^{-} , {λ}^{\overline{+}} = {α}_{Δ}^{-} - {β}^{+}$

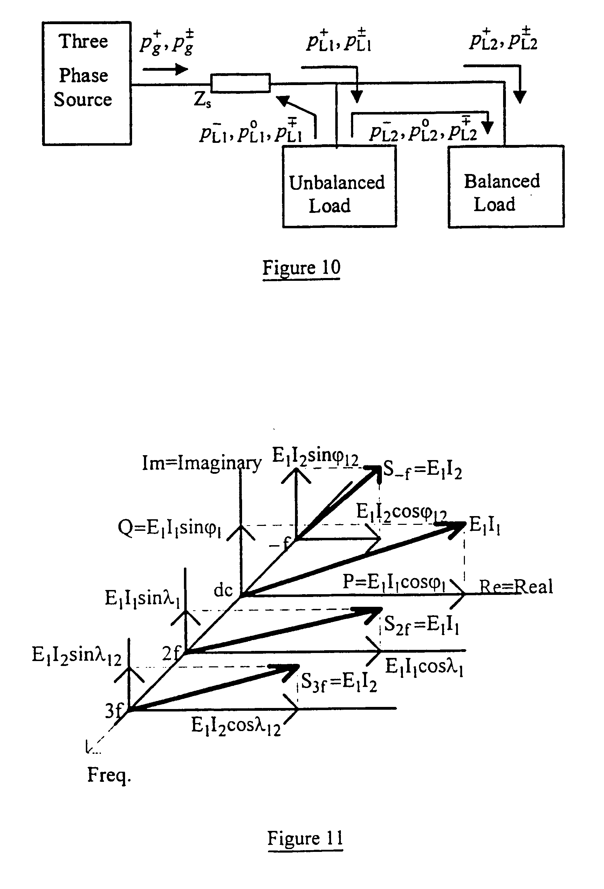

The following remarks can be made;
1-The products of zps (in-phase) voltages and currents to pps and nps (balanced) currents and voltages are zero.
2-It can been seen that the product of the same component voltages and currents contains dc terms which implies that there are active and reactive powers associated with these components.
3-In general, a sign cannot be defined for ac currents on their own, but when the flow of power, e.g. with respect to a voltage is considered the direction finds a meaning. As can be seen the sign of *p⁺* and *p^{±}* are positive. These terms are the product of the pps voltage to the pps and nps currents respectively. The same result was obtained in Section 2.1 when the source was considered.
4-The sign of *p⁻*, *p°*, and *p^{∓}* are negative compared to *p⁺* and *p^{±}*. This means that these terms are flowing in opposite direction to *p⁺* and *p^{±}* w.r.t the unbalanced load. In fact, these IPs are exactly equal to the system impedance demand of the instantaneous components of *p⁻*, *p°*, and *p^{∓}*. The same result for *p⁻*, *p°* had been obtained in [1] however, it is shown here that the same argument is also applied to the IPs that are the result of the product of unlike sequence quantities, namely nps voltage and pps currents. The physical explanation for this phenomenon is that since, as a result of unbalance loading, nps and zps currents flow in the circuit then there would be demand for *p⁻*, *p°*, and *p^{∓}* from the system impedance. The source cannot produce these power components, therefore the unbalanced load converts some of its *p⁺* and *p^{±}* into other dc and ac components of the IP respectively. Note that the sums of each of these components as well as the total IP in the circuit are zero and thus they satisfy the rule of conservation of energy.
5-If there is a balanced load in parallel with the unbalanced load, then it can be easily proved that due to the system impedance some unbalanced current will flow into the balanced load [1]. Thus; this causes the power components *p⁻, p°,* and *p^{∓}* to appear in the IP of the balanced load. The unbalanced load will also supply these.
   With reference to the above observations, the flow of power components can be shown as in Fig 10.

Subscript L1 and L2 represent unbalanced and balanced loads respectively. Note that *p⁺* and *p^{±}* demand by the system impedance is met by the source. Hence, the balanced load also consumes (dissipate) some active power (real energy) in its nps and zps circuits. Although in some loads not all, like heating loads, these powers may be converted into useful energy but in general, due to the other detrimental effects of nps and zps currents on the system they are regarded as undesirable powers.

### 2.2.2-Total AP and pf at the Load

In general, considering balanced and unbalanced loads the total IP of the load can be written as follows: $p = {p}^{+} + {p}^{-} + {p}^{o} + {p}^{\pm } + {p}^{\pm }$

Substituting appropriate signals into (33) yields; $p = 3 ⁢ \left({V}^{+}⁢{I}^{+}⁢{e}^{j ⁢ {ϕ}^{+}}+{V}^{-}⁢{I}^{-}⁢{e}^{j ⁢ {ϕ}^{-}}+{V}^{o}⁢{I}^{o}⁢{e}^{j ⁢ {ϕ}^{o}}\right) + 3 ⁢ \left[{V}^{+}⁢{I}^{-}⁢{e}^{j ⁢ {ϕ}^{\pm }}+{V}^{-}⁢{I}^{+}⁢{e}^{j ⁢ {ϕ}^{\overline{+}}}+{V}^{o}⁢{I}^{o}⁢{e}^{j ⁢ {ϕ}^{o}}\right] ⁢ {e}^{j ⁢ 2 ⁢ {ω}_{1} ⁢ t}$

Note that, as previously mentioned, some of the terms in (34) would be negative for unbalanced loads. As can be seen the IP consists of a complex dc and a complex ac term. The frequency of the ac component is double the system frequency as expected. The dc term representing P and Q are the result of the product of the same symmetrical components.

The apparent power is defined as 2-Norm of the IP. Substituting (34) into (12) yields; $S = {\left[{\left|3⁢{V}^{+}⁢{I}^{+}⁢{e}^{j ⁢ {ϕ}^{+}}+3⁢{V}^{-}⁢{I}^{-}⁢{e}^{j ⁢ {ϕ}^{-}}+3⁢{V}^{o}⁢{I}^{o}⁢{e}^{j ⁢ {ϕ}^{o}}\right|}^{2}+{\left|3⁢{V}^{+}⁢{I}^{-}⁢{e}^{j ⁢ {λ}^{\pm }}+3⁢{V}^{-}⁢{I}^{+}⁢{e}^{j ⁢ {λ}^{\overline{+}}}+3⁢{V}^{o}⁢{I}^{o}⁢{e}^{j ⁢ {λ}^{o}}\right|}^{2}\right]}^{\frac{1}{2}}$
or $S = {\left\{{P}_{t}^{2}+{Q}_{t}^{2}+9⁢\left[{\left({V}^{+}⁢{I}^{-}⁢cos{λ}^{\pm }+{V}^{-}⁢{I}^{+}⁢cos{λ}^{\overline{+}}+{V}^{o}⁢{I}^{o}⁢cos{λ}^{o}\right)}^{2}+{\left({V}^{+}⁢{I}^{-}⁢sin{λ}^{\pm }+{V}^{-}⁢{I}^{+}⁢sin{λ}^{\overline{+}}+{V}^{o}⁢{I}^{o}⁢sin{λ}^{o}\right)}^{2}\right]\right\}}^{\frac{1}{2}}$
where:

| | |
|---|---|
| Pₜ= P⁺+P⁻+P^{°}, | Qₜ= Q⁺+Q⁻+Q^{°}, |
| P⁺=3V⁺I⁺cosϕ⁺, | Q⁺=3V⁺I⁺sinϕ⁺ |
| P⁻=3V⁻I⁻cosϕ⁻, | Q⁻=3V⁻I⁻sinϕ⁻ |
| P^{°}=3V^{°}I^{°}cosϕ^{°}, | Q^{°}=3V^{°}I^{°}sinϕ^{°} |

The AP defined by (36) can be written in terms of Sₛ and Sᵤ as given below; $S = \sqrt{{S}_{s}^{2} + {S}_{u}^{2}}$
where ${S}_{s} = 3 ⁢ \sqrt{{\sum }_{r = + , - , o} {\left({V}^{r}⁢{I}^{r}\right)}^{2} + {\sum }_{\begin{matrix}r ⁢ 1 = + , - , o \\ r ⁢ 2 = + , - , o \\ r ⁢ 1 \neq r ⁢ 2\end{matrix}} {V}^{r ⁢ 1} ⁢ {V}^{r ⁢ 2} ⁢ {I}^{r ⁢ 1} ⁢ {I}^{r ⁢ 2} ⁢ cos \left({ϕ}^{r ⁢ 1}-{ϕ}^{r ⁢ 2}\right)}$ ${S}_{u} = 3 ⁢ \sqrt{{\left({V}^{+}⁢{I}^{-}\right)}^{2} + {\left({V}^{-}⁢{I}^{+}\right)}^{2} + {\left({V}^{o}⁢{I}^{o}\right)}^{2} + 2 ⁢ {V}^{+} ⁢ {V}^{-} ⁢ {I}^{+} ⁢ {I}^{-} ⁢ cos \left({λ}^{\pm }-{λ}^{\pm }\right) + 2 ⁢ {V}^{+} ⁢ {V}^{o} ⁢ {I}^{-} ⁢ {I}^{o} ⁢ cos \left({λ}^{\pm }-{λ}^{o}\right) + 2 ⁢ {V}^{-} ⁢ {V}^{o} ⁢ {I}^{+} ⁢ {I}^{o} ⁢ cos \left({λ}^{o}-{λ}^{\overline{+}}\right)}$

Equation (38.a) and (38.b), which are in terms of the symmetrical components, are equal to (45.a) and (45.b) in [2] respectively.

The pf defined by P/S can be deduced from (39). $pf = \frac{{P}_{f}}{S} = \frac{{P}^{+} + {P}^{-} + {P}^{o}}{{\left\{{S}_{s}^{2}+{S}_{u}^{2}\right\}}^{0.5}}$

Power factor specified by (39) is exactly the same as that calculated from the phase co-ordinates, obtained in [2]. As was previously mentioned, the unbalanced load converts some of its *p⁺* and *p^{±}* into other IP components. This implies that P⁻, P°, Q⁻, Q° from dc terms and also V⁻I⁺exp(j λ^{∓}), V°I°exp(jλ°) of the ac components in (35) or (36) would have opposite sign to P⁺, Q⁺ and V⁺I⁻exp(jλ^{±}). This means that former quantities are actually flowing from the load towards the system and other balanced loads. The active power that is actually consumed by the unbalanced load, Pₜ , is smaller than that taken from the system. Although the difference is injected back to the system to be used by the system impedance and other balanced loads, the unbalanced load itself is the cause of the discrepancies between power components. The same argument is equally applicable to the calculated AP specified by (37). Considering pf shown by (39), it can be seen that smaller S implies larger pf, however, Pₜ also would be smaller.

Then some of increase in the pf due to decrease in S may be compensated by the lower value of, Pₜ. On the other hand, consumers pay their energy bill on active power as well as pf. Therefore, if Pₜ is considered for energy bills then the unbalanced loads do not pay for the system pollution that they are causing. It must also be said that this phenomenon is a mutual effect between loads and systems since the amount of power that is injected back to the system by the unbalanced load depends on the system impedance as well as the amount of unbalanced current. Thus, from the consumer viewpoint, one may argue that the consumers should not alone be penalised for the pollution. Of course any supply system has some impedance which should comply with the standards. It is believed that if the supply system condition complies with the design standards then the consumers should pay for the extra losses of the system.

### 3-MODIFIED APPARENT POWER AND POWER FACTOR

With reference to the above discussion it is desirable to use P⁺=3V⁺I⁺cosϕ⁺, for energy billing purposes. In this case the unbalanced load would pay for the pollution it is causing. On the other hand, balanced loads that are in parallel with unbalanced loads do not pay for the powers in the form of nps and zps active powers that they may be using. However, as was mentioned before, these powers are regarded as undesirable powers. It can be said that the balanced loads are forced to use these undesirable powers. Therefore, since the supply authorities receive the cost of energy from the source of pollution, there is no point of charging the balanced loads again. If P⁺ is used for energy metering then it is technically reasonable to suggest that the AP that is calculated from the pps voltage be considered for measuring the pf. This is different to what has been suggested in [1] as the AP used in pf calculation would be different. For unbalanced loads, P⁺ tends to increase the pf but the AP calculated using only the pps voltages may be higher than the case when total AP is considered. Hence, higher S may compensate the increase in pf due to higher P⁺. The value of Sᵤ depends on the magnitude and phase angles of the sequence voltages and currents.

Thus, the IP is calculated from (40.a); $p = {v}_{ma}^{+} ⁢ {i}_{a}^{*} + {v}_{mb}^{+} ⁢ {i}_{b}^{*} + {v}_{mc}^{+} ⁢ {i}_{c}^{*}$ $p = 3 ⁢ {V}^{+} ⁢ {I}^{+} ⁢ {e}^{j ⁢ {ϕ}^{+}} + 3 ⁢ {V}^{+} ⁢ {I}^{-} ⁢ {e}^{j ⁢ {λ}^{\pm }} ⁢ {e}^{j ⁢ 2 ⁢ {ω}_{1} ⁢ t}$
where *i*ₐ, *i*_{b} and *i*_{c} are the phase currents and *v⁺*ₘₐ, *v⁺*_{md} and *v⁺*_{mc} are the complex pps voltages. Note that (t) has been ignored for simplicity.

The AP is the 2-Norm of Equation (40.b). Thus; $S = \sqrt{{\left|3⁢{V}^{+}⁢{I}^{+}⁢{e}^{j ⁢ {ϕ}^{+}}\right|}^{2} + {\left|3⁢{V}^{+}⁢{I}^{-}⁢{e}^{j ⁢ {λ}^{\pm }}\right|}^{2}}$

Equation (41) can be written as below; $S = 3 ⁢ \sqrt{\left({P}^{{+}^{2}}+{Q}^{{+}^{2}}\right) + {\left({V}^{+}⁢{I}^{-}\right)}^{2}} = 3 ⁢ {V}^{+} ⁢ \sqrt{{I}^{{+}^{2}} + {I}^{{-}^{2}}}$

Note that (42) has the same format as the AP at the source given by (13). The pf is thus given by (43). $pf = \frac{{P}^{+}}{S} = \frac{3 ⁢ {V}^{+} ⁢ {I}^{+} ⁢ cos {ϕ}^{+}}{3 ⁢ {V}^{+} ⁢ \sqrt{{I}^{{+}^{2}} + {I}^{{-}^{2}}}} = \frac{{I}^{+} ⁢ cos {ϕ}^{+}}{\sqrt{{I}^{{+}^{2}} + {I}^{{-}^{2}}}}$

As an example consider a 1-phase circuit with a source voltage of 100 V rms and a load of 8 ζ that is supplied via a system impedance of 2+j4 Ω. The active power and AP of the load are 689.7 W and √2 689.7 VA respectively that give a pf of ≈0.707.

Power factor is used to define the electrical quality of loads and determines the utilisation of a supplying system. When the above load is connected to a 3-phase system with an exactly similar transmission characteristic neither load's quality nor utilisation of the system changes. Thus, the load pf must be the same. Consider that the above 1-phase load is connected to the phase "a" of a 3-phase system with the line impedance of 2+j4 Ω/phase and zero neutral impedance, i.e. ideal earthing (for simplicity). Using (37) the load AP is √2 689.7 VA and the active power is 689.7 W that gives a pf of 0.707. It can be seen that the load pf has not changed. This is logical as neither the system losses nor load power consumption has changed. However, to reflect the effect of the unbalanced load on the system, (42) and (43) must be used that give S=1183.4 VA and pf=0.68, a lower pf. Note that 229.9 VAr pps reactive power is measured at the load terminal that is equal to the sum of nps and zps reactive demand of the system impedance as the load itself does not demand any reactive power.

### 4-IMPLEMENTATION OF THE ALGORITHM

The AP can be calculated/measured either in time domain using (40.a) or from the product of the rms of pps voltage and pps and nps currents defined by (42). Note that since pps voltage is used in S calculation then the reference voltage is eliminated from the equation. Thus the AP given by (42) is independent of reference voltage. Both methods are described here.

### 4.1-Time Domain Technique

The average value of (40.b) is the pps active and reactive powers. In order to obtain (40.b), the pps voltages for three phases must be extracted from the phase signals. There are different methods that can be implemented to achieve this [3]. The description of these methods is out of the scope of the present work. Assuming that *v⁺*ₐ, *v*⁺_{b} and *v*⁺_{c} are obtained, then the quadrature voltages that are formed by phase shifting the pps voltages are obtained for each phase. Multiplication of the real and imaginary voltages with appropriate phase currents provides Equation (40.b).

Thus; ${v}_{pk}^{+} = {V}^{+} ⁢ cos \left({ω}_{1}⁢t+{α}_{k}^{+}\right) ⁢ {|}_{k = a , b , c}$ ${v}_{qk}^{+} = {V}^{+} ⁢ sin \left({ω}_{1}⁢t+{α}_{k}^{+}\right) ⁢ {|}_{k = a , b , c}$
where; ${α}_{a}^{+} = {α}^{+} , {α}_{b}^{+} = {α}^{+} - 120 ⁢ ° , {α}_{b}^{+} = {α}^{+} + 120 ⁢ °$ ${p}_{p} = {\sum }_{k = a , b , c} {v}_{pk}^{+} ⁢ {i}_{k} = 3 ⁢ {V}^{+} ⁢ {I}^{-} ⁢ cos {ϕ}^{+} + 3 ⁢ {V}^{+} ⁢ {I}^{-} ⁢ cos \left(2⁢{ω}_{1}⁢t+{λ}^{\pm }\right)$ ${p}_{q} = {\sum }_{k = a , b , c} {v}_{qk}^{+} ⁢ {i}_{k} = 3 ⁢ {V}^{+} ⁢ {I}^{+} ⁢ sin {ϕ}^{+} + 3 ⁢ {V}^{+} ⁢ {I}^{-} ⁢ sin \left(2⁢{ω}_{1}⁢t+{λ}^{\pm }\right)$

The average value of *pₚ* and *p_{q}* are the pps active and reactive powers as given below; ${P}^{+} = \frac{1}{T} ⁢ {\int }_{t}^{t + T} ⁢ {p}_{p} ⁢ dt$ ${Q}^{+} = \frac{1}{T} ⁢ {\int }_{t}^{t + T} ⁢ {p}_{q} ⁢ dt$

The IP is given by (47) and the AP, defined as the rms of the IP is given by (48). $p = {p}_{p} + j {p}_{q}$ $S = rms \left[p\right] = {\left\{{\left[rms\left({p}_{p}\right)\right]}^{2}+{\left[rms\left({p}_{q}\right)\right]}^{2}\right\}}^{\frac{1}{2}}$

The components of S given by (48) are calculated as follow; $rms \left[{p}_{p}\right] = \sqrt{\frac{1}{T} ⁢ {\int }_{t}^{t + T} ⁢ {p}_{p}^{2} ⁢ dt} = 3 ⁢ {V}^{+} ⁢ \sqrt{{\left({I}^{+}⁢cos{ϕ}^{+}\right)}^{2} + \frac{{I}^{{-}^{2}}}{2}}$ $rms \left[{p}_{q}\right] = \sqrt{\frac{1}{T} ⁢ {\int }_{t}^{t + T} ⁢ {p}_{q}^{2} ⁢ dt} = 3 ⁢ {V}^{+} ⁢ \sqrt{{\left({I}^{+}⁢sin{ϕ}^{+}\right)}^{2} + \frac{{I}^{{-}^{2}}}{2}}$

By substituting (49.a) and (49.b) into (48) Equation (42) is deduced.

### 4.2-AP Calculation Using rms Values of Voltages and Current

Equation (42) can be determined from the rms values of the voltage and currents. It can be proved that the pps voltage is independent of the reference voltage. ${v}_{meas k} = {v}_{k} - {v}_{ref} ⁢ {|}_{k = a , b , c}$ $3 ⁢ {v}^{+} = {v}_{meas a} + H ⁢ {v}_{meas b} + {H}^{2} ⁢ {v}_{meas c}$
where: H $H = {e}^{j ⁢ \frac{2 ⁢ π}{3}} , {H}^{2} = {e}^{- j ⁢ \frac{2 ⁢ π}{3}}$ ${v}_{meas k} = measured phase voltage , {v}_{k} = phase voltage$

Thus $3 ⁢ {v}^{+} = {v}_{a} + H ⁢ {v}_{b} + {H}^{2} ⁢ {v}_{c} - \left(1+H+{H}^{2}\right) ⁢ {v}_{ref}$

Since (1+H+H²)=0 then the reference voltage is eliminated from (52). The rms of the pps voltage is given by (53). $3 ⁢ {V}^{+} = \sqrt{\frac{1}{T} ⁢ {\int }_{t}^{t + T} ⁢ {\left(3⁢{v}^{+}\right)}^{2} ⁢ dt}$

The amount of hardware and software for calculating the AP will be reduced if (42) can be arranged in terms of the phase currents. Equation (42) can be written as (54); $S = 3 ⁢ {V}^{+} ⁢ \sqrt{{I}^{{+}^{2}} + {I}^{{-}^{2}}} = 3 ⁢ {V}^{+} ⁢ \sqrt{{I}^{{+}^{2}} + {I}^{{-}^{2}} + {I}^{{o}^{2}} - {I}^{{o}^{2}}}$

It can be shown that the following relationship exists between the rms values of phase and symmetrical component currents [1]. ${I}_{a}^{2} + {I}_{b}^{2} + {I}_{c}^{2} = 3 ⁢ \left({I}^{{+}^{2}}+{I}^{{-}^{2}}+{I}^{{o}^{2}}\right)$

The rms of zps current is deduced from (56). ${I}^{o} = \sqrt{\frac{1}{T} {\int }_{t}^{t + T} ⁢ {\left[\frac{1}{3}⁢\left({i}_{a}+{i}_{b}+{i}_{c}\right)\right]}^{2}}$

Substituting (55) and (56) into (54) yields; $S = 3 ⁢ {V}^{+} ⁢ \sqrt{\frac{1}{3} ⁢ \left({I}_{a}^{2}+{I}_{b}^{2}+{I}_{c}^{2}\right) - {I}^{{o}^{2}}}$

where Iₐ, _{b}, _{c}= rms of the phase currents.

### 5-CONCLUSIONS

The new AP described in [2] was represented in terms of the symmetrical components. The active and reactive powers were determined as dc signals on the real and imaginary axis. As in [2] the quantities defined as symmetrical and unsymmetrical AP were obtained in terms of the symmetrical components.

It was shown that the IP of 3-phase ideal source consists of a complex dc signal, which gives the active and reactive powers and is the result of the product of the pps voltage and current, and an ac signal which is the result of the product of pps voltage and nps current. The ac term is responsible for the increase in the AP when the system is unbalanced.

The reactive power is a physical quantity. Whenever there is a phase difference between the voltage and current, there exists a reactive power in the circuit. The difference between S and P not only depends on the existence of the reactive power but on the ac term of the IP. It may not be possible to attach any physical meaning to this term. However, it can be said that the ac term causes the increase in size of S.

The compensation of reactive power by passive elements also affects the ac components of the IP.

It was proved that unbalanced loads convert some of the power components into others and injects them back to the system to meet the demand by the system impedance and other parallel loads. As a result, it was suggested that only the products of the pps voltage with pps and nps currents be considered at the load terminals. Also since the above argument is valid for the active and reactive powers then it was suggested that the pps active power be considered for the energy bill purposes. It was suggested that the pf be calculated from the pps power and the AP that is the result of the product of the pps voltage and pps and nps currents.

Two methods were presented for devising the algorithm using rms of the IP or rms of the pps voltage and appropriate currents.

### 6-REFERENCES

[1]-A. Emanuel," On The Definition of Power Factor and Apparent Power in Unbalanced Polyphase Circuits with Sinusoidal Voltage and Currents," IEEE Trans. on Power Delivery, Vol. 11, No. 1, pp.79-101, Jan 1996
[2]-F. Ghassemi," A New Concept in AC Power Theory, Part One: Single and Three Phase Systems," Companion paper.
[3]-The Electricity Council, Power System Protection, TextBook, Vol. 1, 1995, UK.

### 7-APPENDIX A

Assume that the source pps voltage is given by (A1). $e \left(t\right) = \hat{E} ⁢ cos \left({ω}_{1}⁢t\right)$

The sequence voltages at the load are given by (A2). $\begin{matrix}{v}^{+} \left(t\right) = {e}^{+} \left(t\right) - Δ ⁢ {v}^{+} \left(t\right) \\ {v}^{-} \left(t\right) = - Δ ⁢ {v}^{-} \left(t\right) \\ {v}^{o} \left(t\right) = - Δ ⁢ {v}^{o} \left(t\right)\end{matrix} }$

Where : ${v}^{+} \left(t\right) = {\hat{V}}^{+} ⁢ cos \left({ω}_{1}⁢t+{α}^{+}\right)$ ${v}^{-} \left(t\right) = {\hat{V}}^{-} ⁢ cos \left({ω}_{1}⁢t+{α}^{-}\right)$ ${v}^{o} \left(t\right) = {\hat{V}}^{o} ⁢ cos \left({ω}_{1}⁢t+{α}^{o}\right)$

The magnitude and phase of each component are given below; ${\hat{V}}^{+} = \sqrt{{\left[\hat{E}-{Z}_{s}^{+}⁢{\hat{I}}^{+}⁢cos\left({ϕ}_{s}^{+}+{β}^{+}\right)\right]}^{2} + {\left[{Z}_{s}^{+}⁢{\hat{I}}^{+}⁢sin\left({ϕ}_{s}^{+}+{β}^{+}\right)\right]}^{2}}$ ${α}^{+} = {tan}^{- 1} ⁢ \left[-\frac{{Z}_{s}^{+} ⁢ {\hat{I}}^{+} ⁢ sin \left({ϕ}_{s}^{+}+{β}^{+}\right)}{\hat{E} - {Z}_{s}^{+} ⁢ {\hat{I}}^{+} ⁢ cos \left({ϕ}_{s}^{+}+{β}^{+}\right)}\right]$ ${\vec{Z}}_{s}^{r} = {Z}_{s}^{r} ∠ {ϕ}_{s}^{r} ⁢ {|}_{r = + , - , o}$ ${Z}_{s}^{+} = \sqrt{{R}_{s}^{{+}^{2}} + {\left({ω}_{1}⁢{L}_{s}^{+}\right)}^{2}}$ ${ϕ}_{s}^{+} = {tan}^{- 1} ⁢ \frac{{ω}_{1} ⁢ {L}_{s}^{+}}{{R}_{s}^{+}}$ ${\hat{V}}^{-} = {Z}_{s}^{-} ⁢ {\hat{I}}^{-} = \sqrt{{R}_{s}^{{-}^{2}} + {\left({ω}_{1}⁢{L}_{s}^{-}\right)}^{2}} ⁢ {\hat{I}}^{-}$ ${α}_{Δ}^{-} = {ϕ}_{s}^{-} + {β}^{-}$ ${\hat{V}}^{o} = {Z}_{s}^{o} ⁢ {\hat{I}}^{o} = \sqrt{{R}_{s}^{{o}^{2}} + {\left({ω}_{1}⁢{L}_{s}^{o}\right)}^{2}} ⁢ {\hat{I}}^{o}$ ${α}_{Δ}^{o} = {ϕ}_{s}^{o} + {β}^{o}$ ${α}^{-} = {α}_{Δ}^{-} + π$ ${α}^{o} = {α}_{Δ}^{o} + π$

**ABSTRACT** In this paper the new power theory is investigated for non-sinusoidal waveforms. It will be shown that the Instantaneous power components can be determined in frequency and time domains. The reactive power is determined as a dc imaginary signal in the form of the sum of harmonic reactive powers. This is equivalent to the Budeanu reactive power. The apparent power in 1-phase and 3-phase systems is investigated. The Symmetrical components are used to identify the components of the instantaneous and apparent powers and it is shown that the use of the fundamental frequency component is sufficient for calculating the active and apparent powers and thus the power factor. A new definition for the Distortion Power is also presented.

### KEYWORDS Apparent Power, Power Factor, Non-Sinusoidal Waveforms, Distortion Power.

### 1-INTRODUCTION

The definition of active, reactive and apparent powers and also power factor (pf) when the waveforms are not sinusoidal have been investigated for many years. There is much literature on the subject that dates back as far as 1927 [1, 2, 3]. Ref. [1] highlights the reasons for using the apparent power in power engineering. For detailed study of the problem the reader is referred to this large amount of literature on the subject.

In the first two parts of this report a new apparent power (AP) and pf was defined and investigated for 1-phase and 3-phase systems. The purpose of the present work is to apply the new definition of the AP to a non-sinusoidal waveform situation. The basis of the proposed power theory is such that the active, reactive powers and AP can be deduced in time or frequency domain. In the new method a quadrature axis voltage is obtained by phase shifting the voltage signal by -90° to form a complex voltage[4]. This complex voltage is then used to calculate the instantaneous power (IP). If the voltage(s) and current(s) are non-sinusoidal, then the IP will consists of different frequency terms. It will be shown that these frequency components may increase the size of the IP that is defined by its 2-Norm. The format and significance of the average value of the IP is also highlighted.

It is postulated that although it is possible to devise a signal processing system (filter) with a phase response of -90° for all harmonics of the fundamental frequency to obtain the quadrature axis voltages, this is not an essential requirement. The use of the fundamental frequency component (ffc) voltage may be sufficient for calculating the AP and hence the use of complicated signal processing with a particular phase response is avoided.

### 2-SINGLE PHASE POWER COMPONENTS

Consider an ideal source that feeds a non-linear load via a transmission circuit. The non-linear load draws a non-sinusoidal current. The source and load terminals are considered separately.

### 2.1-Source Terminal.

The voltage at the source and the current in the circuit are given by (1) and (2) respectively. $e \left(t\right) = {\hat{E}}_{1} ⁢ cos \left({ω}_{1}⁢t\right)$ $i \left(t\right) = {\sum }_{h = 1}^{∞} {\hat{I}}_{h} ⁢ cos \left({ω}_{h}⁢t+{β}_{h}\right)$
where βₕ is the phase angle of the harmonic currents with respect to (w.r.t) the source voltage and h is the harmonic order. The source can only generate the ffc voltage. The quadrature axis voltage and the IP are given by (3) and (4) respectively. ${e}_{q} \left(t\right) = {\hat{E}}_{1} ⁢ sin \left({ω}_{1}⁢t\right)$ $p \left(t\right) = {e}_{m} \left(t\right) ⁢ {i}^{*} \left(t\right) = {\hat{E}}_{1} ⁢ {e}^{j ⁢ {ω}_{1} ⁢ t} ⁢ {\left[{\sum }_{h = 1}^{∞}{\hat{I}}_{h}⁢cos\left({ω}_{h}⁢t+{β}_{h}\right)\right]}^{*}$

Equation (4) can be rewritten as follows; $p \left(t\right) = {E}_{1} ⁢ {I}_{1} ⁢ {e}^{j ⁢ {ϕ}_{1}} + {E}_{1} ⁢ {I}_{1} ⁢ {e}^{j ⁢ \left(2⁢{ω}_{1}⁢t+{λ}_{1}\right)} + {\sum }_{h = 2}^{∞} \left[{E}_{1}⁢{I}_{h}⁢{e}^{j ⁢ \left(2⁢{ω}_{1}⁢t+{ϕ}_{1 ⁢ h}\right)}+{E}_{1}⁢{I}_{h}⁢{e}^{j ⁢ \left(2⁢{ω}_{1}⁢t+{λ}_{1 ⁢ h}\right)}\right]$
where:
E₁=rms of the real ffc voltage
Iᵢ=rms of the ffc current
ϕ₁=phase angle between ffc voltage and current =β₁
λ₁=+β₁
h= harmonic order
Iₕ = rms of harmonic components
ω₁ₕ=ω₁-ωₕ , ω^{1h}=ω₁+ωₕ for h≠1
ϕ₁ₕ=-βₕ , λ₁ₕ=βₕ for h≠1

It can be seen that the IP consists of dc and ac components. The average real and imaginary values represent the standard definition of active and reactive powers. It is evident that the source can only produce these components by ffc. This is physically acceptable as the machine is driven at the fundamental angular frequency and the energy conversion and voltage generation takes place at this frequency only. The product of other frequency components with ffc voltage cannot have any average value neither on real nor imaginary axis.

It can be also seen that the ac terms do not have equal frequencies. The product of the ffc voltage with the current harmonics (excluding the ffc current) leads to ac terms with distinct negative and positive frequencies that are denoted by ω₁ₕ and ω^{1h} respectively. The product of the ffc voltage and current also result in an ac term with double frequency. The AP, which is the 2-Norm (rms) of (5), is thus given by (6). $S = \sqrt{{\left({E}_{1}⁢{I}_{1}\right)}^{2} + {\left({E}_{1}⁢{I}_{1}\right)}^{2} + {\sum }_{h = 2}^{∞} {\left({E}_{1}⁢{I}_{h}\right)}^{2} + {\sum }_{h = 2}^{∞} {\left({E}_{1}⁢{I}_{h}\right)}^{2}} = \sqrt{2} ⁢ {E}_{1} ⁢ \sqrt{{\sum }_{h = 1}^{∞} {{I}_{h}}^{2}}$

Note that the ac terms of (5) cannot have equal frequencies.

The same result can be deduced in frequency domain. By performing convolution on the frequency spectrum of the voltage and current, given by (7.a) and (7.b) respectively, the same result as calculating the Fourier transform of (5) is obtained. $E \left(f\right) = \hat{E} ⁢ δ ⁢ \left(f-{f}_{1}\right)$ $I \left(f\right) = \frac{1}{2} ⁢ \left[{\hat{I}}_{h}⁢{e}^{j ⁢ {β}_{h}}⁢δ⁢\left(f-{f}_{h}\right)+{\hat{I}}_{h}⁢{e}^{- j ⁢ {β}_{h}}⁢δ⁢\left(f+{f}_{h}\right)\right]$

The frequency spectrum of (5) is shown in Fig. 11.

It is clear that the AP given by (6) can also be calculated from the spectrum of the IP shown in Fig. 11. $S = \sqrt{{\left({E}_{1}⁢{I}_{1}\right)}^{2} + {S}_{2 ⁢ f}^{2} + {S}_{3 ⁢ f}^{2} + {S}_{- f}^{2} + ⋯}$
where S_{2f}, S_{3f}, S_{-f},.... are the magnitude of the ac-terms of the IP at different frequencies.

The term in square brackets in (5) can be regarded as the Distortion Instantaneous Power (DIP), since it exists if the current is non-sinusoidal. Distortion Power (DP), which is a component of the AP, is defined as given in (9). $D = \sqrt{2} ⁢ \sqrt{{\sum }_{h = 2}^{∞} {\left({E}_{1}⁢{I}_{h}\right)}^{2}}$

Thus, the AP can be rewritten as follows; $S = \sqrt{2 ⁢ {P}^{2} + 2 ⁢ {Q}^{2} + {D}^{2}}$

### 2.2-Load Terminal

The load terminal voltage is obtained by subtracting the voltage drop of the system impedance from the source voltage. Thus; $Δ ⁢ {v}_{h} \left(t\right) = \left({R}_{sh}+{L}_{sh}⁢\frac{d}{dt}\right) ⁢ {\hat{I}}_{h} ⁢ cos \left({ω}_{h}⁢t+{β}_{h}\right)$ $Δ ⁢ v \left(t\right) = {\sum }_{h = 1}^{∞} Δ ⁢ {v}_{h} \left(t\right) = {\sum }_{h = 1}^{∞} Δ ⁢ {\hat{V}}_{h} cos \left({ω}_{h}⁢t+{β}_{Δh}\right)$
where:
Rₛₕ = system impedance resistance at frequency h
Lₛₕ = system impedance inductance at frequency h
$Δ ⁢ {\hat{V}}_{h} = \sqrt{{R}_{sh}^{2} + {\left({ω}_{h}⁢{L}_{sh}\right)}^{2}} ⁢ {\hat{I}}_{h}$ ${α}_{Δh} = {β}_{h} + {ϕ}_{sh}$ ${ϕ}_{sh} = {tan}^{- 1} \left(\frac{{ω}_{h} {L}_{sh}}{{R}_{sh}}\right)$
and $v \left(t\right) = e \left(t\right) - Δ ⁢ v \left(t\right)$

Substituting (11.b) into (13) yields; $v \left(t\right) = {\hat{E}}_{1} ⁢ cos \left({ω}_{1}⁢t\right) - {\sum }_{h = 1}^{∞} Δ ⁢ {\hat{V}}_{h} cos \left({ω}_{h}⁢t+{α}_{Δh}\right)$ $v \left(t\right) = {\hat{V}}_{1} ⁢ cos \left({ω}_{1}⁢t+{α}_{1}\right) + {\sum }_{h = 2}^{∞} {\hat{V}}_{h} cos \left({ω}_{h}⁢t+{α}_{h}\right)$
where: ${\hat{V}}_{1} = \sqrt{{\left[{\hat{E}}_{1}-Δ⁢{\hat{V}}_{1}⁢cos\left({α}_{Δ ⁢ 1}\right)\right]}^{2} + {\left[Δ⁢{\hat{V}}_{1}⁢sin\left({α}_{Δ ⁢ 1}\right)\right]}^{2}}$ ${α}_{1} = - {tan}^{- 1} ⁢ \left[\frac{Δ ⁢ {\hat{V}}_{1} ⁢ sin \left({α}_{Δ ⁢ 1}\right)}{{\hat{E}}_{1} - Δ ⁢ {\hat{V}}_{1} ⁢ cos \left({α}_{Δ ⁢ 1}\right)}\right]$ ${\hat{V}}_{h} = Δ ⁢ {\hat{V}}_{h} ⁢ {|}_{h = 2}$ ${α}_{h} = {α}_{Δh} + π ⁢ {|}_{h = 2}$

Equations (17.a) and (17.b) give the complex voltage signals for the system impedance and load terminal respectively. $Δ ⁢ {v}_{m} \left(t\right) = {\sum }_{h = 1}^{∞} Δ ⁢ {\hat{V}}_{h} ⁢ {e}^{j ⁢ \left({ω}_{h}⁢t+{α}_{Δh}\right)}$ ${v}_{m} \left(t\right) = {\sum }_{h = 1}^{∞} {\hat{V}}_{h} ⁢ {e}^{j ⁢ \left({ω}_{h}⁢t+{α}_{h}\right)}$

The corresponding IP are given below; $Δ ⁢ p = Δ ⁢ {v}_{m} \left(t\right) ⁢ i * \left(t\right) = Δ ⁢ {\hat{V}}_{1} ⁢ {\hat{I}}_{1} ⁢ {e}^{j ⁢ \left({ω}_{1}⁢t+{α}_{Δ ⁢ 1}\right)} ⁢ cos \left({ω}_{1}⁢t+{β}_{1}\right) + {\sum }_{h = 2}^{∞} Δ ⁢ {\hat{V}}_{1} ⁢ {\hat{I}}_{h} ⁢ {e}^{j ⁢ \left({ω}_{1}⁢t+{α}_{Δ ⁢ 1}\right)} ⁢ cos \left({ω}_{h}⁢t+{β}_{h}\right) + {\sum }_{h = 2}^{∞} Δ ⁢ {\hat{V}}_{h} ⁢ {\hat{I}}_{h} ⁢ {e}^{j ⁢ \left({ω}_{h}⁢t+{α}_{Δh}\right)} ⁢ cos \left({ω}_{h}⁢t+{β}_{h}\right) + {\sum }_{n = 2}^{∞} {\sum }_{\begin{matrix}m = 1 \\ m \neq n\end{matrix}}^{∞} Δ ⁢ {\hat{V}}_{n} ⁢ {\hat{I}}_{m} ⁢ {e}^{j ⁢ \left({ω}_{n}⁢t+{α}_{Δn}\right)} ⁢ cos \left({ω}_{m}⁢t+{β}_{n}\right)$ $p = Δ ⁢ {v}_{m} \left(t\right) ⁢ i * \left(t\right) = Δ ⁢ {\hat{V}}_{1} ⁢ {\hat{I}}_{1} ⁢ {e}^{j ⁢ \left({ω}_{1}⁢t+{α}_{1}\right)} ⁢ cos \left({ω}_{1}⁢t+{β}_{1}\right) + {\sum }_{h = 2}^{∞} Δ ⁢ {\hat{V}}_{1} ⁢ {\hat{I}}_{h} ⁢ {e}^{j ⁢ \left({ω}_{1}⁢t+{α}_{Δ ⁢ 1}\right)} ⁢ cos \left({ω}_{h}⁢t+{β}_{h}\right) - {\sum }_{h = 2}^{∞} Δ ⁢ {\hat{V}}_{h} ⁢ {\hat{I}}_{h} ⁢ {e}^{j ⁢ \left({ω}_{h}⁢t+{α}_{Δh}\right)} ⁢ cos \left({ω}_{h}⁢t+{β}_{h}\right) - {\sum }_{n = 2}^{∞} {\sum }_{\begin{matrix}m = 1 \\ m \neq n\end{matrix}}^{∞} Δ ⁢ {\hat{V}}_{n} ⁢ {\hat{I}}_{m} ⁢ {e}^{j ⁢ \left({ω}_{n}⁢t+{α}_{Δn}\right)} ⁢ cos \left({ω}_{m}⁢t+{β}_{n}\right)$

It can be seen that those terms of the IPs that do not involve the ffc voltage have equal magnitudes and opposite sign. This implies that the load actually supplies these components of the IP to the system impedance. For the system considered, the source of these components of the IP are the components that are the product of the ffc voltage and harmonic currents, namely; $p \left(t\right) = {\hat{V}}_{1} ⁢ {\hat{I}}_{1} ⁢ {e}^{j ⁢ \left({ω}_{1}⁢t+{α}_{1}\right)} ⁢ cos \left({ω}_{1}⁢t+{β}_{1}\right) + {\sum }_{h = 2}^{∞} {\hat{V}}_{1} ⁢ {\hat{I}}_{h} ⁢ {e}^{j ⁢ \left({ω}_{1}⁢t+{α}_{1}\right)} ⁢ cos \left({ω}_{h}⁢t+{β}_{h}\right)$
(19) gives the IP components that the source can produce. Any other demand is met in the non-linear load by converting some of the IP components from (19). Note that the equivalent of (19) for the system impedance is also provided by the source. This phenomenon in a non-sinusoidal situation is similar to the case discussed in [5], when a 3-phase unbalanced system was considered. More discussion will be given later in this report when power factor (pf) is investigated. (18.b) can be rearranged as follows; $p = {\sum }_{h = 1}^{∞} {V}_{h} ⁢ {I}_{h} ⁢ {e}^{j ⁢ {ϕ}_{h}} + {\sum }_{h = 1}^{∞} {V}_{h} ⁢ {I}_{h} ⁢ {e}^{j ⁢ \left(2⁢{ω}_{h}⁢t+{λ}_{h}\right)} + {\sum }_{n = 1}^{∞} {\sum }_{\begin{matrix}m = 1 \\ m \neq n\end{matrix}}^{∞} {V}_{n} ⁢ {I}_{m} ⁢ {e}^{j ⁢ \left({ω}_{nm}⁢t+{ϕ}_{mn}\right)} + {\sum }_{n = 1}^{∞} {\sum }_{\begin{matrix}m = 1 \\ m \neq n\end{matrix}}^{∞} {V}_{n} ⁢ {I}_{m} ⁢ {e}^{j ⁢ \left({ω}^{nm}⁢t+{λ}_{mn}\right)}$
where: ${ϕ}_{h} = {α}_{h} - {β}_{h} , {λ}_{h} = {α}_{h} + {β}_{h} , {ϕ}_{nm} = {α}_{n} - {β}_{m} , {λ}_{nm} = {α}_{n} + {β}_{m}$ ${ω}_{nm} = {ω}_{n} - {ω}_{m} , {ω}^{nm} = {ω}_{n} + {ω}_{m}$

V and I with subscripts denote the rms of a specific harmonic.

(20) gives the total IP at the load terminal. Note that the average imaginary of (20) is the Budeanu's reactive power [6]. In that definition the total reactive power was defined as the sum of the magnitude of ac components with different frequencies. That was not acceptable to many researchers [6]. However, with the new method presented in this article, the reactive power is deduced as the sum of dc terms. This does not present any analytical problem. The real average value of (20) is the total active power consumed by the load. Thus; ${P}_{t} + j ⁢ {Q}_{t} = {\sum }_{h = 1}^{∞} {V}_{h} ⁢ {I}_{h} ⁢ cos {ϕ}_{h} + j {\sum }_{h = 1}^{∞} {V}_{h} ⁢ {I}_{h} ⁢ sin {ϕ}_{h}$

The frequency of the ac terms in (20), depends on the frequency spectra of the voltage and current. It is clear that the product of different frequency components of voltage and current in time domain (or convolution in frequency domain) may result in the formation of ac components with equal frequencies. Thus in general, combining the ac components with equal frequencies, the IP at the load terminal can be written as follows; $p = {\sum }_{h = 1}^{∞} {V}_{h} ⁢ {I}_{h} ⁢ {e}^{j ⁢ {ϕ}_{h}} + {\sum }_{w = - ∞}^{∞} {S}_{w} ⁢ {e}^{j ⁢ \left({Ω}_{w}⁢t+{θ}_{w}\right)}$
where:
S_{w}= magnitude of the ac terms for different frequencies
θ_{w}= angle of the ac terms

The AP is thus given by (23). $S = \sqrt{{\left({\sum }_{h = 1}^{∞}{V}_{h}⁢{I}_{h}⁢cos{ϕ}_{h}\right)}^{2} + {\left({\sum }_{h = 1}^{∞}{V}_{h}⁢{I}_{h}⁢sin{ϕ}_{h}\right)}^{2} + {\sum }_{h = 1}^{∞} {S}_{w}^{2}}$

If the relationships given by (24) are valid for the IP then the AP can be written as (25).${2 ⁢ ω}_{h} \neq {ω}_{nm} , {2 ⁢ ω}_{h} \neq {ω}^{nm} , {ω}_{nm} \neq {ω}^{nm} }$for any h, n and m$S = \sqrt{{\left({\sum }_{h = 1}^{∞}{V}_{h}⁢{I}_{h}⁢cos{ϕ}_{h}\right)}^{2} + {\left({\sum }_{h = 1}^{∞}{V}_{h}⁢{I}_{h}⁢sin{ϕ}_{h}\right)}^{2} + {\sum }_{h = 1}^{∞} {\left({V}_{h}⁢{I}_{h}\right)}^{2} + 2 {\sum }_{n = 1}^{∞} {\sum }_{\begin{matrix}n = 1 \\ m \neq n\end{matrix}}^{∞} {\left({V}_{n}⁢{I}_{m}\right)}^{2}}$

The pf is equal to P/S. Thus using the total active power given by (21) and total AP described by (23), the pf can be calculated.

### 3-DISCUSSION

It was shown that the source can only produce those components of the IP that are the product of the ffc voltage and full spectrum of the current. Those terms of the system impedance IP that are the result of the product of the harmonic voltages (non-ffc voltage) and full spectrum of the current are supplied by the non-linear load. If the current spectrum of the non-linear load is not disturbed by any form of filtering, then the source of the above IP components are those terms that result from the product of the ffc voltage and full spectrum of the current. If filters are used to modify the current spectrum then some of the non-ffc voltage components are produced by the filters.

Since the active power is only generated by the ffc voltages and currents then active, harmonic powers are supplied by the non-linear load by converting some of the ffc power.

The above argument is also true for the harmonic power components of any linear load in parallel with the non-linear load that absorbs harmonic currents. In other words, the non-ffc voltage components of the linear loads are supplied by the non-linear load. Note that the ffc active and reactive powers of the linear load are smaller than the total active and reactive powers as for linear loads the harmonic active and reactive powers are added to the ffc of the respective power components. However, harmonic powers have a detrimental effect on systems and one may argue that the linear loads are forced to consume these powers.

Hence, it is suggested that the IP is calculated only for ffc voltage components. The logic behind this is the fact that other power components are supplied by the ffc voltage terms. The non-linear load must be held responsible for the harmonic pollution, assuming the system impedance values comply with the design standards.

Thus the IP is calculated using (26). $p \left(t\right) = {v}_{m ⁢ 1} \left(t\right) ⁢ i * \left(t\right) = {V}_{1} ⁢ {I}_{1} ⁢ {e}^{j ⁢ {ϕ}_{1}} + {V}_{1} ⁢ {I}_{1} ⁢ {e}^{j ⁢ \left(2⁢{ω}_{1}⁢t+{λ}_{1}\right)} + {\sum }_{h = 2}^{∞} \left[{V}_{1}⁢{I}_{h}⁢{e}^{j ⁢ \left({ω}_{1 ⁢ h}⁢t+{ϕ}_{1 ⁢ h}\right)}+{V}_{1}⁢{I}_{h}⁢{e}^{j ⁢ \left({ω}^{1 ⁢ h}⁢t+{λ}_{1 ⁢ h}\right)}\right]$

It can be seen that (26) has a format similar to the source IP. The ac terms do not have equal frequencies. The average real and imaginary values of (26) are the ffc active and reactive powers respectively. The AP and pf of the load are thus given by (27) and (28) respectively. $S = \sqrt{2} ⁢ \sqrt{{\left({V}_{1}⁢{I}_{1}\right)}^{2} + {\sum }_{h = 2}^{∞} {\left({V}_{1}⁢{I}_{h}\right)}^{2}} = \sqrt{2} ⁢ {V}_{1} ⁢ \sqrt{{\sum }_{h = 1}^{∞} {I}_{h}^{2}}$ $pf = \frac{P}{S} = \frac{{V}_{1} ⁢ {I}_{1} ⁢ cos {ϕ}_{1}}{\sqrt{2} ⁢ {V}_{1} ⁢ \sqrt{{\sum }_{h = 1}^{∞} {I}_{h}^{2}}} = \frac{{I}_{1} ⁢ cos {ϕ}_{1}}{\sqrt{2} ⁢ \sqrt{{\sum }_{h = 1}^{∞} {I}_{h}^{2}}}$

It can be said that the AP and pf given respectively by (27) and (28) reflect the electrical quality of the load in single phase pure/non sinusoidal situations.

### 4-IMPLEMENTATION OF THE TECHNIOUE

In order to calculate the AP, the voltage signal must be phase shifted by -90° to obtain the quadrature axis voltage signal. Thus, a system is required with a phase response of -90° for all frequencies in the bandwidth considered. However, it was shown that the product of the ffc voltage and full spectrum of the current can reflect the energy consumption and quality of the load. Hence, it is essential to filter the voltage signal to extract the ffc voltage and then to perform the phase shifting process. This eliminates the need for a sophisticated filtering and signal processing.

Appendix A shows that (29) can be used to calculate the AP. $S = \sqrt{{\left\{rms\left[{v}_{1 ⁢ p}\left(t\right)⁢i\left(t\right)\right]\right\}}^{2} + {\left\{rms\left[{v}_{1 ⁢ q}\left(t\right)⁢i\left(t\right)\right]\right\}}^{2}}$
where : ${v}_{1 ⁢ p} \left(t\right) = {\hat{V}}_{1} ⁢ cos \left({ω}_{1}⁢t+{α}_{1}\right) , {v}_{1 ⁢ q} \left(t\right) = {\hat{V}}_{1} ⁢ sin \left({ω}_{1}⁢t+{α}_{1}\right)$ *i(t)* is given by (2)

### 5-THREE PHASE SYSTEMS

The procedure for calculating the AP in 3-phase systems when the signals are not sinusoidal is exactly the same as the case that has been described in [4] and the proceeding sections.

### 5.1-AP Calculation Using Phase Quantities

Assume the phase voltages and currents at any point in the circuit are given below: ${v}_{k} \left(t\right) = {\sum }_{h = 1}^{∞} {\hat{V}}_{kh} ⁢ cos \left({ω}_{h}⁢t+{α}_{kh}\right) ⁢ {|}_{k = a , b , c}$ ${i}_{k} \left(t\right) = {\sum }_{h = 1}^{∞} {\hat{I}}_{kh} ⁢ cos \left({ω}_{h}⁢t+{β}_{kh}\right) ⁢ {|}_{k = a , b , c}$
where k and h denote phase number and harmonic order respectively. Note that in order to consider a general case the harmonic order for different phases may not be the same.

The complex voltages and the total IP are determined from (31) and (32) respectively. ${v}_{mk} \left(t\right) = {\sum }_{h = 1}^{∞} {\hat{V}}_{kh} ⁢ {e}^{j ⁢ \left({ω}_{h}⁢t+{α}_{kh}\right)} ⁢ {|}_{k = a , b , c}$ $p \left(t\right) = {\sum }_{h = 1}^{∞} {\sum }_{k = a , b , c} {V}_{kh} ⁢ {I}_{kh} ⁢ {e}^{j ⁢ {ϕ}_{kh}} + {\sum }_{w = - ∞}^{∞} {\sum }_{k = a , b , c} {S}_{kw} ⁢ {e}^{j ⁢ \left({Ω}_{w}⁢t+{θ}_{kw}\right)}$
where Vₖₕ and Iₖₕ are the rms of the per phase harmonic voltages and currents. S_{kw} is the magnitude of the ac terms of the IP.

The AP is defined as the 2-Norm of (32). Thus: $S ⁢ {\left\{{\left({\sum }_{h = 1}^{∞}{\sum }_{k = a , b , c}{V}_{kh}⁢{I}_{kh}⁢cos{ϕ}_{kh}\right)}^{2}+{\left({\sum }_{h = 1}^{∞}{\sum }_{k = a , b , c}{V}_{kh}⁢{I}_{kh}⁢sin{ϕ}_{kh}\right)}^{2}+{\sum }_{w = - ∞}^{∞}\left[{\left({\sum }_{k = a , b , c}{S}_{kw}⁢cos{θ}_{kh}\right)}^{2}+{\left({\sum }_{k = a , b , c}{S}_{kw}⁢sin{θ}_{kh}\right)}^{2}\right]\right\}}^{\frac{1}{2}}$

S described by (33) is the total AP of the non-linear load itself, excluding the demand by the system impedance and any other linear parallel load that absorbs some of the harmonic currents. The pf is the ratio of the active power, that is the real dc value of (32), and S given by (33).

At the source and also if the load terminal ffc voltage is considered in the power analysis of 3-phase systems, then the IP can be calculated from (34). $p \left(t\right) = {\sum }_{k = a , b , c} {V}_{k ⁢ 1} ⁢ {I}_{k ⁢ 1} ⁢ {e}^{j ⁢ {ϕ}_{k ⁢ 1}} + {\sum }_{k = a , b , c} {V}_{k ⁢ 1} ⁢ {I}_{k ⁢ 1} ⁢ {e}^{j ⁢ \left(2⁢{ω}_{1}⁢t+{λ}_{k ⁢ 1}\right)} + {\sum }_{k = a , b , c} {\sum }_{h = 2}^{∞} {v}_{k ⁢ 1} ⁢ {i}_{kh}^{*}$ $p \left(t\right) = {\sum }_{k = a , b , c} {V}_{k ⁢ 1} ⁢ {I}_{k ⁢ 1} ⁢ {e}^{j ⁢ {ϕ}_{k ⁢ 1}} + {\sum }_{k = a , b , c} {V}_{k ⁢ 1} ⁢ {I}_{k ⁢ 1} ⁢ {e}^{j ⁢ \left(2⁢{ω}_{1}⁢t+{λ}_{k ⁢ 1}\right)} + {\sum }_{h = 2}^{∞} {\sum }_{k = a , b , c} {V}_{k ⁢ 1} ⁢ {I}_{kh} ⁢ {e}^{j ⁢ \left({ω}_{1 ⁢ h}⁢t+{ϕ}_{k ⁢ 1 ⁢ h}\right)} + {\sum }_{h = 2}^{∞} {\sum }_{k = a , b , c} {V}_{k ⁢ 1} ⁢ {I}_{kh} ⁢ {e}^{j ⁢ \left({ω}^{1 ⁢ h}⁢t+{λ}_{k ⁢ 1 ⁢ h}\right)}$

Where, for the source, Vₖ₁ is replaced by E₁. It can be seen that the ac part consists of terms with distinct positive and negative frequencies. The AP is thus given below: $S = \sqrt{{S}_{s}^{2} + {S}_{u}^{2} + {D}^{2}}$
where: ${S}_{s} = \left|{\sum }_{k = a , b , c}{V}_{k ⁢ 1}⁢{I}_{k ⁢ 1}⁢{e}^{j ⁢ {ϕ}_{k ⁢ 1}}\right| As given in \left[4\right]$ ${S}_{u} = \left|{\sum }_{k = a , b , c}{V}_{k ⁢ 1}⁢{I}_{k ⁢ 1}⁢{e}^{j ⁢ {λ}_{k ⁢ 1}}\right| As given in \left[4\right]$ $D = \sqrt{{\sum }_{h = 2}^{∞} {\left|{\sum }_{k = a , b , c}{V}_{k ⁢ 1}⁢{I}_{kh}⁢{e}^{j ⁢ {ϕ}_{k ⁢ 1 ⁢ h}}\right|}^{2} + {\sum }_{h = 2}^{∞} {\left|{\sum }_{k = a , b , c}{V}_{k ⁢ 1}⁢{I}_{kh}⁢{e}^{j ⁢ {λ}_{k ⁢ 1 ⁢ h}}\right|}^{2}}$
where D is the Distortion Power. Note that Sₛ and Sᵤ are exactly the same as (45.a) and (45.b) in [4]. These terms are related to the ffc voltages and currents.

The pf is then calculated using real dc value of (34) and S given by (35).

### 5.2-AP Calculation Using Symmetrical Components

If the system impedance can be considered equal in all three phases, then the 3-phase system can be replaced by three uncoupled systems known as sequence impedances. The above statement is very near to true in a 3-phase system when only ffc signals are present. However, if there is a non-linear load in the circuit, then mutual effects between sequence networks exist at harmonic frequencies. This is due to the fact that the condition of system impedance symmetry may not be fulfilled since the self and mutual impedances of the phases may be different as the frequency increases. However, it is always possible to resolve the voltages and currents at any point in the system into symmetrical components. The system impedance asymmetry only results in coupling between the sequence networks. This implies that the current in one sequence circuit gives rise to a voltage in others [7]. Therefore, having measured/calculated the phase co-ordinates of voltages and currents, then wide band frequency spectrum three phase signals can be resolved into symmetrical components. Unequal system impedances implies that Equation (16) in [5] is not strictly valid since voltage drop on sequence impedances of the line is not due to one sequence current only. The voltages and currents are defined by (30.a) and (30.b). At any point in the circuit the following relationship between the phase and symmetrical component voltages exists. ${v}^{+} \left(t\right) = {\sum }_{h = 1}^{∞} {v}_{h}^{+} \left(t\right) = \frac{1}{3} {\sum }_{h = 1}^{∞} \left[{v}_{ah}\left(t\right)+{v}_{bh}⁢\left(t+\frac{{T}_{h}}{3}\right)+{v}_{ch}⁢\left(t-\frac{{T}_{h}}{3}\right)\right]$ ${v}^{-} \left(t\right) = {\sum }_{h = 1}^{∞} {v}_{h}^{-} \left(t\right) = \frac{1}{3} {\sum }_{h = 1}^{∞} \left[{v}_{ah}\left(t\right)+{v}_{bh}⁢\left(t-\frac{{T}_{h}}{3}\right)+{v}_{ch}⁢\left(t+\frac{{T}_{h}}{3}\right)\right]$ ${v}^{o} \left(t\right) = {\sum }_{h = 1}^{∞} {v}_{h}^{o} \left(t\right) = \frac{1}{3} {\sum }_{h = 1}^{∞} \left[{v}_{ah}\left(t\right)+{v}_{bh}\left(t\right)+{v}_{ch}\left(t\right)\right]$
where Tₕ is the period for each harmonic including the ffc. The same relationship can be defined for the currents.

If the 3-phase system is balanced, then harmonics will appear only in one symmetrical component signal. For example, for balanced 3-phase systems the 9^{th} harmonic appears in zero phase sequence (zps) only and the 2^{nd} harmonic as negative phase sequence (nps). However, considering a general case, the positive phase sequence (pps), nps and zps signals may contain harmonics irrespective of their orders.

The symmetrical component currents and complex voltages are defined by (39) and (40) respectively. ${i}_{k}^{r} \left(t\right) = {\sum }_{h = 1}^{∞} {\hat{I}}_{kh}^{r} ⁢ cos \left({ω}_{h} t+{β}_{kh}^{r}\right) ⁢ {|}^{r = + , - , o} ⁢ {|}_{k = a , b , c}$ ${v}_{mk}^{r} \left(t\right) = {\sum }_{h = 1}^{∞} {v}_{mkh}^{r} \left(t\right) = {\sum }_{h = 1}^{∞} {\hat{V}}_{kh}^{r} ⁢ {e}^{j ⁢ {\left({ω}_{h}⁢t+{α}_{kh}^{r}\right)}^{r = + , - , o}} ⁢ {|}_{k = a , b , c}$
where: ${α}_{ah}^{+} = {α}_{h}^{+} , {α}_{bh}^{+} = {α}_{h}^{+} - 120 ⁢ ° , {α}_{ch}^{+} = {α}_{h}^{+} + 120 ⁢ °$ ${α}_{ah}^{-} = {α}_{h}^{-} , {α}_{bh}^{-} = {α}_{h}^{-} + 120 ⁢ ° , {α}_{ch}^{-} = {α}_{h}^{-} - 120 ⁢ °$ ${α}_{ah}^{o} = {α}_{h}^{o} , {α}_{bh}^{o} = {α}_{h}^{o} , {α}_{ch}^{o} = {α}_{h}^{o}$ ${β}_{ah}^{+} = {β}_{h}^{+} , {β}_{bh}^{+} = {β}_{h}^{+} - 120 ⁢ ° , {β}_{ch}^{+} = {β}_{h}^{+} + 120 ⁢ °$ ${β}_{ah}^{-} = {β}_{h}^{-} , {β}_{bh}^{-} = {β}_{h}^{-} + 120 ⁢ ° , {β}_{ch}^{-} = {β}_{h}^{-} - 120 ⁢ °$ ${β}_{ah}^{o} = {β}_{h}^{o} , {β}_{bh}^{o} = {β}_{h}^{o} , {β}_{ch}^{o} = {β}_{h}^{o}$

The total IP is defined by (22.a) or (22.b) in [5]. The elements of the total IP are given below; ${p}^{+} = {\sum }_{k = a , b , c} {v}_{mk}^{+} \left(t\right) ⁢ {i}_{k}^{{+}^{*}} \left(t\right) = 3 {\sum }_{n = 1}^{∞} {\sum }_{m = 1}^{∞} {V}_{n}^{+} ⁢ {I}_{m}^{+} ⁢ {e}^{j ⁢ \left({ω}_{nm}⁢t+{ϕ}_{nm}^{+}\right)} = 3 {\sum }_{h = 1}^{∞} {V}_{h}^{+} ⁢ {I}_{h}^{+} ⁢ {e}^{j ⁢ {ϕ}_{h}^{+}} + 3 {\sum }_{n = 1}^{∞} {\sum }_{\begin{matrix}m = 1 \\ m \neq n\end{matrix}}^{∞} {V}_{n}^{+} ⁢ {I}_{m}^{+} ⁢ {e}^{j ⁢ \left({ω}_{nm}⁢t+{ϕ}_{nm}^{+}\right)}$ ${p}^{-} = {\sum }_{k = a , b , c} {v}_{mk}^{-} \left(t\right) ⁢ {i}_{k}^{{-}^{*}} \left(t\right) = 3 {\sum }_{h = 1}^{∞} {V}_{h}^{-} ⁢ {I}_{h}^{-} ⁢ {e}^{j ⁢ {ϕ}_{h}^{-}} + 3 {\sum }_{n = 1}^{∞} {\sum }_{\begin{matrix}m = 1 \\ m \neq n\end{matrix}}^{∞} {V}_{n}^{-} ⁢ {I}_{m}^{-} ⁢ {e}^{j ⁢ \left({ω}_{nm}⁢t+{ϕ}_{nm}^{-}\right)}$ ${p}^{o} = {\sum }_{k = a , b , c} {v}_{mk}^{o} \left(t\right) ⁢ {i}_{k}^{{o}^{*}} \left(t\right) = 3 {\sum }_{h = 1}^{∞} {V}_{h}^{o} ⁢ {I}_{h}^{o} ⁢ {e}^{{jϕ}_{h}^{o}} + 3 {\sum }_{n = 1}^{∞} {\sum }_{\begin{matrix}m = 1 \\ m \neq n\end{matrix}}^{∞} {V}_{n}^{o} ⁢ {I}_{m}^{o} ⁢ {e}^{j ⁢ \left({ω}_{nm}⁢t+{ϕ}_{nm}^{o}\right)} + 3 {\sum }_{n = 1}^{∞} {\sum }_{\begin{matrix}m = 1\end{matrix}}^{∞} {V}_{n}^{o} ⁢ {I}_{m}^{o} ⁢ {e}^{j ⁢ \left({ω}^{nm}⁢t+{λ}_{nm}^{o}\right)}$ ${p}^{\pm } = {\sum }_{k = a , b , c} {v}_{mk}^{+} \left(t\right) ⁢ {i}_{k}^{{-}^{*}} \left(t\right) = 3 {\sum }_{n = 1}^{∞} {\sum }_{\begin{matrix}m = 1\end{matrix}}^{∞} {V}_{n}^{+} ⁢ {I}_{m}^{-} ⁢ {e}^{j ⁢ \left({ω}^{nm}⁢t+{λ}_{nm}^{\pm }\right)}$ ${p}^{\overline{+}} = {\sum }_{k = a , b , c} {v}_{mk}^{-} \left(t\right) ⁢ {i}_{k}^{{+}^{*}} \left(t\right) = 3 {\sum }_{n = 1}^{∞} {\sum }_{\begin{matrix}m = 1\end{matrix}}^{∞} {V}_{n}^{-} ⁢ {I}_{m}^{+} ⁢ {e}^{j ⁢ \left({ω}^{nm}⁢t+{λ}_{nm}^{\overline{+}}\right)}$ ${\sum }_{k = a , b , c} {v}_{mk}^{+} ⁢ {i}_{k}^{{o}^{*}} = {\sum }_{k = a , b , c} {v}_{mk}^{-} ⁢ {i}_{k}^{{o}^{*}} = {\sum }_{k = a , b , c} {v}_{mk}^{o} ⁢ {i}_{k}^{{+}^{*}} = {\sum }_{k = a , b , c} {v}_{mk}^{o} ⁢ {i}_{k}^{{-}^{*}} = 0$
where:

| | |
|---|---|
| ωₙₘ=ωₙ-ωₘ | ω^{nm}=ωₙ+ωₘ |
| ϕₙₘ^{r}=αₙ^{r}-βₘ^{r} | λₙₘ^{r}=αₙ^{r}+βₘ^{r} |

and h, n, m = harmonic orders.ω

With reference to [5] and the aforementioned analysis the following remarks can be made.
1- The product of similar sequences and harmonics leads to dc values in *p*⁺,*p*⁻ and *p*°*.*
2- If the signals are pure sinusoidal, the result is the same as that obtained in [5].
3- The ac components of *p*⁺and *p⁻* have frequencies that result from the difference of the harmonic frequencies.
4- The ac components of *p*° have frequencies that are from the difference and summation of the harmonic frequencies.
5- *p*⁶ and *p*⁷ have frequencies that result from the summation of the harmonic frequencies.
6- At the ideal source terminal *p⁻ , p*° and *p*^{∓} are all zero. The average value is V₁⁺I₁⁺exp(jω₁⁺).
7- For non-linear loads, *p*⁻ *, p*° and *p*^{∓} at all frequencies are equal to the demand of the system impedance and any other parallel loads that absorb the harmonic and unbalanced currents of the non-linear load.
8- The terms mentioned in 7 are supplied through *p*⁺ and *p*^{∓} by the source for the system considered. Note that if there is any form of harmonic filtering, then the above terms are supplied by the source and filter.

Combining the ac terms with equal frequencies, the total IP is given below: $p \left(t\right) = {p}^{+} + {p}^{-} + {p}^{o} + {p}^{\pm } + {p}^{\overline{+}}$ $p \left(t\right) = 3 {\sum }_{r = + , - , o} {V}_{h}^{r} {I}_{h}^{r} ⁢ {e}^{j ⁢ {ϕ}_{h}^{r}} + 3 {\sum }_{w = - ∞}^{∞} {S}_{w} ⁢ {e}^{j ⁢ \left({Ω}_{w}⁢t+{θ}_{w}\right)}$

The average values of (48) on real and imaginary axis are the load active and reactive powers respectively as shown below. $P = 3 ⁢ \left[{\sum }_{h = 1}^{∞}{V}_{h}^{+}{I}_{h}^{+}⁢cos{ϕ}_{h}^{+}+{\sum }_{h = 1}^{∞}{V}_{h}^{-}{I}_{h}^{-}⁢cos{ϕ}_{h}^{-}+{\sum }_{h = 1}^{∞}{V}_{h}^{o}{I}_{h}^{o}⁢cos{ϕ}_{h}^{o}\right]$ $P = 3 ⁢ \left[{\sum }_{h = 1}^{∞}{V}_{h}^{+}{I}_{h}^{+}⁢sin{ϕ}_{h}^{+}+{\sum }_{h = 1}^{∞}{V}_{h}^{-}{I}_{h}^{-}⁢sin{ϕ}_{h}^{-}+{\sum }_{h = 1}^{∞}{V}_{h}^{o}{I}_{h}^{o}⁢sin{ϕ}_{h}^{o}\right]$
(49) and (50) are equal to the real and imaginary average values of (32). The ac terms are also equal for each frequency. The AP in terms of the symmetrical components is the 2-Norm of (48). Thus; $S = 3 ⁢ \sqrt{{\sum }_{r = + , - , o} {\sum }_{h = 1}^{∞} {V}_{h}^{r} {I}_{h}^{r} ⁢ {e}^{j ⁢ {ϕ}_{h}^{r}} + {\sum }_{w = - ∞}^{∞} {S}_{w}^{2}}$ $S = 3 ⁢ \sqrt{{\left({\sum }_{r = + , - , o} {\sum }_{h = 1}^{∞} {V}_{h}^{r} {I}_{h}^{r} cos {ϕ}_{h}^{r}\right)}^{2} + {\left({\sum }_{r = + , - , o} {\sum }_{h = 1}^{∞} {V}_{h}^{r} {I}_{h}^{r} sin {ϕ}_{h}^{r}\right)}^{2} + {\sum }_{h = - ∞}^{∞} {S}_{w}^{2}}$

If one can assumes that (16) in [5] is approximately valid, i.e. the system impedance matrix is symmetrical for all frequencies, then it is technically more acceptable to consider the ffc, pps voltage in the IP calculation. Thus, the IP is determined from (53). $p \left(t\right) = {{\sum }_{k = a , b , c} {v}_{mk ⁢ 1}^{+} \left({\sum }_{h = 1}^{∞}{i}_{kh}^{+}+{\sum }_{h = 1}^{∞}{i}_{kh}^{-}+{\sum }_{h = 1}^{∞}{i}_{kh}^{o}\right)}^{*}$ $p \left(t\right) = 3 ⁢ {V}_{1}^{+} ⁢ {I}_{1}^{+} ⁢ {e}^{j ⁢ {ϕ}_{1}^{+}} + 3 ⁢ {V}_{1}^{+} {\sum }_{h = 2}^{∞} {I}_{h}^{+} ⁢ {e}^{j ⁢ \left({ω}_{1 ⁢ h}⁢t+{ϕ}_{1 ⁢ h}^{+}\right)} + 3 ⁢ {V}_{1}^{+} {\sum }_{h = 1}^{∞} {I}_{h}^{-} ⁢ {e}^{j ⁢ \left({ω}^{1 ⁢ h}⁢t+{λ}_{1 ⁢ h}^{\overline{+}}\right)}$

It can be seen that the ac terms do not have equal frequencies. The product of the ffc, pps voltage with pps currents leads to a complex average value and ac terms with distinct negative frequencies. The product of the ffc, pps voltage and the nps currents, on the other hand, results in the ac terms with distinct positive frequencies. The active, reactive and apparent powers are given by (54.a), (54.b) and (55.b) respectively. $P = 3 ⁢ {V}_{1}^{+} ⁢ {I}_{1}^{+} ⁢ cos {ϕ}_{1}^{+}$ $Q = 3 ⁢ {V}_{1}^{+} ⁢ {I}_{1}^{+} ⁢ sin {ϕ}_{1}^{+}$ $S = \sqrt{{\left(3⁢{V}_{1}^{+}⁢{I}_{1}^{+}\right)}^{2} + {\sum }_{h = 2}^{∞} {\left(3⁢{V}_{1}^{+}⁢{I}_{h}^{+}\right)}^{2} + {\sum }_{h = 1}^{∞} {\left(3⁢{V}_{1}^{+}⁢{I}_{h}^{-}\right)}^{2}}$ $S = 3 ⁢ {V}_{1}^{+} ⁢ \sqrt{{\sum }_{h = 1}^{∞} {{I}_{h}^{+}}^{2} + {\sum }_{h = 1}^{∞} {{I}_{h}^{-}}^{2}}$

The AP in terms of Sₛ, Sᵤ and DP can be written as follows; $S = \sqrt{{S}_{s}^{2} + {S}_{u}^{2} + {D}^{2}}$

Where: ${S}_{s} = 3 ⁢ {V}_{1}^{+} ⁢ {I}_{1}^{+}$ ${S}_{u} = 3 ⁢ {V}_{1}^{+} ⁢ {I}_{1}^{-}$ $D = 3 ⁢ {V}_{1}^{+} ⁢ \sqrt{{\sum }_{h = 2}^{∞} {{I}_{h}^{+}}^{2} + {\sum }_{h = 2}^{∞} {{I}_{h}^{-}}^{2}}$

It can be shown that the power components at the load terminal have the same format as the source where V₁⁺ is replaced by E₁. The pf is calculated from P/S where P and S are given by (54.a) and (55.b).

With reference to [5] and since the relationship given by (58) is valid between phase and sequence currents at each frequency h then (55.b) can be written in terms of the phase and zps currents as given by (59). ${{I}_{h}^{+}}^{2} + {{I}_{h}^{-}}^{2} + {{I}_{h}^{o}}^{2} = \frac{1}{3} ⁢ \left({I}_{ah}^{2}+{I}_{bh}^{2}+{I}_{ch}^{2}\right)$ $S = 3 ⁢ {V}_{1}^{+} ⁢ \sqrt{\frac{1}{3} ⁢ \left({\sum }_{h = 1}^{∞}{I}_{ah}^{2}+{\sum }_{h = 1}^{∞}{I}_{bh}^{2}+{\sum }_{h = 1}^{∞}{I}_{ch}^{2}\right) - {\sum }_{h = 1}^{∞} {{I}_{h}^{o}}^{2}}$

The DP can be written in terms of the phase and zps current as shown by (60). $D = 3 ⁢ {V}_{1}^{+} ⁢ \sqrt{\frac{1}{3} ⁢ \left({\sum }_{h = 2}^{∞}{I}_{ah}^{2}+{\sum }_{h = 2}^{∞}{I}_{bh}^{2}+{\sum }_{h = 2}^{∞}{I}_{ch}^{2}\right) - {\sum }_{h = 2}^{∞} {{I}_{h}^{o}}^{2}}$

### 6-THREE PHASE IMPLEMENTATION

The technique for measuring the AP in 3-phase systems is similar to the single phase method that has already been explained in Section 4. There is a need to extract the pps voltage after the filter section. The AP is then calculated according to [5]. It is essential to specify the bandwidth of the measuring units.

### 7-CONCLUSION

The new method for calculating the AP and pf was investigated when the signals are not sinusoidal. Single and three phase systems were considered. It was shown that the technique can be equally applied in frequency and time domains. The active and reactive powers are the sum of the active and reactive powers of each frequency and these are determined as the average powers of the total IP. This partly confirms the Budeanu definition of the reactive power. The difference in the two approaches is the fact that in the new definition the reactive power is determined as the sum of dc values.

It was shown that it is sufficient and technically more acceptable to consider the ffc voltage in the IP calculation at any point in the circuit. This reflects the power components that are present at the source.

With reference to [5], in 3-phase systems the pps, ffc voltage must be considered in the IP calculation.

The Distortion Power was defined in terms of the phase and sequence quantities.

### 8-REFERENCES

[1] P. S. Filipski, " Polyphase Apparent Power and Power Factor Under Distorted Waveform Conditions," IEEE Trans. Power Delivery, Vol. 6, No. 3, July 1991, pp. 1161-1165.
[2] L. S. Czarnecki, " Orthogonal Decomposition of the Currents in a 3-phase Non-linear Asymmetrical Circuit with Nonsinusoidal Voltage Source," IEEE Trans. Instrumentation and Measurement, Vol. 37, March 1987, pp. 30-34.
[3] A. E. Emanuel, " Powers in Nonsinusoidal Situations. A Review of Definitions and Physical Meaning," IEEE Trans., Power Delivery, Vol. 5, No. 3, July 1990, pp. 1377-1389.
[4] F.Ghassemi, " A New Concept for Power Theory in AC Circuits, Part One: Single and Three Phase Systems " Companion Paper, Submitted to IEEE for presentation in 1999 Winter Meeting.
[5] F.Ghassemi, " A New Concept for Power Theory in AC Circuits, Part Two: The New Apparent Power and Power Factor in Terms of Symmetrical Components " Companion Paper.
[6] L. S. Czarnecki, " What is Wrong with the Budeanu Concept of Reactive and Distortion Power and why it should be Abandoned," IEEE Trans. Instrum. Meas., Vol. IM-36, Sept. 1987, pp. 834-837.
[7] J. Arrillaga, D.A. Bradley, P. S. Bodger, Power System Harmonics, Textbook, John Wiley & Sons, 1985, pp224-225.

### 10-APPENDIX A

The voltage signal must be filtered to extract the fundamental frequency component (ffc). The filtered signal is then phase shifted to form the complex ffc voltage. Thus; ${v}_{1 ⁢ p} \left(t\right) = {\hat{V}}_{1} ⁢ cos \left({ω}_{1}⁢t+{α}_{1}\right)$ ${v}_{1 ⁢ q} \left(t\right) = {\hat{V}}_{1} ⁢ cos \left({ω}_{1}⁢t+{α}_{1}-\frac{π}{2}\right) = {\hat{V}}_{1} ⁢ sin \left({ω}_{1}⁢t+{α}_{1}\right)$ ${v}_{m} \left(t\right) = {v}_{1 ⁢ p} \left(t\right) + j ⁢ {v}_{1 ⁢ q} \left(t\right)$

The IP is given by (A3). $p \left(t\right) = {p}_{p} \left(t\right) + j ⁢ {p}_{q} \left(t\right)$
where: ${p}_{p} \left(t\right) = {v}_{1 ⁢ p} \left(t\right) {\sum }_{h = 1}^{∞} {i}_{h} \left(t\right) = {\hat{V}}_{1} ⁢ cos \left({ω}_{1}⁢t+{α}_{1}\right) {\sum }_{h = 1}^{∞} {\hat{I}}_{h} ⁢ cos \left({ω}_{h}⁢t+{β}_{h}\right)$ ${p}_{q} \left(t\right) = {v}_{1 ⁢ q} \left(t\right) {\sum }_{h = 1}^{∞} {i}_{h} \left(t\right) = {\hat{V}}_{1} ⁢ sin \left({ω}_{1}⁢t+{α}_{1}\right) {\sum }_{h = 1}^{∞} {\hat{I}}_{h} ⁢ cos \left({ω}_{h}⁢t+{β}_{h}\right)$

(A4) and (A5) can be written as follows; ${p}_{p} \left(t\right) = {V}_{1} {I}_{1} ⁢ cos {ϕ}_{1} + {V}_{1} {I}_{1} ⁢ cos \left({ω}_{1}⁢t+{λ}_{1}\right) + {\sum }_{h = 2}^{∞} {V}_{1} {I}_{h} ⁢ cos \left({ω}_{1 ⁢ h}⁢t+{ϕ}_{1 ⁢ h}\right) + {\sum }_{h = 2}^{∞} {V}_{1} {I}_{h} ⁢ cos \left({ω}^{1 ⁢ h}⁢t+{λ}_{1 ⁢ h}\right)$ ${p}_{q} \left(t\right) = {V}_{1} {I}_{1} ⁢ sin {ϕ}_{1} + {V}_{1} {I}_{1} ⁢ sin \left(2⁢{ω}_{1}⁢t+{λ}_{1}\right) + {\sum }_{h = 2}^{∞} {V}_{1} {I}_{1} ⁢ sin \left({ω}_{1 ⁢ h}⁢t+{ϕ}_{1 ⁢ h}\right) + {\sum }_{h = 2}^{∞} {V}_{1} {I}_{h} ⁢ sin \left({ω}^{1 ⁢ h}⁢t+{λ}_{1 ⁢ h}\right)$
where; ${ω}_{1 ⁢ h} = {ω}_{1} - {ω}_{h} , {ω}^{1 ⁢ h} = {ω}_{1} + {ω}_{h}$

V and I with subscripts denote the rms of the signals.

The AP is defined as the rms of the IP. Hence; $S = rms \left[p\left(t\right)\right] = \sqrt{{\left\{rms\left[{p}_{p}\left(t\right)\right]\right\}}^{2} + {\left\{rms\left[{p}_{q}\left(t\right)\right]\right\}}^{2}}$
where : $rms \left[{p}_{p}\left(t\right)\right] = \sqrt{{\left({V}_{1}⁢{I}_{1}⁢cos{ϕ}_{1}\right)}^{2} + \frac{{\left({V}_{1}⁢{I}_{1}\right)}^{2}}{2} + {\sum }_{h = 2}^{∞} \frac{{\left({V}_{1}⁢{I}_{h}\right)}^{2}}{2} + {\sum }_{h = 2}^{∞} \frac{{\left({V}_{1}⁢{I}_{h}\right)}^{2}}{2}}$ $rms \left[{p}_{q}\left(t\right)\right] = \sqrt{{\left({V}_{1}⁢{I}_{1}⁢sin{ϕ}_{1}\right)}^{2} + \frac{{\left({V}_{1}⁢{I}_{1}\right)}^{2}}{2} + {\sum }_{h = 2}^{∞} \frac{{\left({V}_{1}⁢{I}_{h}\right)}^{2}}{2} + {\sum }_{h = 2}^{∞} \frac{{\left({V}_{1}⁢{I}_{h}\right)}^{2}}{2}}$ $S = \sqrt{2} ⁢ \sqrt{{\left({V}_{1}⁢{I}_{1}\right)}^{2} + {\sum }_{h = 2}^{∞} {\left({V}_{1}⁢{I}_{h}\right)}^{2}} = \sqrt{2} ⁢ {V}_{1} ⁢ \sqrt{{\sum }_{h = 1}^{∞} {I}_{h}^{2}}$

The AP can be written in terms of active, reactive and distortion powers as shown in (A12). $S = \sqrt{2 ⁢ {P}^{2} + 2 ⁢ {Q}^{2} + {D}^{2}}$
where: $P = {V}_{1} ⁢ {I}_{1} ⁢ cos {ϕ}_{1} = average \left[{p}_{p}\left(t\right)\right]$ $Q = {V}_{1} ⁢ {I}_{1} ⁢ sin {ϕ}_{1} = average \left[{p}_{q}\left(t\right)\right]$ $D = \sqrt{{\left\{rms\left[{v}_{1 ⁢ p}\left(t\right){\sum }_{h = 2}^{∞} {i}_{h} \left(t\right)\right]\right\}}^{2} + {\left\{rms\left[{v}_{1 ⁢ q}\left(t\right){\sum }_{h = 2}^{∞} {i}_{h} \left(t\right)\right]\right\}}^{2}}$

Having described particular preferred embodiments of the present invention, it is to be appreciated that the embodiments in question are exemplary only The scope of the invention is as set forth in the appended claims. Whilst the present invention has been described as a meter, the method employed in the operation of the meter could be used for monitoring of power parameters whilst load conditions are being varied or are fluctuating.

## Claims

1. A method of measuring the value of an electrical power parameter of an electrical signal, the electrical power parameter comprising at least one of Universal Apparent Power and Universal Power Factor, the method comprising:
sensing (100) an instantaneous voltage signal of the electrical power signal;
sensing (100) an instantaneous current signal of the electrical power signal;
calculating (114) a first instantaneous power component (38) as the product of the instantaneous voltage signal and the instantaneous current signal;
carrying out (116) a relative phase shift of 90 degrees between the fundamental frequency voltage signal and the full spectrum of the current signal;
calculating (114) a second instantaneous power component (40) as the product of the relatively phase-shifted instantaneous voltage and instantaneous current signals;
RMS averaging (128) each of the first and second instantaneous power components (38, 40) to determine their respective magnitudes;
using (130, 134) both of the determined magnitudes to determine the value of the electrical power parameter, which comprises determining said Universal Apparent Power of the electrical signal by calculating the square root of the sum of the squares of the RMS values of the first and second instantaneous power components (38, 40); and
displaying (124) the calculated value of the electrical power parameter as a measured value, wherein Universal Apparent Power is defined as the square root of the sum of the squares of the RMS values of the instantaneous power components, and Universal Power Factor is defined as the ratio of the measured Active Power to the measured Universal Apparent Power.

2. A method according to Claim 1, wherein the step of carrying out (116) a relative phase shift comprises phase shifting the instantaneous voltage of the electrical power signal prior to calculating the second instantaneous power component.

3. A method according to any preceding claim, further comprising measuring (122) the mean value of the first instantaneous power component (38) to determine the Active Power of the electrical power signal.

4. A method according to Claim 3, further comprising:
calculating (132) the ratio of measured Active Power of the electrical power signal to the measured Universal Apparent Power of the electrical power signal, the value of the ratio being the Universal Power Factor of the electrical power signal.

5. A method according to Claim 3 or Claim 4, further comprising integrating (126) the Active Power value over time to determine the Energy Consumption of the electrical power signal.

6. A method according to any preceding claim, further comprising measuring (122) the mean value of the second instantaneous power component (40) which defines the Reactive Power of the electrical system.

7. A method according to any preceding claim, further comprising filtering (120, 112) at least one of the instantaneous voltage or instantaneous current signals of the electrical power signal, prior to their use in the calculating steps.

8. A method according to Claim 7, wherein the filtering step (120, 112) results in the fundamental frequency component of at least one of the instantaneous voltage or instantaneous current signals being obtained.

9. A method according to Claim 7 or Claim 8, wherein the filtering step (120, 112) results in at least one of the harmonic frequency components of at least one of the instantaneous voltage or instantaneous current signals being obtained.

10. A method according to Claim 7, wherein the filtering step (120, 112) comprises:
filtering (106) the instantaneous voltage signal to obtain its fundamental frequency components; and
leaving the instantaneous current signal unfiltered.

11. A method according to Claim 7 or Claim 10, wherein the filtering step (120, 112) comprises:
filtering (106) the instantaneous voltage signal to obtain its fundamental frequency components; and
filtering (120 the instantaneous current signal to obtain at least one of its harmonic frequency components.

12. A method according to any one of Claims 7, 10 and 11, wherein the filtering step (120, 112) comprises:
filtering (112) the instantaneous voltage signal to obtain at least one of its harmonic frequency components; and
filtering the instantaneous current signal to obtain its fundamental frequency components.

13. A method according to any one of Claims 7 and 10 to 12, wherein the filtering step (120, 112) comprises:
filtering (112) the instantaneous voltage signal to obtain at least one of its harmonic frequency components; and
filtering (120) the instantaneous current signal to obtain at least one of its harmonic frequency components.

14. A method according to any preceding claim, wherein:
the electrical power signal is a multiple-phase signal; and
the calculating steps (114) comprise: calculating a single first instantaneous single-phase power component for each of the multiple phases; summing the single first instantaneous single-phase components together to provide the first instantaneous power component; calculating a single second instantaneous single-phase power component for each of the multiple phases; and summing the single second instantaneous single-phase components together to provide the second instantaneous power component.

15. A method according to Claim 14, wherein the electrical power signal comprises an unbalanced multiple-phase signal.

16. A method according to Claim 14, wherein the electrical power signal comprises a balanced multiple-phase signal.

17. A method according to any one of Claims 14 to 16, further comprising resolving (108) the multiple-phase signal into a phase sequence for use in establishing the effect of a load on an electric power network.

18. A method according to Claim 17, wherein the resolving step (108) comprises resolving the multiphase signal into a phase sequence comprising a positive-phase sequence in order to obtain a measure representative of the power generated at a source of the electrical power signal.

19. A method according to Claim 17 or Claim 18, wherein the resolving step (108) comprises resolving the multiphase signal into a phase sequence comprising negative and zero-phase sequences in order to obtain a measure representative of the power converted in the load.

20. A method according to Claim 19 as dependent on Claim 18, further comprising using the positive, the negative and the zero-phase sequences to obtain a measure representative of the power used by the load.

21. A method according to any of Claims 17 to 20, wherein the resolving step (108) is operatively selectable by a user.

22. A method according to any preceding claim, further comprising converting (102) the instantaneous current signal of the electrical power signal into a proportional voltage representation signal for use in the calculating and averaging steps.

23. A method of measuring the value of an electrical power parameter of an electrical signal, wherein the power parameter comprises at least one of Universal Apparent Power and Universal Power Factor, the method comprising:
sensing (100) an instantaneous voltage signal of the electrical power signal;
sensing (100) an instantaneous current signal of the electrical power signal;
converting (303) the sensed instantaneous voltage signal and the sensed instantaneous current signal from the time domain into the frequency domain as frequency spectra;
calculating (314) a first instantaneous power spectrum as the convolution of the frequency spectra of the instantaneous voltage signal and the instantaneous current signal;
carrying out (316) a relative phase shift of 90 degrees between the instantaneous voltage signal and the instantaneous current signal in the time domain;
calculating (314) a second instantaneous power spectrum as the convolution of the frequency spectra of the relatively phase-shifted instantaneous voltage and current signals;
combining (331, 335) each of the first and second power spectra in the frequency domain, by calculating the square root of the sum of the squares of the frequency components of the first and second component power spectra, to determine the value of the electric power parameter; and
displaying (324) the calculated value of the electrical power parameter as a measured value, wherein Universal Apparent Power is defined as the square root of the sum of the squares of the RMS values of the instantaneous power components, and Universal Power Factor is defined as the ratio of the measured Active Power to the measured Universal Apparent Power.

24. A method according to Claim 23, wherein the electrical power parameter comprises Universal Apparent Power and the combining step (331, 335) comprises determining the square root of the sum of the squares of the frequency components of the first and second power spectra.

25. A method according to Claim 23 or Claim 24, further comprising filtering (306, 312, 320) at least one of the instantaneous voltage or instantaneous current signals of the electrical power signal in the frequency domain, or prior to the conversion of the at least one signal into the frequency domain.

26. A method according to Claim 25, wherein the filtering step results in the fundamental frequency component of the electrical power signal being obtained (306).

27. A method according to Claim 25 or Claim 26, wherein the filtering step results in at least one of the harmonic frequency components of the electrical power signal being obtained (312, 320).

28. A method according to any preceding claim, wherein the electrical power signal comprises a non-sinusoidal waveform signal.

29. An electrical power meter (1, 201) for measuring the value of an electrical power parameter of an electrical power signal, the electrical power parameter comprising at least one of Universal Apparent Power and Universal Power Factor, the meter comprising:
means for sensing (14) an instantaneous voltage signal of the electrical power signal;
means for sensing (16) an instantaneous current signal of the electrical power signal;
means for calculating (32) a first instantaneous power component (38) as the product of the sensed instantaneous voltage signal and the sensed instantaneous current signal;
means for implementing (36) a relative phase shift of 90 degrees between the fundamental frequency voltage signal and the full spectrum of the current signal;
means for calculating (34) a second instantaneous power component (40) as the product of the relatively phase-shifted instantaneous voltage and instantaneous current signals;
means for RMS averaging (42, 44) each of the first and second instantaneous power components (38. 40) to determine their respective magnitudes;
means for using (54, 58) the calculated magnitudes to determine the value of the electrical power parameter; and
means for displaying (50) the calculated value of the electrical power parameter as a measured value, wherein Universal Apparent Power is defined as the square root of the sum of the squares of the RMS values of the instantaneous power components, and Universal Power Factor is defined as the ratio of the measured Active Power to the measured Universal Apparent Power.

30. A power meter (1, 201) according to Claim 29, further comprising a step-down voltage means (14) for stepping down the instantaneous voltage signal of the electrical power signal to a level suitable for measurement by the meter (1,201).

31. A power meter (1, 201) according to Claim 29 or Claim 30, further comprising a conversion means (16) for converting the instantaneous current signal of the electrical power signal into a representative voltage signal.

32. A power meter (1, 201) according to any one of Claims 29 to 31, wherein the meter (1, 201) is arranged to calculate several different power parameters and the means for displaying is arranged to selectively display information regarding the values of the calculated power parameters.

## Patentansprüche

1. Verfahren zum Messen des Werts eines elektrischen Leistungsparameters eines elektrischen Signals, wobei der elektrische Leistungsparameter mindestens eine universelle Scheinleistung (Universal Apparent Power) oder einen universellen Leistungsfaktor (Universal Power Factor) umfasst, wobei das Verfahren Folgendes umfasst:
Erfassen (100) eines Augenblicksspannungssignals des elektrischen Leistungssignals;
Erfassen (100) eines Augenblicksstromsignals des elektrischen Leistungssignals;
Berechnen (114) einer ersten Augenblicksleistungskomponente (38) als das Produkt aus dem Augenblicksspannungssignal und dem Augenblicksstromsignal;
Ausführen (116) einer relativen Phasenverschiebung von 90 Grad zwischen dem Grundschwingungsspannungssignal und dem ganzen Spektrum des Stromsignals;
Berechnen (114) einer zweiten Augenblicksleistungskomponente (40) als das Produkt aus dem relativ phasenverschobenen Augenblicksspannungssignal und Augenblicksstromsignal;
RMS-Mitteln (128) jeder der ersten und zweiten Augenblicksleistungskomponente (38, 40), um ihre jeweiligen Größen zu bestimmen;
Verwenden (130, 134) der beiden festgestellten Größen zum Bestimmen des Werts des elektrischen Leistungsparameters, was das Bestimmen der universellen Scheinleistung des elektrischen Signals umfasst durch Berechnen der Quadratwurzel aus der Summe der Quadrate der RMS-Werte der ersten und zweiten Augenblicksleistungskomponente (38, 40); und
Anzeigen (124) des berechneten Werts des elektrischen Leistungsparameters als ein Messwert, wobei die universelle Scheinleistung definiert ist als die Quadratwurzel aus der Summe der Quadrate der RMS-Werte der Augenblicksleistungskomponente und der universelle Leistungsfaktor definiert ist als das Verhältnis aus der gemessenen Wirkleistung und der gemessenen universellen Scheinleistung.

2. Verfahren nach Anspruch 1, wobei der Schritt des Ausführens (116) einer relativen Phasenverschiebung das Phasenverschieben der Augenblicksspannung des elektrischen Leistungssignals vor dem Berechnen der zweiten Augenblicksleistungskomponente umfasst.

3. Verfahren nach einem vorhergehenden Anspruch, weiterhin umfassend das Messen (122) des Mittelwerts der ersten Augenblicksleistungskomponente (38), um die Wirkleistung des elektrischen Leistungssignals zu bestimmen.

4. Verfahren nach Anspruch 3, weiterhin umfassend:
Berechnen (132) des Verhältnisses aus der gemessenen Wirkleistung des elektrischen Leistungssignals und der gemessenen universellen Scheinleistung des elektrischen Leistungssignals, wobei der Wert des Verhältnisses der universelle Leistungsfaktor des elektrischen Leistungssignals ist

5. Verfahren nach Anspruch 3 oder 4, weiterhin umfassend das Integrieren (126) des Wirkleistungswerts über die Zeit, um den Energieverbrauch des elektrischen Leistungssignals zu bestimmen.

6. Verfahren nach einem vorhergehenden Anspruch, weiterhin umfassend das Messen (122) des Mittelwerts der zweiten Augenblicksleistungskomponente (40), die die Blindleistung des elektrischen Systems definiert.

7. Verfahren nach einem vorhergehenden Anspruch, weiterhin umfassend das Filtern (120, 112) mindestens des Augenblicksspannungssignals oder des Augenblicksstromsignals des elektrischen Leistungssignals vor ihrer Verwendung in den Berechnungsschritten.

8. Verfahren nach Anspruch 7, wobei der Filterungsschritt (120, 112) dazu führt, dass die Grundschwingungskomponente des Augenblicksspannungssignals oder des Augenblicksstromsignals erhalten wird.

9. Verfahren nach Anspruch 7 oder 8, wobei der Filterungsschritt (120, 112) dazu führt, dass mindestens eine der Oberschwingungsfrequenzkomponenten des Augenblicksspannungssignals oder Augenblicksstromsignals erhalten wird.

10. Verfahren nach Anspruch 7, wobei der Filterungsschritt (120, 112) Folgendes umfasst:
Filtern (106) des Augenblicksspannungssignals, um seine Grundschwingungskomponenten zu erhalten; und das Augenblicksstromsignal ungefiltert lassen.

11. Verfahren nach Anspruch 7 oder 10, wobei der Filterungsschritt (120, 112) Folgendes umfasst:
Filtern (106) des Augenblicksspannungssignals, um seine Grundschwingungskomponenten zu erhalten; und
Filtern (120) des Augenblicksstromsignals, um mindestens eine seiner Oberschwingungsfrequenzkomponenten zu erhalten.

12. Verfahren nach einem der Ansprüche 7, 10 und 11, wobei der Filterungsschritt (120, 112) Folgendes umfasst:
Filtern (112) des Augenblicksspannungssignals, um mindestens eine seiner Oberschwingungskomponenten zu erhalten; und
Filtern des Augenblicksstromsignals, um seine Grundschwingungsfrequenzkomponente zu erhalten.

13. Verfahren nach einem der Ansprüche 7 und 10 bis 12, wobei der Filterungsschritt (120, 112) Folgendes umfasst:
Filtern (112) des Augenblicksspannungssignals, um mindestens eine seiner Oberschwingungskomponenten zu erhalten; und
Filtern (120) des Augenblicksstromsignals, um mindestens eine seiner Oberschwingungskomponenten zu erhalten.

14. Verfahren nach einem vorhergehenden Anspruch, wobei:
das elektrische Leistungssignal ein mehrphasiges Signal ist und
die Berechnungsschritte (114) Folgendes umfassen:
Berechnen einer einzelnen ersten Einphasen-Augenblicksleistungskomponente für jede der mehreren Phasen; Summieren der einzelnen ersten Einphasen-Augenblicksleistungskomponente miteinander, um die erste Augenblicksleistungskomponente zu erhalten; Berechnen einer einzelnen zweiten Einphasen-Augenblicksleistungskomponente für jede der mehreren Phasen und
Summieren der einzelnen zweiten Einphasen-Augenblicksleistungskomponenten miteinander, um die zweite Augenblicksleistungskomponente zu erhalten.

15. Verfahren nach Anspruch 14, wobei das elektrische Leistungssignal ein unsymmetrisches mehrphasiges Signal umfasst.

16. Verfahren nach Anspruch 14, wobei das elektrische Leistungssignal ein symmetrisches mehrphasiges Signal umfasst.

17. Verfahren nach einem der Ansprüche 14 bis 16, weiterhin umfassend das Auflösen (108) des mehrphasigen Signals in eine Phasensequenz zur Verwendung beim Herstellen des Effekts einer Last auf ein elektrisches Leistungsnetz.

18. Verfahren nach Anspruch 17, wobei der Auflösungsschritt (108) das Auflösen des mehrphasigen Signals in eine Phasensequenz umfasst, die eine positivphasige Sequenz umfasst, um ein Maß zu erhalten, das die an einer Quelle des elektrischen Leistungssignals erzeugte Leistung darstellt.

19. Verfahren nach Anspruch 17 oder 18, wobei der Auflösungsschritt (108) das Auflösen des mehrphasigen Signals in eine Phasensequenz umfasst, die eine negativ- und nullphasige Sequenz umfasst, um ein Maß zu erhalten, das die in die Last umgewandelte Leistung darstellt.

20. Verfahren nach Anspruch 19 in Abhängigkeit von Anspruch 18, weiterhin umfassend das Verwenden der positiv-, negativ- und nullphasigen Sequenz, um ein Maß zu erhalten, das die von der Last verbrauchte Leistung darstellt.

21. Verfahren nach einem der Ansprüche 17 bis 20, wobei der Auflösungsschritt (108) von einem Benutzer operativ gewählt werden kann.

22. Verfahren nach einem vorhergehenden Anspruch, weiterhin umfassend das Umwandeln (102) des Augenblicksstromsignals des elektrischen Leistungssignals in ein Proportionalspannungsdarstellungssignal zur Verwendung bei den Berechnungs- und Mittelungsschritten.

23. Verfahren zum Messen des Werts eines elektrischen Leistungsparameter eines elektrischen Signals, wobei der Leistungsparameter mindestens eine universelle Scheinleistung (Universal Apparent Power) oder einen universellen Leistungsfaktor (Universal Power Factor) umfasst, wobei das Verfahren Folgendes umfasst:
Erfassen (100) eines Augenblicksspannungssignals des elektrischen Leistungssignals;
Erfassen (100) eines Augenblicksstromsignals des elektrischen Leistungssignals;
Umwandeln (303) des erfassten Augenblicksspannungssignals und des erfassten Augenblicksstromsignals aus dem Zeitbereich in den Frequenzbereich als Frequenzspektren;
Berechnen (314) eines ersten Augenblicksleistungsspektrums als die Faltung der Frequenzspektren des Augenblicksspannungssignals und des Augenblicksstromsignals;
Ausführen (316) einer relativen Phasenverschiebung von 90 Grad zwischen dem Augenblicksspannungssignal und dem Augenblicksstromsignal im Zeitbereich;
Berechnen (314) eines zweiten Augenblicksleistungsspektrums als die Faltung der Frequenzspektren des relativ phasenverschobenen Augenblicksspannungssignals und Augenblicksstromsignals;
Kombinieren (331, 335) jedes des ersten und zweiten Frequenzspektrums im Frequenzbereich durch Berechnen der Quadratwurzel aus der Summe der Quadrate der Frequenzkomponenten des ersten und zweiten Komponentenleistungsspektrums, um den Wert des elektrischen Leistungsparameters zu bestimmen; und
Anzeigen (324) des berechneten Werts des elektrischen Leistungsparameters als ein Messwert, wobei die universelle Scheinleistung definiert ist als die Quadratwurzel aus der Summe der Quadrate der RMS-Werte der Augenblicksleistungskomponenten und der universelle Leistungsfaktor definiert ist als das Verhältnis aus der gemessenen Wirkleistung und der gemessenen universellen Scheinleistung.

24. Verfahren nach Anspruch 23, wobei der elektrische Leistungsparameter die universelle Scheinleistung umfasst und der Kombinierungsschritt (331, 335) das Bestimmen der Quadratwurzel aus der Summe der Quadrate der Frequenzkomponenten des ersten und zweiten Leistungsspektrums umfasst.

25. Verfahren nach Anspruch 23 oder 24, weiterhin umfassend das Filtern (306, 312, 320) mindestens des Augenblicksspannungssignals oder des Augenblicksstromsignals des elektrischen Leistungssignals im Frequenzbereich oder vor der Umwandlung des mindestens einen Signals in den Frequenzbereich.

26. Verfahren nach Anspruch 25, wobei der Filterungsschritt dazu führt, dass die Grundschwingungskomponente des elektrischen Leistungssignals erhalten wird (306).

27. Verfahren nach Anspruch 25 oder 26, wobei der Filterungsschritt dazu führt, dass mindestens eine der Oberschwingungskomponenten des elektrischen Leistungssignals erhalten wird (312, 320).

28. Verfahren nach einem vorhergehenden Anspruch, wobei das elektrische Leistungssignal ein Signal mit einer nicht-sinusförmigen Wellenform umfasst.

29. Elektrisches Leistungsmessgerät (1, 201) zum Messen des Werts eines elektrischen Leistungsparameters eines elektrischen Leistungssignals, wobei der elektrische Leistungsparameter mindestens eine universelle Scheinleistung oder einen universellen Leistungsfaktor umfasst, wobei das Messgerät Folgendes umfasst:
Mittel zum Erfassen (14) eines Augenblicksspannungssignals des elektrischen Leistungssignals;
Mittel zum Erfassen (16) eines Augenblicksstromsignals des elektrischen Leistungssignals;
Mittel zum Berechnen (32) einer ersten Augenblicksleistungskomponente (38) als das Produkt aus dem erfassten Augenblicksspannungssignal und dem erfassten Augenblicksstromsignal;
Mittel zum Implementieren (36) einer relativen Phasenverschiebung von 90 Grad zwischen dem Grundschwingungsspannungssignal und dem ganzen Spektrum des Stromsignals;
Mittel zum Berechnen (34) einer zweiten Augenblicksleistungskomponente (40) als das Produkt aus dem relativ phasenverschobenen Augenblicksspannungssignal und Augenblicksstromsignal;
Mittel zum RMS-Mitteln (42, 44) jeder der ersten und zweiten Augenblicksleistungskomponente (38, 40), um ihre jeweiligen Größen zu bestimmen;
Mittel zum Verwenden (54, 58) der berechneten Größen zum Bestimmen des Werts des elektrischen Leistungsparameters; und
Mittel zum Anzeigen (50) des berechneten Werts des elektrischen Leistungsparameters als ein Messwert, wobei die universelle Scheinleistung definiert ist als die Quadratwurzel aus der Summe der Quadrate der RMS-Werte der Augenblicksleistungskomponenten und der universelle Leistungsfaktor definiert ist als das Verhältnis aus der gemessenen Wirkleistung und der gemessenen universellen Scheinleistung.

30. Leistungsmessgerät (1, 201) nach Anspruch 29, weiterhin umfassend ein Step-down-Spannungsmittel (14) zum Abwärtstransformieren des Augenblicksspannungssignals des elektrischen Leistungssignals auf einen Pegel, der sich zur Messung durch das Messgerät (1, 201) eignet.

31. Leistungsmessgerät (1, 201) nach Anspruch 29 oder 30, weiterhin umfassend ein Umwandlungsmittel (16) zu Umwandeln des Augenblicksstromsignals des elektrischen Leistungssignals in ein repräsentatives Spannungssignal.

32. Leistungsmessgerät (1, 201) nach einem der Ansprüche 29 bis 31, wobei das Messgerät (1, 201) ausgelegt ist, mehrere verschiedene Leistungsparameter zu messen, und das Mittel zum Anzeigen ausgelegt ist, Informationen hinsichtlich der Werte der berechneten Leistungsparameter selektiv anzuzeigen.

## Revendications

1. Procédé pour mesurer la valeur d'un paramètre de puissance électrique d'un signal électrique, le paramètre de puissance électrique comprenant au moins un paramètre parmi la puissance apparente universelle et le facteur de puissance universel, le procédé comprenant :
la détection (100) d'un signal de tension instantanée du signal de puissance électrique ;
la détection (100) d'un signal de courant instantané du signal de puissance électrique ;
le calcul (114) d'une première composante de puissance instantanée (38) sous la forme du produit du signal de tension instantanée et du signal de courant instantané ;
l'exécution (116) d'un déphasage relatif de 90 degrés entre le signal de tension à la fréquence fondamentale et le spectre complet du signal de courant ;
le calcul (114) d'une seconde composante de puissance instantanée (40) sous la forme du produit de la tension instantanée déphasée de manière relative et des signaux de courant instantané ;
l'exécution de la moyenne quadratique (128) de chacune des première et seconde composantes de puissance instantanée (38, 40) pour déterminer leurs amplitudes respectives ;
l'utilisation (130, 134) des deux amplitudes déterminées pour déterminer la valeur du paramètre de puissance électrique, qui comprend la détermination de ladite puissance apparente universelle du signal électrique par le calcul de la racine carrée de la somme des carrés des valeurs quadratiques moyennes des première et seconde composantes de puissance instantanée (38, 40) ; et
l'affichage (124) de la valeur calculée du paramètre de puissance électrique en tant que valeur mesurée, dans lequel la puissance apparente universelle est définie comme la racine carrée de la somme des carrés des valeurs quadratiques moyennes des composantes de puissance instantanée, et le facteur de puissance universel est défini comme le rapport entre la puissance active mesurée et la puissance apparente universelle mesurée.

2. Procédé selon la revendication 1, dans lequel l'étape d'exécution (116) d'un déphasage relatif comprend le déphasage de la tension instantanée du signal de puissance électrique avant le calcul de la seconde composante de puissance instantanée.

3. Procédé selon l'une quelconque des revendications précédentes, comprenant en outre la mesure (122) de la valeur moyenne de la première composante de puissance instantanée (38) pour déterminer la puissance active du signal de puissance électrique.

4. Procédé selon la revendication 3, comprenant en outre :
le calcul (132) du rapport entre la puissance active mesurée du signal de puissance électrique et la puissance apparente universelle mesurée du signal de puissance électrique, la valeur du rapport étant le facteur de puissance universel du signal de puissance électrique.

5. Procédé selon la revendication 3 ou la revendication 4, comprenant en outre l'intégration dans le temps (126) de la valeur de puissance active pour déterminer la consommation d'énergie du signal de puissance électrique.

6. Procédé selon l'une quelconque des revendications précédentes, comprenant en outre la mesure (122) de la valeur moyenne de la seconde composante de puissance instantanée (40) qui définit la puissance réactive du système électrique.

7. Procédé selon l'une quelconque des revendications précédentes, comprenant en outre le filtrage (120, 112) au moins d'une valeur parmi la tension instantanée et les signaux de courant instantané du signal de puissance électrique, avant leur utilisation dans les étapes de calcul.

8. Procédé selon la revendication 7, dans lequel l'étape de filtrage (120, 112) produit la composante de fréquence fondamentale d'au moins une valeur parmi la tension instantanée et les signaux de courant instantané obtenus.

9. Procédé selon la revendication 7 ou la revendication 8, dans lequel l'étape de filtrage (120, 112) produit au moins une valeur parmi les composantes de fréquence harmonique d'au moins une valeur parmi la tension instantanée et les signaux de courant instantané obtenus.

10. Procédé selon la revendication 7, dans lequel l'étape de filtrage (120, 112) comprend :
le filtrage (106) du signal de tension instantanée pour obtenir ses composantes de fréquence fondamentale ; et
l'abandon du signal de courant instantané non filtré.

11. Procédé selon la revendication 7 ou la revendication 10, dans lequel l'étape de filtrage (120, 112) comprend :
le filtrage (106) du signal de tension instantanée pour obtenir ses composantes de fréquence fondamentale ; et
le filtrage (120) du signal de courant instantané pour obtenir au moins une de ses composantes de fréquence harmonique.

12. Procédé selon l'une quelconque des revendications 7, 10 et 11, dans lequel l'étape de filtrage (120, 112) comprend :
le filtrage (112) du signal de tension instantanée pour obtenir au moins une de ses composantes de fréquence harmonique ; et
le filtrage du signal de courant instantané pour obtenir ses composantes de fréquence fondamentale.

13. Procédé selon l'une quelconque des revendications 7 et 10 à 12, dans lequel l'étape de filtrage (120, 112) comprend :
le filtrage (112) du signal de tension instantanée pour obtenir au moins une de ses composantes de fréquence fondamentale ; et
le filtrage (120) du signal de courant instantané pour obtenir au moins une de ses composantes de fréquence harmonique.

14. Procédé selon l'une quelconque des revendications précédentes, dans lequel :
le signal de puissance électrique est un signal à plusieurs phases ; et
les étapes de calcul (114) comprennent : le calcul d'une unique composante de puissance monophasée instantanée pour chacune des phases multiples ; l'addition des uniques premières composantes monophasées instantanées pour fournir la première composante de puissance instantanée ; le calcul d'une unique seconde composante de puissance monophasée instantanée pour chacune des phases multiples ; et l'addition des secondes uniques composantes monophasées instantanées pour fournir la seconde composante de puissance instantanée.

15. Procédé selon la revendication 14, dans lequel le signal de puissance électrique comprend un signal à plusieurs phases déséquilibrées.

16. Procédé selon la revendication 14, dans lequel le signal de puissance électrique comprend un signal à plusieurs phases équilibrées.

17. Procédé selon l'une quelconque des revendications 14 à 16, comprenant en outre la résolution (108) du signal à plusieurs phases en une séquence de phases destinée à être utilisée pour déterminer l'effet d'une charge sur un réseau d'énergie électrique.

18. Procédé selon la revendication 17, dans lequel l'étape de résolution (108) comprend la résolution du signal à plusieurs phases en une séquence de phases comprenant une séquence de phases positives pour obtenir une mesure représentative de la puissance générée à la source du signal de puissance électrique.

19. Procédé selon la revendication 17 ou la revendication 18, dans lequel l'étape de résolution (108) comprend la résolution du signal à plusieurs phases en une séquence de phases comprenant des séquences de phases négatives et nulles pour obtenir une mesure représentative de la puissance convertie dans la charge.

20. Procédé selon la revendication 19, lorsqu'elle dépend de la revendication 18, comprenant en outre l'utilisation des séquences de phases positives, négatives et nulles pour obtenir une mesure représentative de la puissance utilisée par la charge.

21. Procédé selon l'une quelconque des revendications 17 à 20, dans lequel l'étape de résolution (108) peut être sélectionnée de manière fonctionnelle par un utilisateur.

22. Procédé selon l'une quelconque des revendications précédentes, comprenant en outre la conversion (102) du signal de courant instantané du signal de puissance électrique en un signal de représentation de tension proportionnelle destiné à être utilisé dans les étapes de calcul et de moyennage.

23. Procédé pour mesurer la valeur d'un paramètre de puissance électrique d'un signal électrique, dans lequel le paramètre de puissance comprend au moins un paramètre parmi la puissance apparente universelle et le facteur de puissance universel, le procédé comprenant :
la détection (100) d'un signal de tension instantanée du signal de puissance électrique ;
la détection (100) d'un signal de courant instantané du signal de puissance électrique ;
la conversion (303) du signal de tension instantanée détecté et du signal de courant instantané détecté depuis le domaine temporel dans le domaine fréquentiel, en tant que spectres de fréquence ;
le calcul (314) d'un premier spectre de puissance instantanée sous la forme de la convolution des spectres de fréquence du signal de tension instantané et du signal de courant instantané ;
l'exécution (316) d'un déphasage relatif de 90 degrés entre le signal de tension instantané et le signal de courant instantané dans le domaine temporel ;
le calcul (314) d'un second spectre de puissance instantanée sous la forme de la convolution du spectre de fréquence de la tension instantanée déphasée de manière relative et des signaux de courant ;
la combinaison (331, 335) de chaque spectre parmi les premier et second spectres de puissance dans le domaine fréquentiel, en calculant la racine carrée de la somme des carrés des composantes de fréquence des premier et second spectres de puissance de composante, pour déterminer la valeur du paramètre de puissance électrique ; et
l'affichage (124) de la valeur calculée du paramètre de puissance électrique en tant que valeur mesurée, dans lequel la puissance apparente universelle est définie comme la racine carrée de la somme des carrés des valeurs quadratiques moyennes des composantes de puissance instantanée, et le facteur de puissance universel est défini comme le rapport entre la puissance active mesurée et la puissance apparente universelle mesurée.

24. Procédé selon la revendication 23, dans lequel le paramètre de puissance électrique comprend la puissance apparente universelle et l'étape de combinaison (331, 335) comprend la détermination de la racine carrée de la somme des carrés des composantes de fréquence des premier et second spectres de puissance.

25. Procédé selon la revendication 23 ou la revendication 24, comprenant en outre le filtrage (306, 312, 320) d'au moins une valeur parmi la tension instantanée et les signaux de courant instantané du signal de puissance électrique dans le domaine fréquentiel, ou avant la conversion de l'au moins un signal dans le domaine fréquentiel.

26. Procédé selon la revendication 25, dans lequel l'étape de filtrage produit la composante de fréquence fondamentale du signal de puissance électrique obtenu (306).

27. Procédé selon la revendication 25 ou la revendication 26, dans lequel l'étape de filtrage produit au moins une des composantes de fréquence harmonique du signal de puissance électrique obtenu (312, 320).

28. Procédé selon l'une quelconque des revendications précédentes, dans lequel le signal de puissance électrique comprend un signal de forme d'onde non sinusoïdale.

29. Appareil de mesure de puissance électrique (1, 201) pour mesurer la valeur d'un paramètre de puissance électrique d'un signal de puissance électrique, le paramètre de puissance électrique comprenant au moins un paramètre parmi la puissance apparente universelle et le facteur de puissance universel, l'appareil de mesure de puissance comprenant :
un moyen de détection (14) d'un signal de tension instantanée du signal de puissance électrique ;
un moyen de détection (16) d'un signal de courant instantané du signal de puissance électrique ;
un moyen de calcul (32) d'une première composante de puissance instantanée (38) sous la forme du produit du signal de tension instantanée détecté et du signal de courant instantané détecté ;
un moyen d'exécution (36) d'un déphasage relatif de 90 degrés entre le signal de tension à la fréquence fondamentale et le spectre complet du signal de courant ;
un moyen de calcul (34) d'une seconde composante de puissance instantanée (40) sous la forme du produit de la tension instantanée déphasée de manière relative et des signaux de courant instantané ;
un moyen pour effectuer la moyenne quadratique (42, 44) de chacune des première et seconde composantes de puissance instantanée (38, 40) pour déterminer leurs amplitudes respectives ;
un moyen d'utilisation (54, 58) des amplitudes calculées pour déterminer la valeur du paramètre de puissance électrique ; et
un moyen d'affichage (50) de la valeur calculée du paramètre de puissance électrique en tant que valeur mesurée, dans lequel la puissance apparente universelle est définie comme la racine carrée de la somme des carrés des valeurs quadratiques moyennes des composantes de puissance instantanée, et le facteur de puissance universel est défini comme le rapport entre la puissance active mesurée et la puissance apparente universelle mesurée.

30. Appareil de mesure de puissance (1, 201) selon la revendication 29, comprenant en outre un moyen d'abaissement de tension (14) pour abaisser le signal de tension instantanée du signal de puissance électrique à un niveau convenable pour la mesure par l'appareil de mesure (1, 201).

31. Appareil de mesure de puissance (1, 201) selon la revendication 29 ou la revendication 30, comprenant en outre un moyen de conversion (16) pour convertir le signal de courant instantané du signal de puissance électrique en un signal de tension représentatif.

32. Appareil de mesure de puissance (1, 201) selon l'une quelconque des revendications 29 à 31, dans lequel l'appareil de mesure (1, 201) est agencé pour calculer plusieurs paramètres de puissance différents et le moyen d'affichage est agencé pour afficher de manière sélective des informations concernant les valeurs des paramètres de puissance calculés.
